# EUROPEAN PATENT SPECIFICATION

(11) **EP 4 016 656 B1**
(45) Date of publication and mention of the grant of the patent: **03.09.2025**
(21) Application number: 21213971.1
(22) Date of filing: 13.12.2021
(51) Int. Cl.: C07F 15/00, H10K 85/30

(54) **ORGANOMETALLIC COMPOUND, ORGANIC LIGHT-EMITTING DEVICE INCLUDING THE SAME, AND DIAGNOSTIC COMPOSITION INCLUDING THE ORGANOMETALLIC COMPOUND**
ORGANOMETALLISCHE VERBINDUNG, ORGANISCHE LICHTEMITTIERENDE VORRICHTUNG DAMIT UND DIAGNOSEZUSAMMENSETZUNG MIT DER ORGANOMETALLISCHEN VERBINDUNG
COMPOSÉ ORGANOMÉTALLIQUE, DISPOSITIF ÉLECTROLUMINESCENT ORGANIQUE LE COMPRENANT ET COMPOSITION DE DIAGNOSTIC COMPRENANT LE COMPOSÉ ORGANOMÉTALLIQUE

(30) Priority: 16.12.2020 KR 20200176596
(43) Date of publication of application: 22.06.2022
(73) Proprietor: Samsung Electronics Co., Ltd., Suwon-si, Gyeonggi-do 16677 (KR)
(72) Inventor: KWON, Ohyun, 16678 Suwon-si (KR); RAI, Virendra Kumar, 16678 Suwon-si (KR); PARK, Bumwoo, 16678 Suwon-si (KR); KIM, Sangdong, 16678 Suwon-si (KR); KIM, Hyungjun, 16678 Suwon-si (KR); SIM, Myungsun, 16678 Suwon-si (KR); CHOI, Byoungki, 16678 Suwon-si (KR)
(74) Representative: Elkington and Fife LLP

(56) References cited:
- WO-A1-2017/103584
- CN-A- 111 978 355
- US-A1- 2016 164 012
- US-A1- 2019 252 619
- US-A1- 2020 087 334

## Description

### FIELD OF THE INVENTION

One or more embodiments described herein relate to an organometallic compound, an organic light-emitting device including the same, and a diagnostic composition including the organometallic compound.

### BACKGROUND OF THE INVENTION

Organic light-emitting devices (OLEDs) are self-emission devices that have improved characteristics compared to conventional devices, including having wider viewing angles, faster response time, excellent brightness, driving voltage, and response speed. In addition, OLEDS can produce full-color images with these enhanced properties.

In an example, an organic light-emitting device includes an anode, a cathode, and an organic layer located between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons may recombine in the emission layer to produce excitons. These excitons may transition from an excited state to a ground state to thereby generate light, for example, visible light.

US 2019/252619 discloses compounds for use as emitters, and devices, such as organic light emitting diodes including the same. US 2020/087334 discloses cyclometallated iridium complexes having triphenylene or aza triphenylene and bulky alkyl substitution that can be used as emitters in OLEDs. CN 111 978 355 discloses an organic compound in the technical field of organic photoelectric materials. US 2016/164012 discloses an organometallic compound and an organic light-emitting device including the same. WO 2017/103584 discloses phosphorescent light-emitting compounds; compositions, solutions and light-emitting devices comprising said light-emitting compounds; and methods of making said light-emitting devices.

### SUMMARY OF THE INVENTION

One or more embodiments described herein relate to an organometallic compound, an organic light-emitting device including at least one organometallic compound, and a diagnostic composition including at least one organometallic compound.

Additional aspects will be set forth in part in the detailed description, which follows and, in part, will be apparent from the detailed description, or may be learned by practice of the presented exemplary embodiments of the disclosure.

According to the invention, an organometallic compound is provided in accordance with claim 1.

According to an embodiment, an organic light-emitting device includes a first electrode, a second electrode, and an organic layer located between the first electrode and the second electrode, wherein the organic layer includes an emission layer, and wherein the organic layer includes at least one of the organometallic compound represented by Formula 1.

According to another embodiment, the organometallic compound may be included in the emission layer of the organic layer, and the organometallic compound included in the emission layer may act as a dopant.

According to yet another embodiment, a diagnostic composition includes at least one organometallic compound represented by Formula 1.

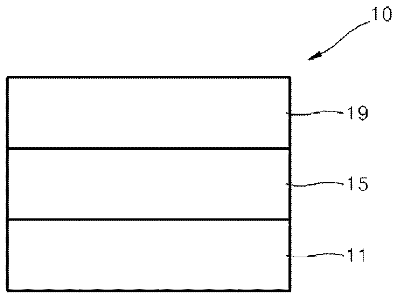

### BRIEF DESCRIPTION OF THE DRAWING

The above and other aspects, features, and advantages of certain embodiments of the disclosure will be more apparent from the following description taken in conjunction with the accompanying drawing, in which
The FIGURE shows a schematic cross-sectional view of an organic light-emitting device according to one or more embodiments.

### DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (*i.e*., the limitations of the measurement system). For example, "about" can mean within one or more standard deviations, or within ± 30%, 20%, 10%, 5% of the stated value.

According to an aspect of the present disclosure, one or more embodiments describe an organometallic compound represented by Formula 1:

Formula 1 M₁(Ln₁)ₙ₁(Ln₂)ₙ₂

M₁ is Ir, Pt, Os, or Rh.

In one or more embodiments, M₁ may be Ir.

In Formula 1, n1 is 0, 1 or 2, and n2 is 1, 2, or 3.

In one or more embodiments, the sum of n1 and n2 may be 2 or 3.

In one or more embodiments, M₁ may be Ir and the sum of n1 and n2 may be 3.

In one or more embodiments, M₁ may be Pt and the sum of n1 and n2 may be 2.

Ln₁ in Formula 1 is a ligand represented by Formula 1A.

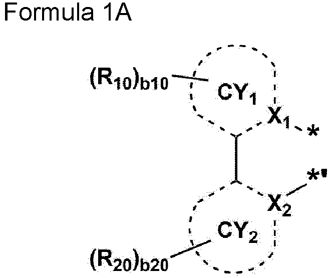

Ln₂ in Formula 1 is a ligand represented by Formula 1B.

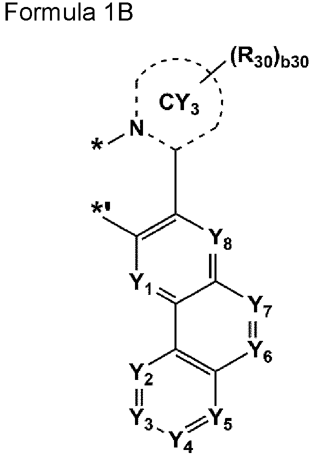

In Formula 1A, X₁ is C or N, and X₂ is C or N.

In Formula 1B, Y₁ is C(R₄₁) or N, Y₂ is C(R₄₂) or N, Y₃ is C(R₄₃) or N, Y₄ is C(R₄₄) or N, Y₅ is C(R₄₅) or N, Y₆ is C(R₄₆) or N, Y₇ is C(R₄₇) or N, and Y₈ is C(R₄₈) or N.

CY₁ and CY₂ in Formula 1A are each independently be a C₅-C₃₀ carbocyclic group or a C₁-C₃₀ heterocyclic group.

CY₃ in Formula 1B is a C₁-C₃₀ heterocyclic group including nitrogen.

In one or more embodiments, CY₁ and CY₂ may each independently be i) a first ring, ii) a second ring, iii) a condensed cyclic group in which two or more first rings are condensed with each other, iv) a condensed cyclic group in which two or more second rings are condensed with each other, or v) a condensed cyclic group in which at least one first ring is condensed with at least one second ring,
wherein the first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a phenyl group, a pyridine group, a pyrimidine group, a pyrazine group, a pyridazine group, or a triazine group.

In one or more embodiments, CY₁ and CY₂ may each independently be a cyclopentane group, a cyclohexane group, a cycloheptane group, a cyclopentene group, a cyclohexene group, a cycloheptene group, a phenyl group, a naphthalene group, a 1,2,3,4-tetrahydronaphthalene group, a anthracene group, a phenanthrene group, a triphenylene group, a pyrene group, a chrysene group, a cyclopentadiene group, a thiophene group, a furan group, a indole group, a benzoborole group, a benzophosphole group, a indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, a azaindole group, a azabenzoborole group, a azabenzophosphole group, a azaindene group, a azabenzosilole group, a azabenzogermole group, a azabenzothiophene group, a azabenzoselenophene group, a azabenzofuran group, a azacarbazole group, a azadibenzoborole group, a azadibenzophosphole group, a azafluorene group, a azadibenzosilole group, a azadibenzogermole group, a azadibenzothiophene group, a azadibenzoselenophene group, a azadibenzofuran group, a azadibenzothiophene 5-oxide group, a aza-9H-fluoren-9-one group, a azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, a imidazole group, a triazole group, a oxazole group, a isoxazole group, a thiazole group, a isothiazole group, a oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group; or
a group represented by Formulae 8-1 or 8-2:

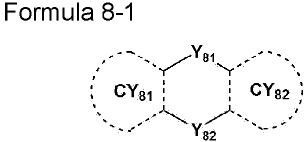

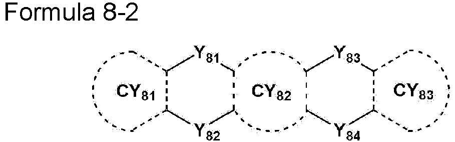

In Formulae 8-1 and 8-2,
Y₈₁ to Y₈₄ may each independently be a single bond, O, S, N(R₈₁), C(R₈₁)(R₈₂), Si(R₈₁)(R₈₂), C(=O), S(=O), S(=O)₂, B(R₈₁), P(R₈₁), or P(=O)(R₃₁),
CY₈₁ to CY₈₃ may each independently be a phenyl group, a naphthalene group, a 1,2,3,4-tetrahydronaphthalene group, a phenanthrene group, a pyridine group, a pyrimidine group, a pyrazine group, a triazine group, a quinoline group, an isoquinoline group, a quinoxaline group, a quinazoline group, a phenanthroline group, a benzofuran group, a benzothiophene group, a fluorene group, a carbazole group, a dibenzofuran group, a dibenzothiophene group, a dibenzosilole group, a azafluorene group, a azacarbazole group, a azadibenzofuran group, a azadibenzothiophene group, or a azadibenzosilole group.

R₃₁ and R₈₂ may each independently be as described in connection with R₁₀ and R₂₀.

In one or more embodiments, in Formulae 8-1 and 8-2, Y₈₁ to Y₈₄ may each independently be a single bond, O, S, N(R₈₁), C(R₈₁)(R₈₂), or Si(R₈₁)(R₈₂).

In one or more embodiments, Y₈₁ and Y₈₂ may not be a single bond at the same time, and Y₈₃ and Y₈₄ may not be a single bond at the same time. For example, in one or more embodiments, Y₈₁ and Y₈₂ are not both a single bond, and Y₈₃ and Y₈₄ are not both a single bond.

In one or more embodiments, CY₈₁ to CY₈₃ may be each independently a phenyl group, a naphthalene group, a pyridine group, or a pyrimidine group.

In one or more embodiments, CY₈₁ to CY₈₃ may each independently be a phenyl group or a naphthalene group.

In one or more embodiments, CY₁ and CY₂ may each independently be a phenyl group, a naphthalene group, a 1,2,3,4-tetrahydronaphthalene group, a phenanthrene group, a pyridine group, a pyrimidine group, a pyrazine group, a triazine group, a quinoline group, an isoquinoline group, a quinoxaline group, a quinazoline group, a phenanthroline group, a benzofuran group, a benzothiophene group, a fluorene group, a carbazole group, a dibenzofuran group, a dibenzothiophene group, a dibenzosilole group, a azafluorene group, a azacarbazole group, a azadibenzofuran group, a azadibenzothiophene group, or a azadibenzosilole group.

In one or more embodiments, CY₁ may be a pyridine group, a pyrimidine group, a pyrazine group, a triazine group, a quinoline group, an isoquinoline group, a quinoxaline group, or a quinazoline group.

In one or more embodiments, CY₂ may be a phenyl group, a naphthalene group, a pyridine group, a pyrimidine group, a pyrazine group, a triazine group, a quinoline group, an isoquinoline group, a quinoxaline group, a quinazoline group, a fluorene group, a carbazole group, a dibenzofuran group, a dibenzothiophene group, or a dibenzosilole group.

In one or more embodiments, CY₃ may be a pyridine group, a pyrimidine group, a pyrazine group, a triazine group, a quinoline group, an isoquinoline group, a quinoxaline group, or a quinazoline group.

R₁₀, R₂₀, and R₄₁ to R₄₈ in Formula 1 are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(Q₈)(Q₉), or - P(=O)(Q₈)(Q₉).

b10, b20, and b30 in Formulae 1A and 1B are each independently 1, 2, 3, 4, 5, 6, 7, 8, 9, or 10.

In one or more embodiments, b10, b20, and b30 may each independently be 1, 2, 3, 4, 5, 6, 7, or 8.

In one or more embodiments, b10, b20, and b30 may each independently be 1, 2, 3, or 4.

In one or more embodiments, b10, b20, and b30 may each independently be 1 or 2.

In one or more embodiments, b10, b20, and b30 may each independently be 1.

In one or more embodiments, R₁₀, R₂₀, and R₄₁ to R₄₈ may each independently be:
hydrogen, deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, or a C₁-C₂₀ alkoxy group;
a C₁-C₂₀ alkyl group or a C₁-C₂₀ alkoxy group, each substituted with one or more of deuterium, -F, -Cl, -Br, -I, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, or a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with one or more of deuterium, -F, -Cl, -Br, -I, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group; or
-Si(Q₁)(Q₂)(Q₃), -Ge(Q₁)(Q₂)(Q₃), -N(Q₄)(Q₅), -B(Q₆)(Q₇), -P(Q₈)(Q₉), or -P(=O)(Q₈)(Q₉).

In one or more embodiments, R₁₀, R₂₀, and R₄₁ to R₄₈ may each independently be:
hydrogen, deuterium, -F, -Cl, -Br, -I, -CD₃, -CD₂H, -CDH₂, -CF₃, -CF₂H, -CFH₂, -SF₅, a C₁-C₆₀ alkyl group, a C₂-C₆₀ alkenyl group, a C₂-C₆₀ alkynyl group, a C₁-C₆₀ alkoxy group, -Si(Q₃)(Q₄)(Q₅), or -Ge(Q₃)(Q₄)(Q₅); or
a group represented by one of Formulae 9-1 to 9-61, 9-201 to 9-237, 10-1 to 10-141, or 10-201 to 10-350:

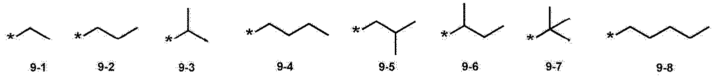

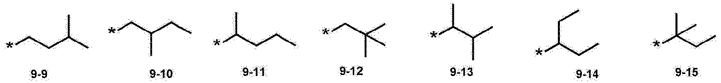

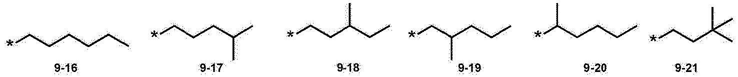

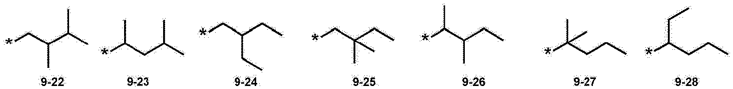

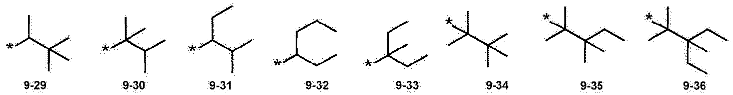

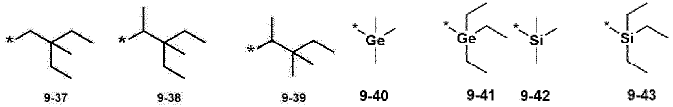

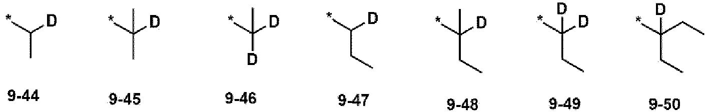

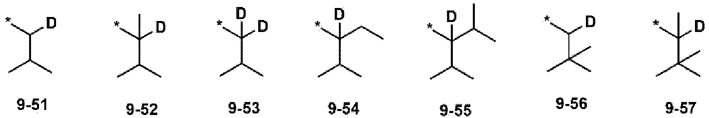

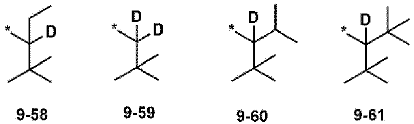

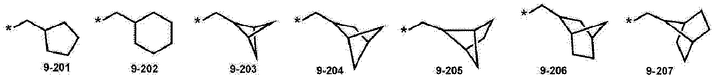

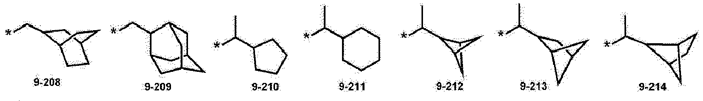

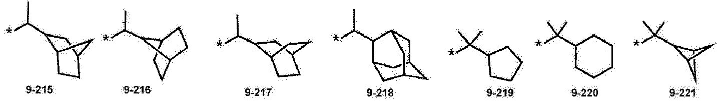

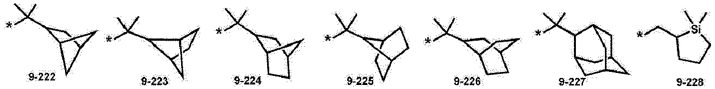

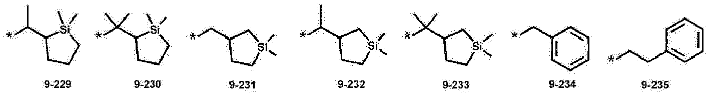

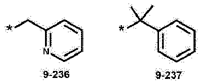

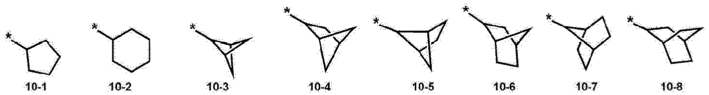

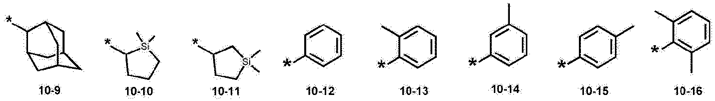

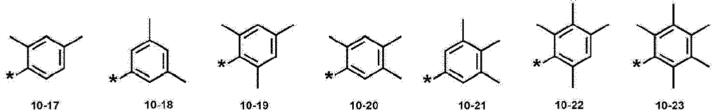

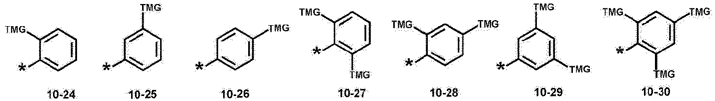

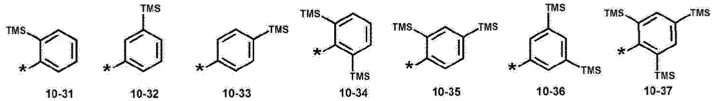

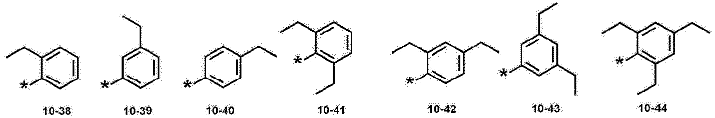

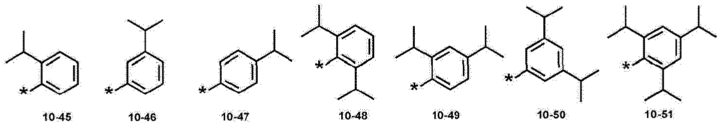

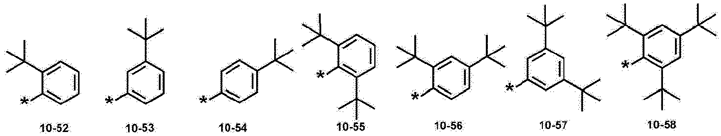

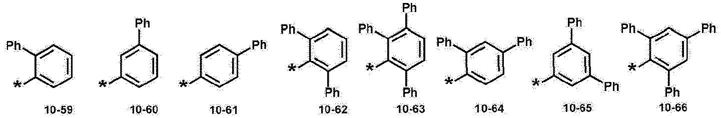

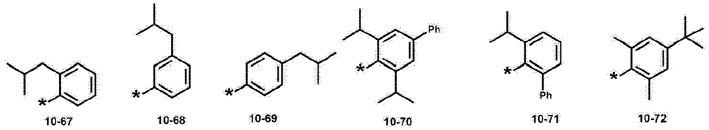

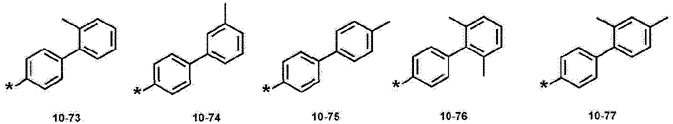

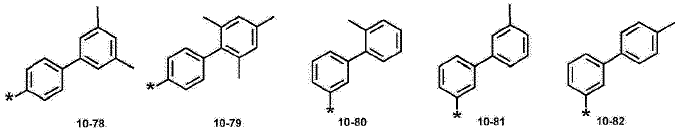

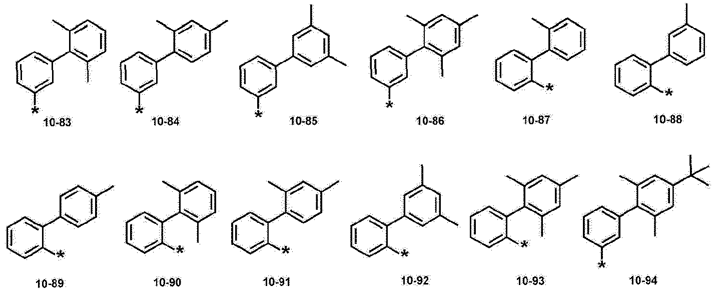

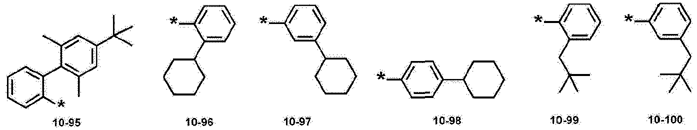

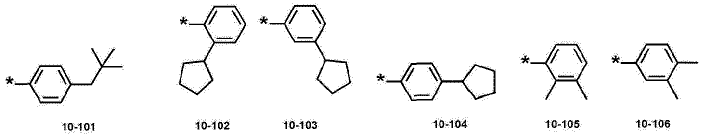

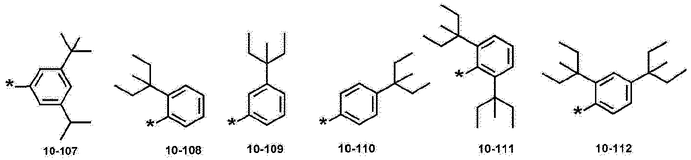

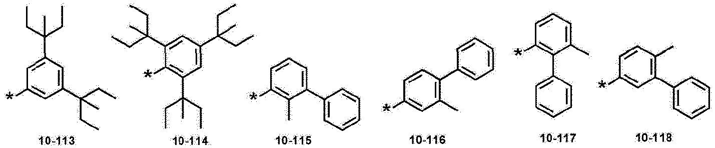

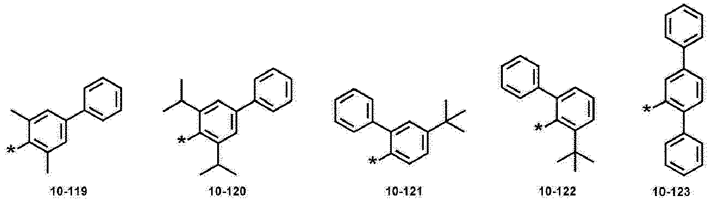

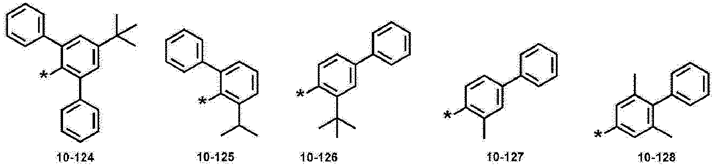

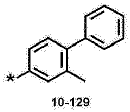

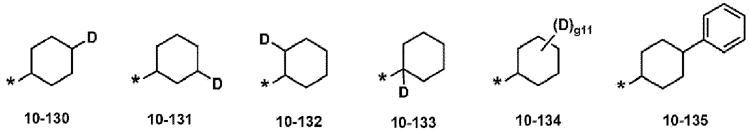

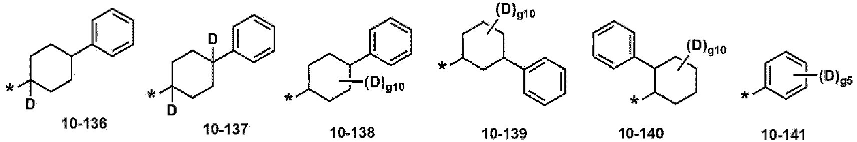

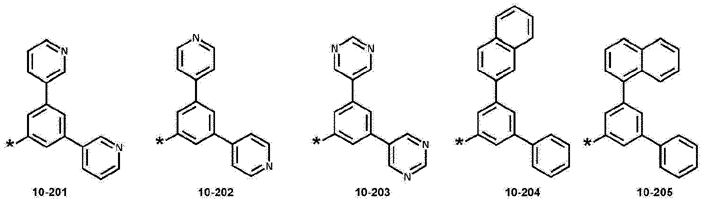

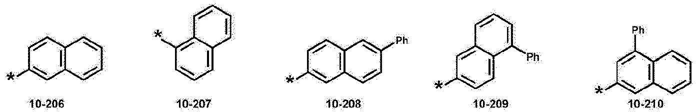

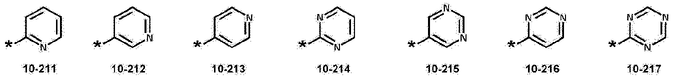

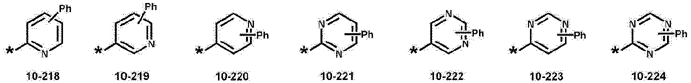

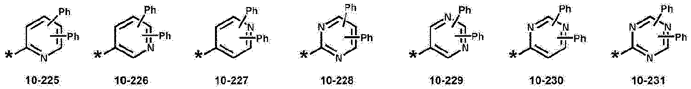

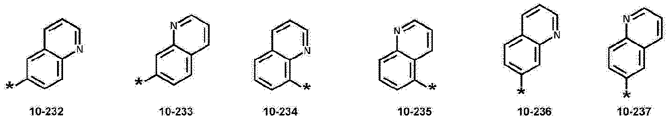

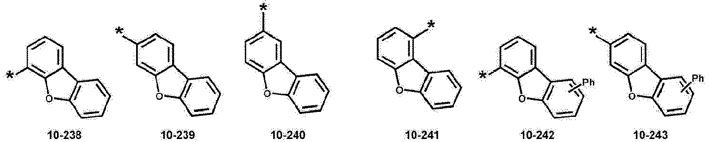

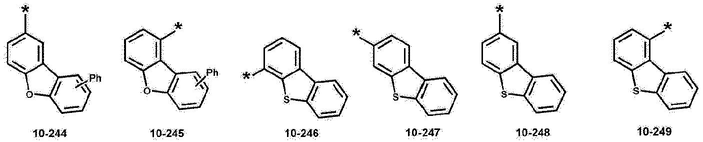

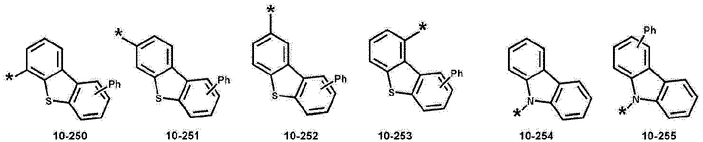

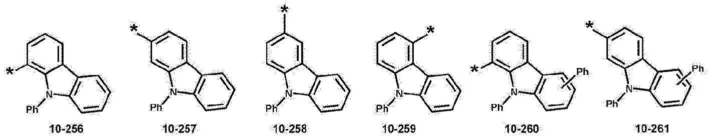

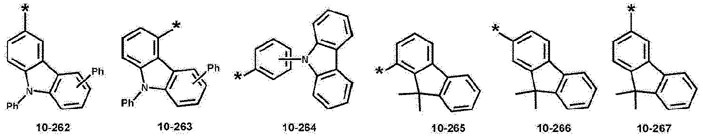

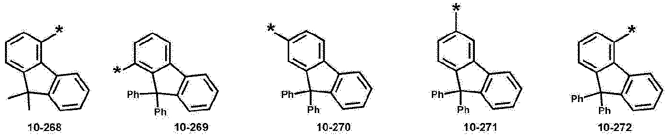

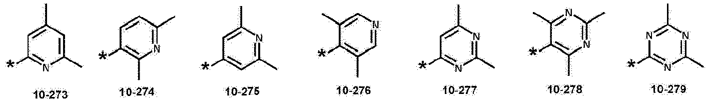

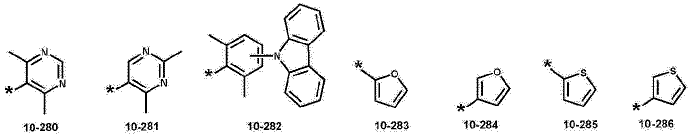

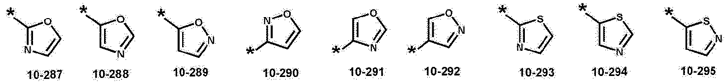

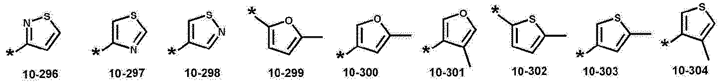

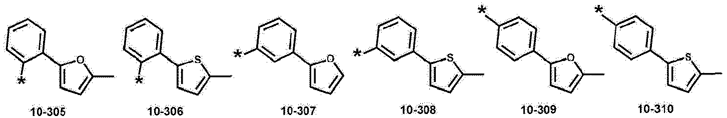

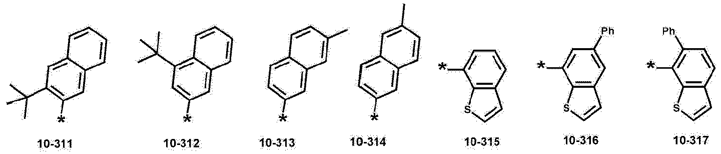

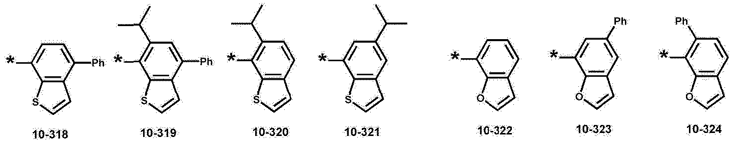

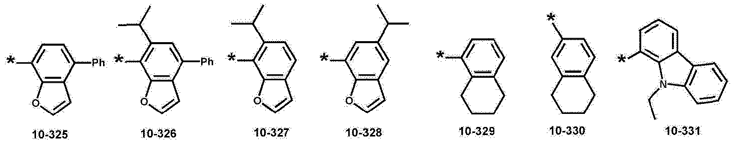

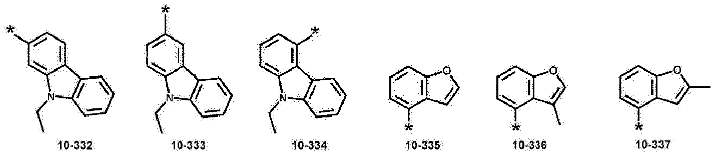

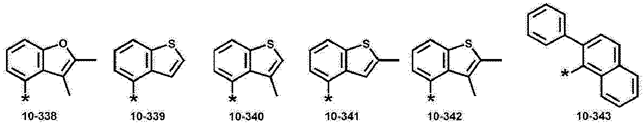

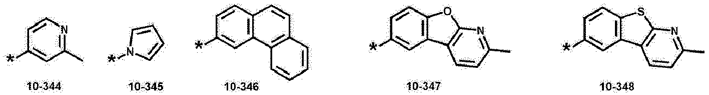

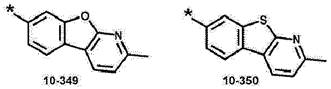

In Formulae 9-1 to 9-61, 9-201 to 9-237, 10-1 to 10-141, and 10-201 to 10-350,
* indicates a binding site to a neighboring atom,
Ph is a phenyl group,
TMS is a trimethylsilyl group,
TMG is a trimethylgermyl group,
g5 may be an integer from 1 to 5,
g10 may be an integer from 1 to 10, and
g11 may be an integer from 1 to 11.

R₃₀ in Formula 1B is hydrogen, a C₂-C₆₀ alkyl group, a C₂-C₆₀ alkyl group substituted with deuterium, or -Ge(Q₁)(Q₂)(Q₃).

In one or more embodiments, R₃₀ may be a group represented by one of Formulae 9-1 to 9-61.

In one or more embodiments, R₃₀ may be:
a C₂-C₂₀ alkyl group;
a C₂-C₂₀ alkyl group substituted with deuterium; or
-Ge(Q₁)(Q₂)(Q₃).

Q₁ to Q₉, Q₁₁ to Q₁₉, Q₂₁ to Q₂₉, and Q₃₁ to Q₃₉ are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, and a substituted or unsubstituted monovalent non-aromatic condensed heteropolycyclic group.

In one or more embodiments, Q₁ to Q₉, Q₁₁ to Q₁₉, Q₂₁ to Q₂₉, and Q₃₁ to Q₃₉ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with one or more of deuterium, a C₁-C₁₀ alkyl group, or a phenyl group.

Two or more of a plurality of R₁₀(s) are optionally linked to each other to form a substituted or unsubstituted C₅-C₃₀ carbocyclic group or a substituted or unsubstituted C₁-C₃₀ heterocyclic group; two or more of a plurality of R₂₀(s) are optionally linked to each other to form a substituted or unsubstituted C₅-C₃₀ carbocyclic group or a substituted or unsubstituted C₁-C₃₀ heterocyclic group; two or more of a plurality of R₃₀(s) are optionally linked to each other to form a substituted or unsubstituted C₅-C₃₀ carbocyclic group or a substituted or unsubstituted C₁-C₃₀ heterocyclic group; and two or more neighboring substituents of R₁₀, R₂₀, and R₃₀ are optionally linked to each other to form a substituted or unsubstituted C₅-C₃₀ carbocyclic group or a substituted or unsubstituted C₁-C₃₀ heterocyclic group.

In one or more embodiments, two or more of a plurality of R₁₀(s); two or more of a plurality of R₂₀(s); and/or two or more neighboring substituents of R₁₀, R₂₀, and R₄₁ to R₄₈ may optionally be linked to each other via a single bond, a double bond or first linking group to form a C₅-C₃₀ carbocyclic group unsubstituted or substituted with at least one R₁₀ₐ or a C₁-C₃₀ heterocyclic group unsubstituted or substituted with at least one R₁₀ₐ (for example, a fluorene group, a xanthene group, an acridine group, etc. unsubstituted or substituted with at least one R₁₀ₐ. R₁₀ₐ) is as described in connection with R₁₀.

In one or more embodiments, CY₁ in Formula 1A may be represented by one of Formulae 1-1 to 1-16:

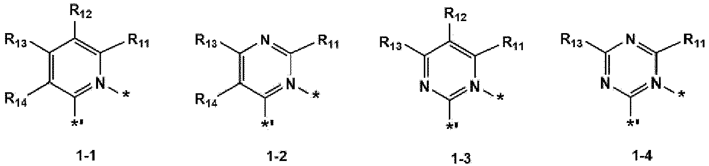

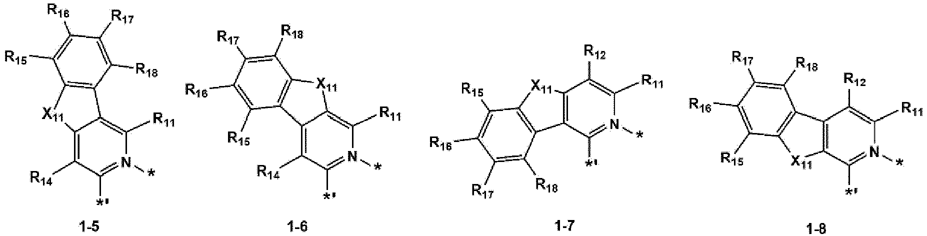

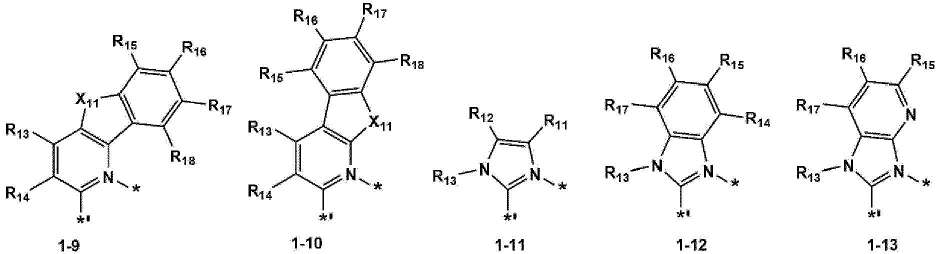

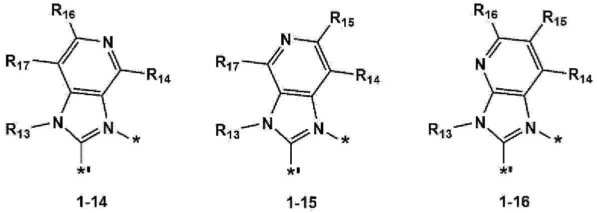

In Formulae 1-1 to 1-16,
X₁₁ may be O, S, N(R₁₉ₐ), C(R₁₉ₐ)(R_{19b}), or Si(R₁₉ₐ)(R_{19b}),
R₁₁ to R₁₈, R₁₉ₐ, and R_{19b} are each independently as described in connection with R₁₀,
two or more neighboring substituents of R₁₁ to R₁₈, R₁₉ₐ, and R_{19b} may optionally be linked to each other to form a substituted or unsubstituted C₅-C₃₀ carbocyclic group or a substituted or unsubstituted C₁-C₃₀ heterocyclic group,
wherein, when R₁₁ to R₁₈, R₁₉ₐ, or R_{19b} is -Si(Q₁)(Q₂)(Q₃) or - Ge(Q₁)(Q₂)(Q₃), Q₁ to Q₃ may each independently be:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂;
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with one or more of deuterium, a C₁-C₁₀ alkyl group, or a phenyl group,
   * indicates a binding site to M₁, and
   *' indicates a binding site to ring CY₂.

In one or more embodiments, CY₂ in Formula 1A may be represented by one of Formulae 2-1 to 2-22:

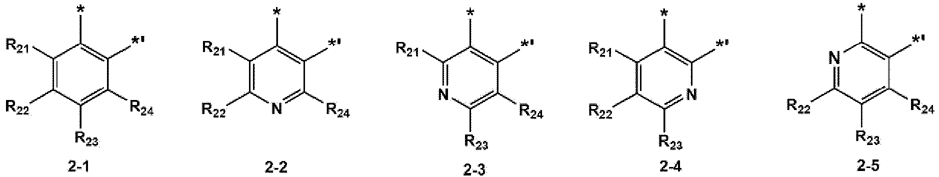

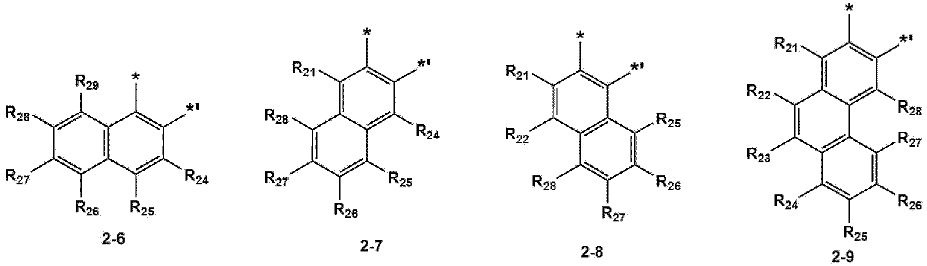

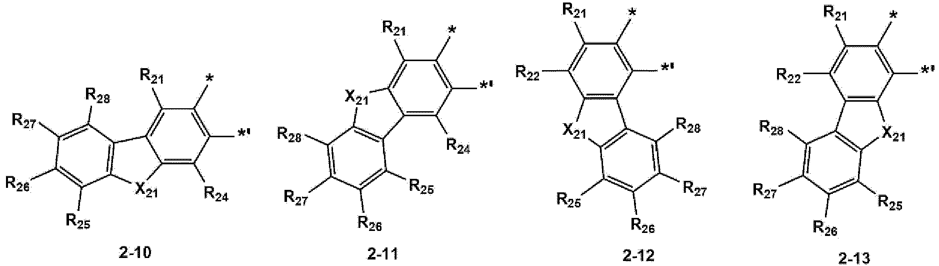

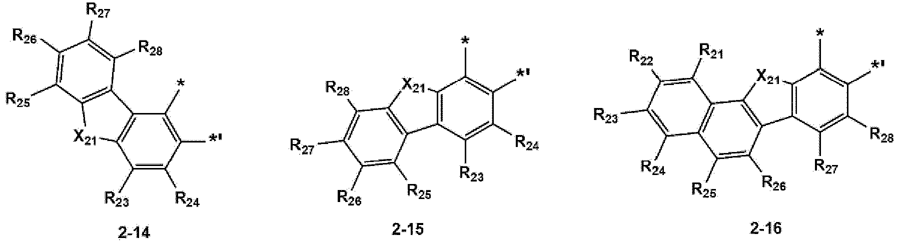

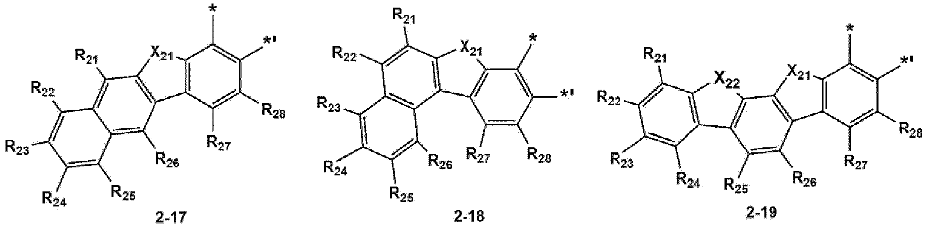

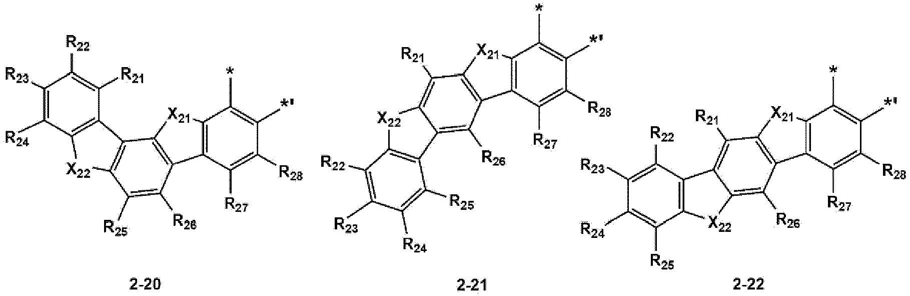

In Formulae 2-1 to 2-22,
X₂₁ and X₂₂ may each independently be O, S, N(R₂₉ₐ), C(R₂₉ₐ)(R_{29b}), or Si(R₂₉ₐ)(R_{29b}),
R₂₁ to R₂₈, R₂₉ₐ, and R_{29b} are each independently as described in connection with R₂₀, and
two or more neighboring substituents of R₂₁ to R₂₈, R₂₉ₐ, and R_{29b} may optionally be linked to each other to form a substituted or unsubstituted C₅-C₃₀ carbocyclic group or a substituted or unsubstituted C₁-C₃₀ heterocyclic group,
wherein, when R₂₁ to R₂₈, R₂₉ₐ, or R_{29b} is -Si(Q₁)(Q₂)(Q₃) or - Ge(Q₁)(Q₂)(Q₃), Q₁ to Q₃ may each independently be:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂;
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with one or more of deuterium, a C₁-C₁₀ alkyl group, or a phenyl group,
   * indicates a binding site to ring CY₁, and
   *' indicates a binding site to M₁.

In one or more embodiments, two or more neighboring substituents of R₁₁ to R₁₈, R₁₉ₐ, and R_{19b}; or R₂₁ to R₂₈, R₂₉ₐ, and R_{29b} may be optionally linked to each other to form a C₅-C₃₀ carbocyclic group unsubstituted or substituted with at least one R_{10a;} or a C₁-C₃₀ heterocyclic group unsubstituted or substituted with at least one R₁₀ₐ.

For example, two or more neighboring substituents of R₁₁ to R₁₈, R₁₉ₐ, or R_{19b}; or R₂₁ to R₂₈, R₂₉ₐ, or R_{29b} may optionally be linked to each other to form a cyclopentane group, a cyclopentene group, a cyclopentadiene group, a furan group, a thiophene group, a pyrrole group, a silole group, an adamantane group, a norbornane group, a norbornene group, a cyclohexane group, a cyclohexene group, a phenyl group, a naphthalene group, an indene group, an indole group, a benzofuran group, a benzothiophene group, a benzosilole group, a fluorene group, a carbazole group, a dibenzofuran group, a dibenzothiophene group, or dibenzosilole group, each unsubstituted or substituted with at least one R₁₀ₐ.

In one or more embodiments, CY₃ in Formula 1B may be represented by one of Formulae 3-1 to 3-16:

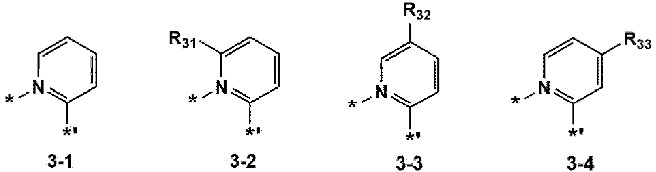

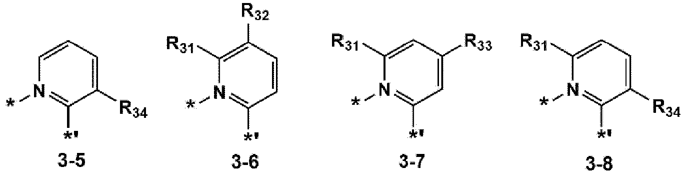

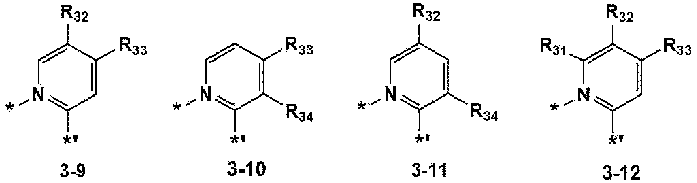

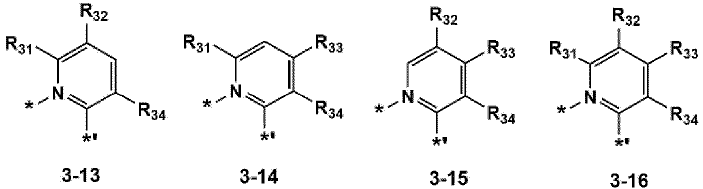

In Formulae 3-1 to 3-16,
R₃₁ to R₃₄ may each independently be as described in connection with R₃₀,
* indicates a binding site to M₁, and
*' indicates a binding site to a neighboring atom.

In one or more embodiments, the organometallic compound may be a compound represented by Formula 11-1:

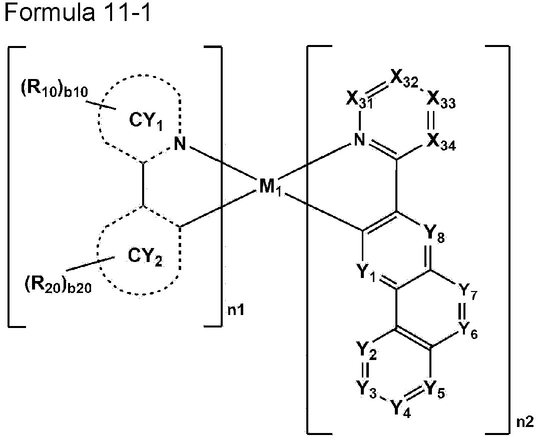

In Formula 11-1,
M₁, n1, n2, CY₁, CY₂, Y₁ to Y₈, R₁₀, R₂₀, b10 and b20 each are as described herein,
X₃₁ may be C(R₃₁) or N, X₃₂ may be C(R₃₂) or N, X₃₃ may be C(R₃₃) or N, and X₃₄ may be C(R₃₄) or N,
R₃₁ to R₃₄ are each independently as described in connection with R₃₀, and
two or more of R₃₁ to R₃₄ may optionally be linked to form a substituted or unsubstituted C₅-C₃₀ carbocyclic group or a substituted or unsubstituted C₁-C₃₀ heterocyclic group.

In one or more embodiments, two or more neighboring substituents of R₃₁ to R₃₄ are optionally linked to form a C₅-C₃₀ carbocyclic group unsubstituted or substituted with at least one R₁₀ₐ, or a C₁-C₃₀ heterocyclic group unsubstituted or substituted with at least one R₁₀ₐ.

For example, two or more neighboring substituents of R₃₁ to R₃₄ may optionally be linked to each other to form a cyclopentane group, a cyclopentene group, a cyclopentadiene group, a furan group, a thiophene group, a pyrrole group, a silole group, an adamantane group, a norbornane group, a norbornene group, a cyclohexane group, a cyclohexene group, a phenyl group, a naphthalene group, an indene group, an indole group, a benzofuran group, a benzothiophene group, a benzosilole group, a fluorene group, a carbazole group, a dibenzofuran group, a dibenzothiophene group, or dibenzosilole group, each unsubstituted or substituted with at least one R₁₀ₐ.

In one or more embodiments, examples of the "C₅-C₃₀ carbocyclic group unsubstituted or substituted with at least one R₁₀ₐ, or a C₁-C₃₀ heterocyclic group unsubstituted or substituted with at least one R₁₀ₐ" include a phenyl group, a naphthalene group, a cyclopentane group, a cyclopentene group, a cyclopentadiene group, a cyclohexane group, a cyclohexene group, a cycloheptane group, a cycloheptene group, a bicyclo[2.2.1]heptane group, a furan group, a thiophene group, a pyrrole group, a silole group, an indene group, a benzofuran group, a benzothiophene group, an indole group, or a benzosilole group, each unsubstituted or substituted with at least one R₁₀ₐ. R₁₀ₐ may be as described in connection with R₁₀. The C₅-C₃₀ carbocyclic group and the C₁-C₃₀ heterocyclic group each may be as described herein.

In one or more embodiments, the organometallic compound may be a compound represented by Formula 12-1:

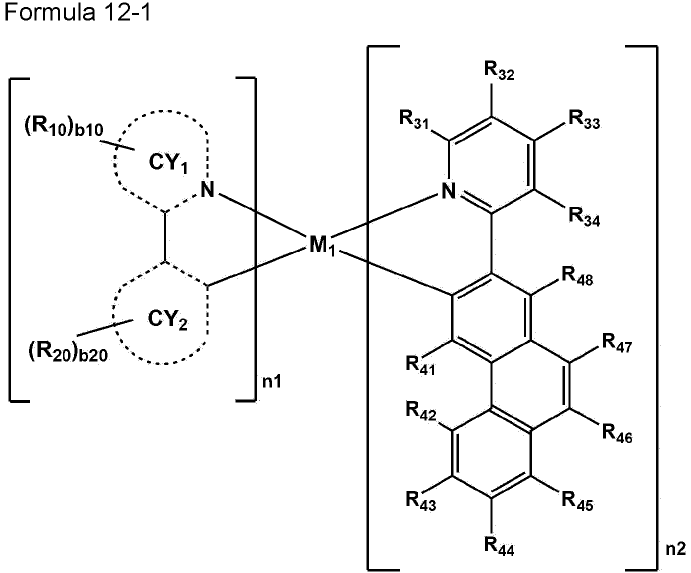

In Formula 12-1,
M₁, n1, n2, CY₁, CY₂, R₁₀, R₂₀, b10, b20, and R₄₁ to R₄₈ each may be as described herein, and
R₃₁ to R₃₄ each may be independently as described in connection with R₃₀.

In one or more embodiments, at least one of R₁₀(s) in the number of b10 and R₂₀(s) in the number of b20 may be a substituted or unsubstituted C₁-C₆₀ alkyl group, a substituted or unsubstituted C₃-C₁₀ cycloalkyl group, -Si(Q₁)(Q₂)(Q₃), or - Ge(Q₁)(Q₂)(Q₃).

In one or more embodiments, at least one of R₁₀(s) in the number of b10 and R₂₀(s) in the number of b20 may be a methyl group, an ethyl group, an n-propyl group, an isopropyl group, an n-butyl group, an isobutyl group, a sec-butyl group, a tert-butyl group, an n-pentyl group, an isopentyl group, a 2-methylbutyl group, a sec-pentyl group, a tert-pentyl group, a neo-pentyl group, a 3-pentyl group, a 3-methyl-2-butyl group, a cyclopropyl group, a cyclobutyl group, a cyclopentyl group, a cyclohexyl group, a cycloheptyl group, a cyclooctyl group, a phenyl group, a biphenyl group, a C₁-C₂₀ alkyl phenyl group, a naphthyl group, -Si(Q₁)(Q₂)(Q₃), or -Ge(Q₁)(Q₂)(Q₃).

In one or more embodiments, at least one of R₃₁ to R₃₄ in Formula 11-1 or Formula 12-1 may be an ethyl group, an n-propyl group, an isopropyl group, an n-butyl group, an isobutyl group, a sec-butyl group, a tert-butyl group, an n-pentyl group, an isopentyl group, a 2-methylbutyl group, a sec-pentyl group, a tert-pentyl group, a neo-pentyl group, a 3-pentyl group, a 3-methyl-2-butyl group, -CH₂CD₃, -CH₂CD₂H, - CH₂CDH₂, -CHDCH₃, -CHDCD₂H, -CHDCDH₂, -CHDCD₃, -CD₂CD₃, -CD₂CD₂H, - CD₂CDH₂, or -Ge(Q₁)(Q₂)(Q₃).

In one or more embodiments, at least one of R₃₁ to R₃₄ in Formulae 3-1 to 3-16 may be an ethyl group, an n-propyl group, an isopropyl group, an n-butyl group, an isobutyl group, a sec-butyl group, a tert-butyl group, an n-pentyl group, an isopentyl group, a 2-methylbutyl group, a sec-pentyl group, a tert-pentyl group, a neo-pentyl group, a 3-pentyl group, a 3-methyl-2-butyl group, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, -CD₂CDH₂, or - Ge(Q₁)(Q₂)(Q₃).

In one or more embodiments, the organometallic compound may be electrically neutral.

In one or more embodiments, the organometallic compound may be one of Compounds 1 to 7, 9 to 101, and 112 to 179:

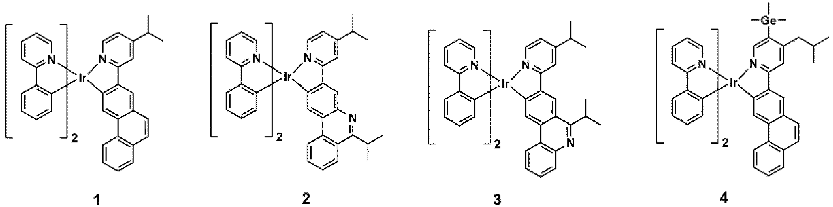

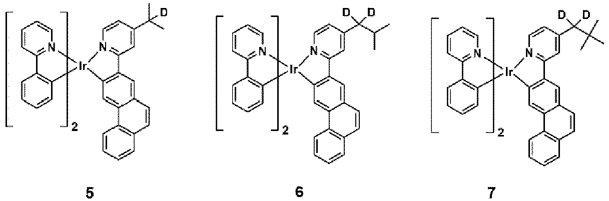

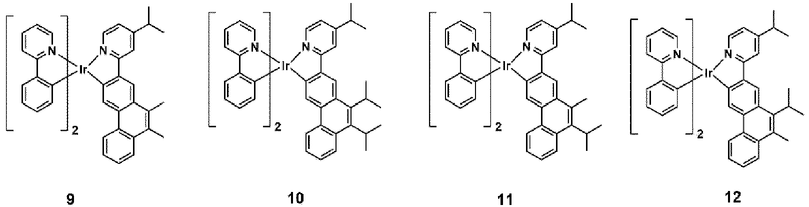

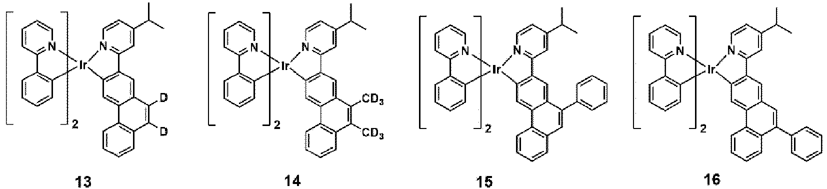

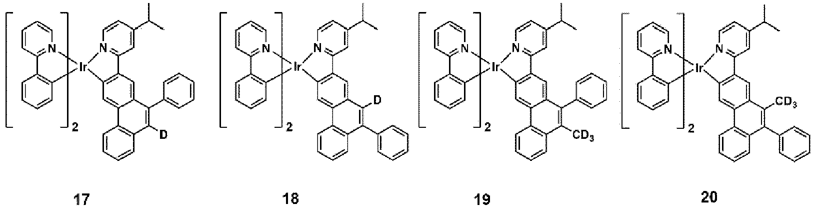

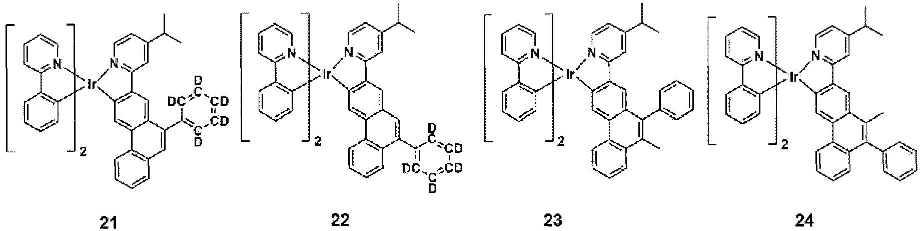

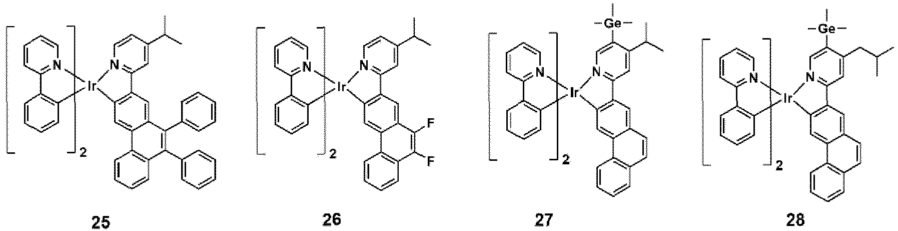

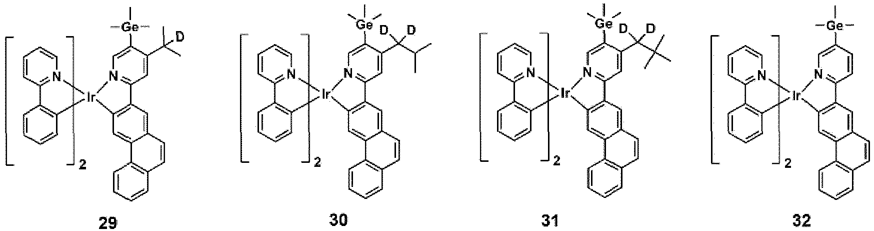

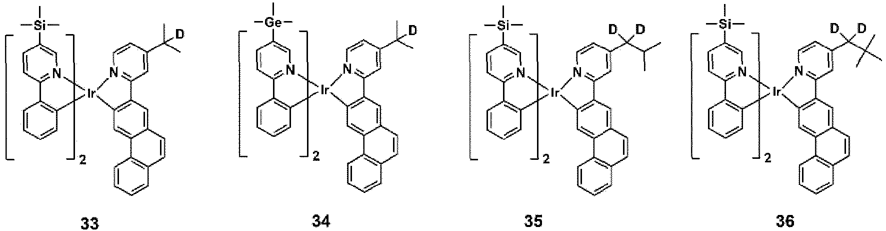

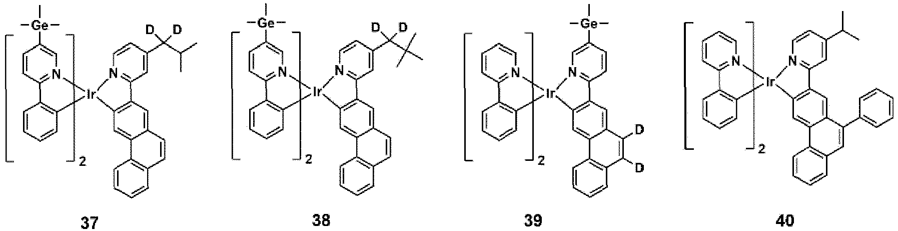

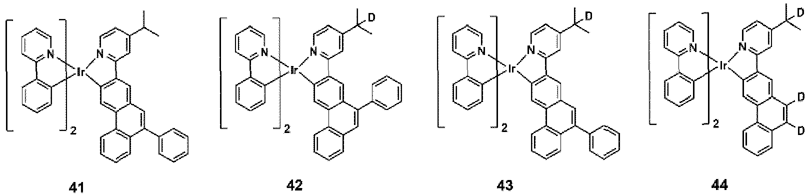

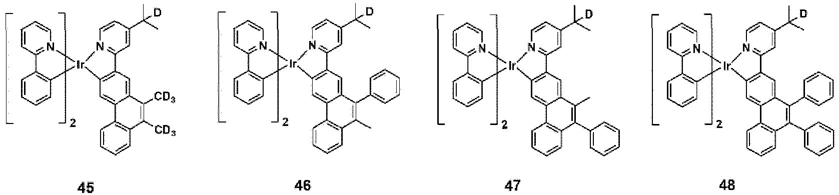

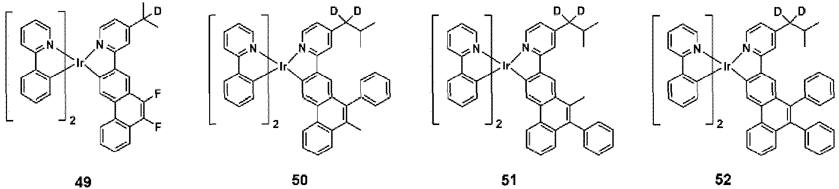

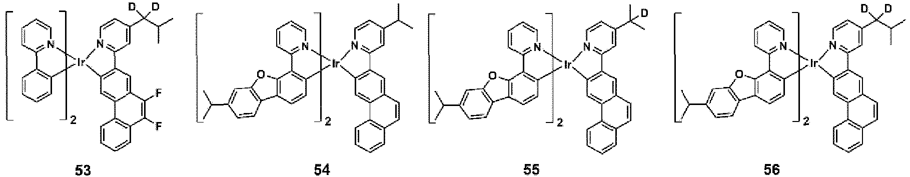

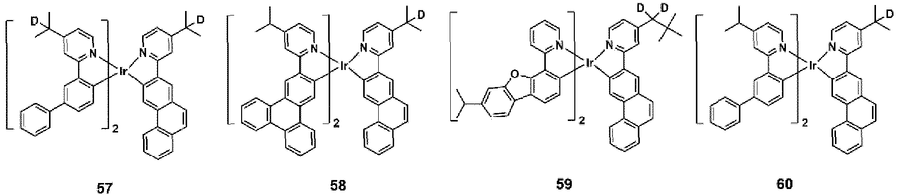

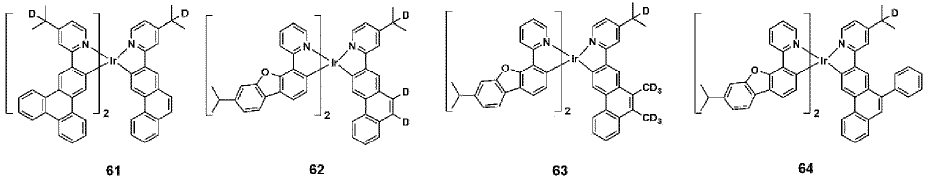

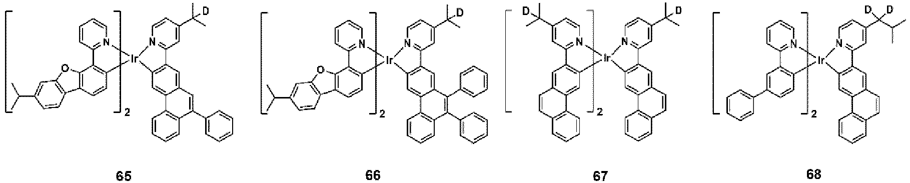

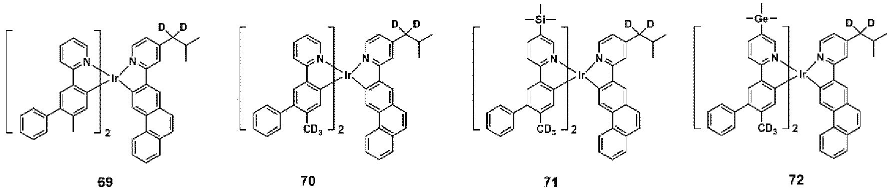

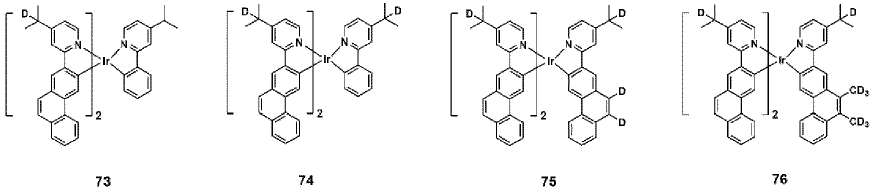

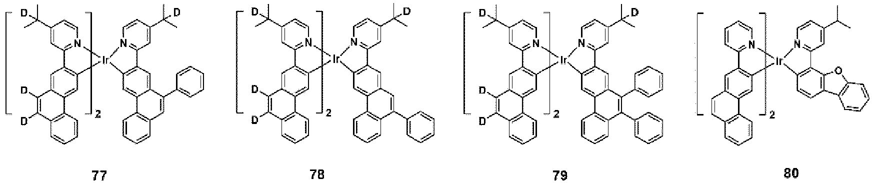

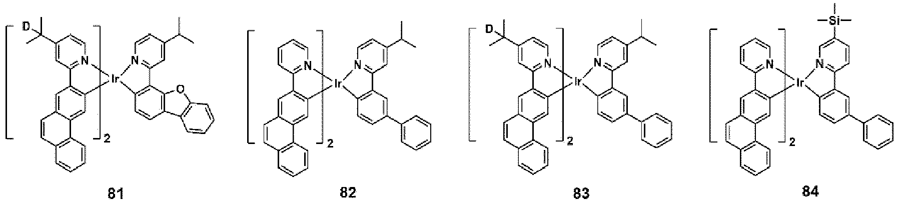

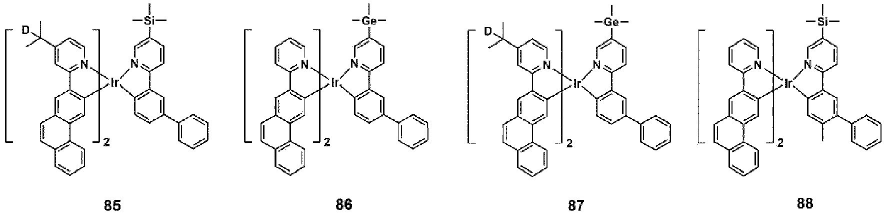

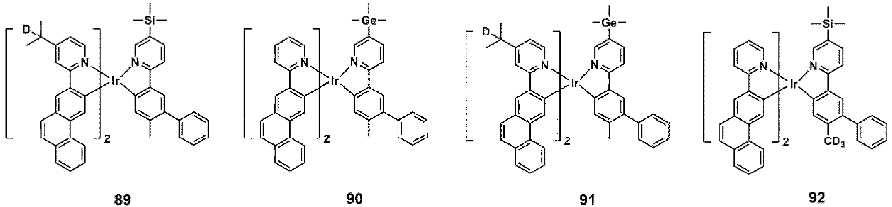

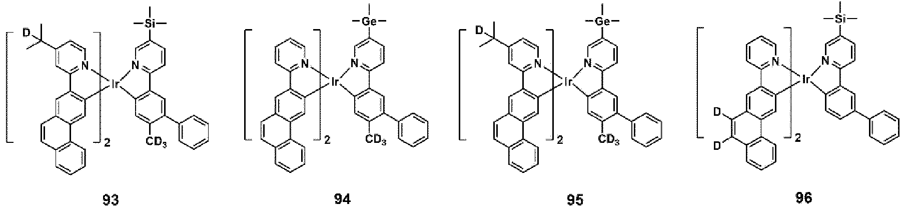

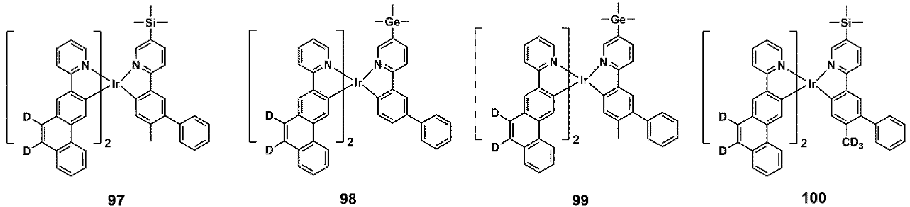

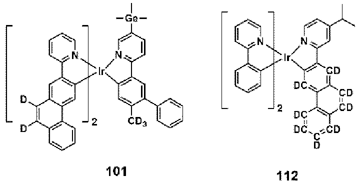

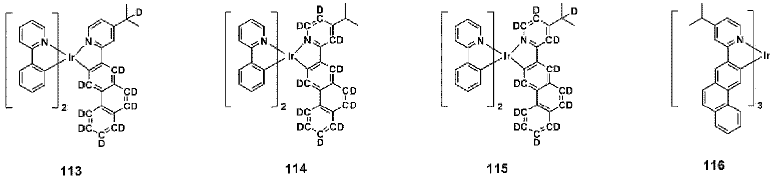

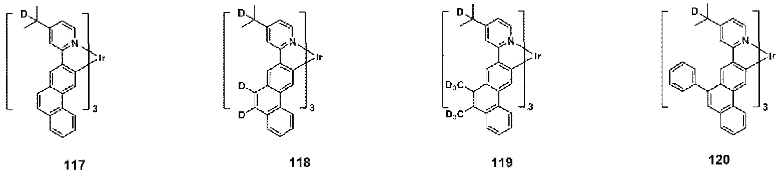

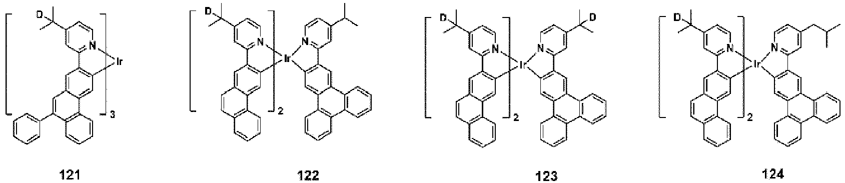

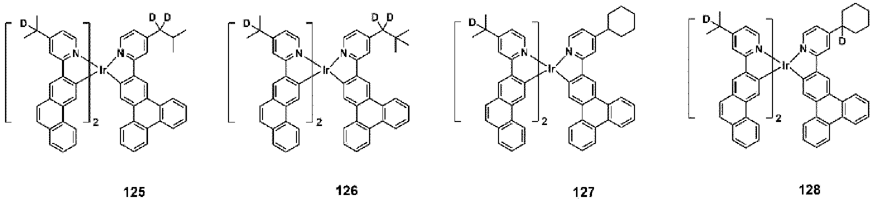

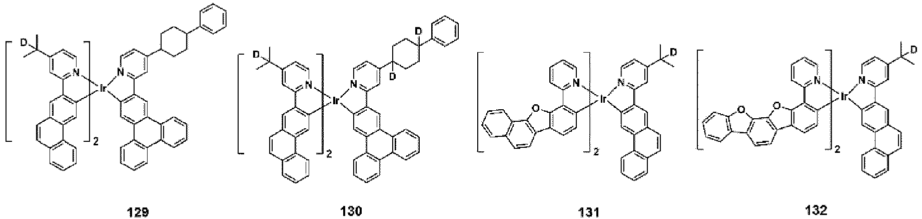

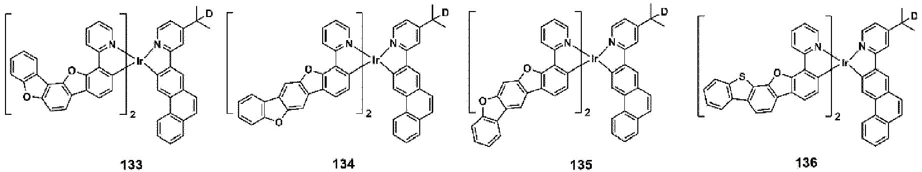

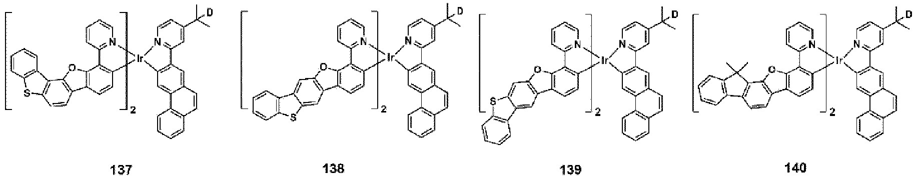

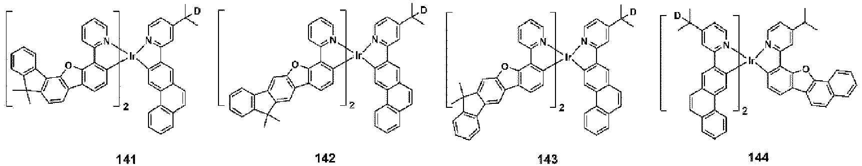

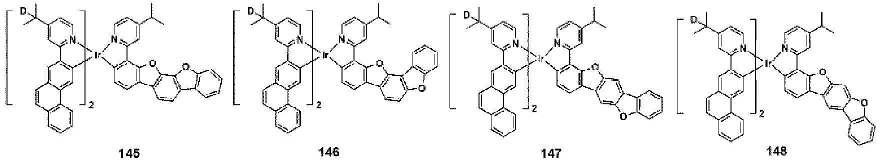

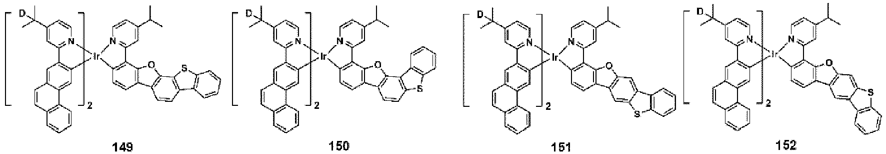

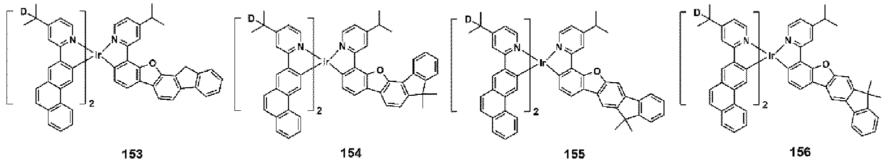

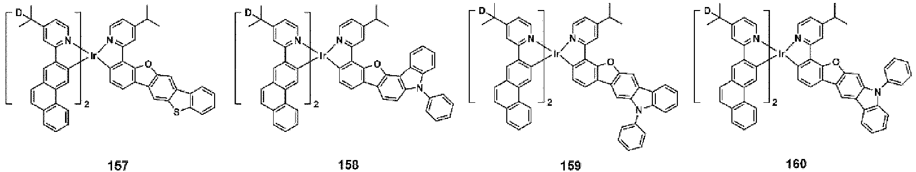

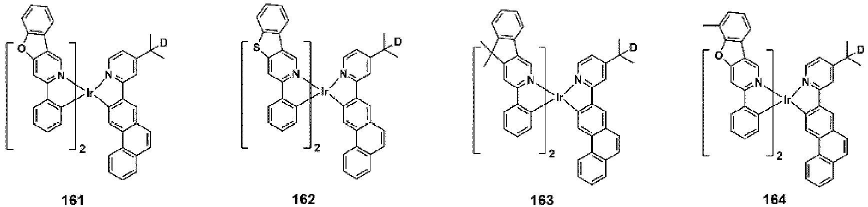

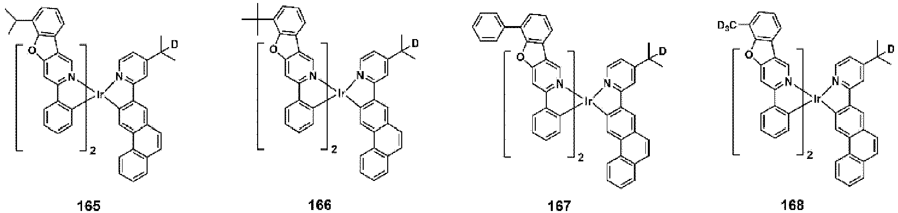

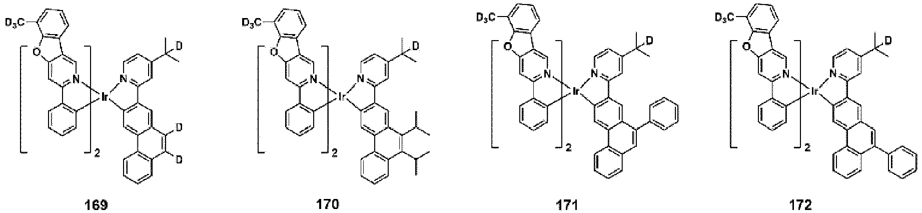

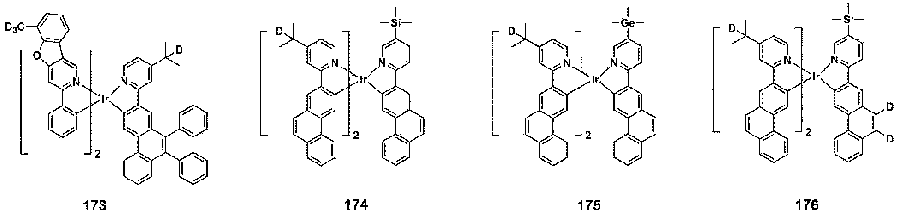

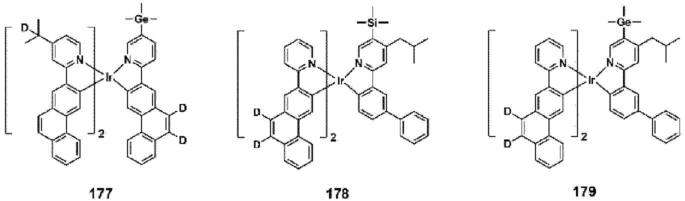

The organometallic compound represented by Formula 1 satisfies the structure of Formula 1 and includes at least one bidentate ligand represented by Formula 1B. In one or more embodiments, among the bidentate ligands represented by Formula 1B, a substituted or unsubstituted methyl group (e.g. a methyl group or a methyl group substituted with groups other than alkyl group) and silyl group are excluded from R₃₀, which is a substituent of ring CY₃. Due to this structure, the organometallic compound has excellent luminescence characteristics, and has such characteristics suitable for use as a luminescent material with high color purity by controlling the emission wavelength range. In this regard, it is to be understood that the "substituted methyl group" is differentiated from a C₂ or higher alkyl group. Accordingly, in Table 1 below, Formulae 1 to 3 are not considered to include a "substituted methyl group." Similarly, in Table 1 below, Formula B exemplifies the substituted methyl group as used in Table 1.

In one or more embodiments, the organometallic compound represented by Formula 1 may have excellent electrical mobility, and thus, electronic devices including the organometallic compound, for example, organic light-emitting devices including the organometallic compound may show low driving voltage, high efficiency, long lifespan, and reduced roll-off phenomenon.

In one or more embodiments, the photochemical stability of the organometallic compound represented by Formula 1 may be improved, and thus, electronic devices including the organometallic compound, for example, organic light-emitting devices including the organometallic compound, may show high emission efficiency, long lifespan, and high color purity.

The highest occupied molecular orbital (HOMO) energy level, lowest unoccupied molecular orbital (LUMO) energy level, energy gap (electron volts, eV), lowest excited triplet (T₁) energy level, and lowest excited singlet (S₁) energy level of selected organometallic compounds represented by Formula 1 were calculated using a density functional theory (DFT) method of the Gaussian 09 program with the molecular structure optimization at the B3LYP level, and results thereof are shown in Table 1.

**Table 1**

| Compound No. | HOMO (eV) | LUMO (eV) | Energy gap (eV) | S₁ (eV) | T₁ (eV) |
|---|---|---|---|---|---|
| Compound 1 | -4.734 | -1.329 | 3.405 | 2.765 | 2.475 |
| Compound 2 | -4.820 | -1.362 | 3.458 | 2.796 | 2.519 |
| Compound 3 | -4.978 | -1.445 | 3.533 | 2.839 | 2.556 |
| Compound A | -4.727 | -1.369 | 3.358 | 2.729 | 2.450 |
| Compound B | -4.744 | -1.311 | 3.433 | 2.786 | 2.493 |
| Compound C | -4.760 | -1.523 | 3.237 | 2.583 | 2.386 |

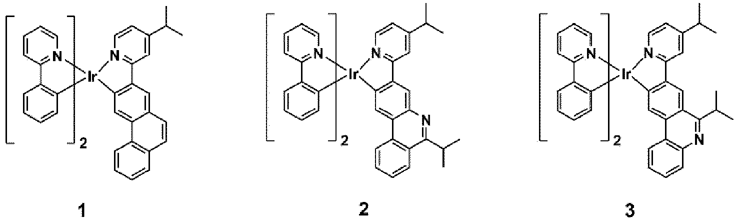

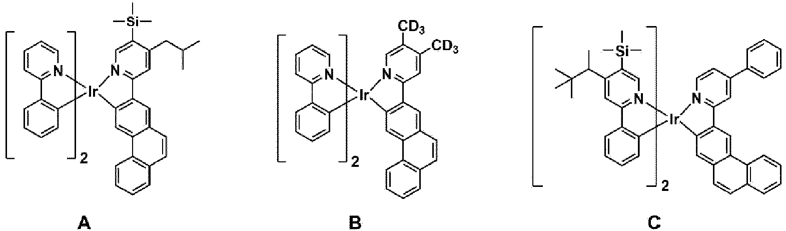

Referring to Table 1, it was confirmed that the organometallic compound represented by Formula 1 has electric characteristics that are desirable for a dopant in an electronic device, for example, an organic light-emitting device.

In one or more embodiments, the full width at half maximum (FWHM) of the emission peak of the emission spectrum or the electroluminescence spectrum of the organometallic compound may be 70 nanometers (nm) or less. For example, the FWHM of the emission peak of the emission spectrum or the electroluminescence spectrum of the organometallic compound may be from about 30 nm to about 65 nm, from about 40 nm to about 63 nm, or from about 45 nm to about 62 nm.

In one or more embodiments, the maximum emission wavelength (emission peak wavelength (λₘₐₓ), nm) of the emission peak of the emission spectrum or electroluminescence spectrum of the organometallic compound may be from about 500 nm to about 600 nm.

Synthesis methods of the organometallic compound represented by Formula 1 may be understood by a person having ordinary skill in the art by referring to Synthesis Examples provided herein.

The organometallic compound represented by Formula 1 is suitable for use in an organic layer of an organic light-emitting device, for example, for use as a dopant in an emission layer of the organic layer. Thus, another aspect provides an organic light-emitting device that includes a first electrode; a second electrode; and an organic layer located between the first electrode and the second electrode, wherein the organic layer includes an emission layer, and wherein the organic layer includes at least one organometallic compound represented by Formula 1.

As described herein, due to the inclusion of the organometallic compound represented by Formula 1 in the organic layer, the organic light-emitting device may have excellent characteristics in terms of driving voltage, current efficiency, power efficiency, external quantum efficiency (EQE), lifespan, and/or color purity. In addition, an organic light-emitting device may have a reduced roll-off phenomenon and a relatively narrow electroluminescent (EL) spectrum emission peak FWHM.

The organometallic compound represented by Formula 1 may be located between a pair of electrodes of an organic light-emitting device. For example, at least one organometallic compound represented by Formula 1 may be included in the emission layer. In this regard, the at least one organometallic compound may act as a dopant, and the emission layer may further include a host. In one or more embodiments, an amount of the organometallic compound represented by Formula 1 in the emission layer is less than an amount of the host in the emission layer.

In one or more embodiments, the emission layer may emit green light. For example, the emission layer may emit green light having a maximum emission wavelength of about 500 nm to about 600 nm.

The expression "(an organic layer) includes at least one of organometallic compounds" used herein may include a case in which "(an organic layer) includes a single organometallic compound represented by Formula 1" and a case in which "(an organic layer) includes two or more different organometallic compounds represented by Formula 1."

For example, the organic layer may include, as the organometallic compound, only a single Compound 1. In this embodiment, Compound 1 may be included in the emission layer of the organic light-emitting device. In one or more embodiments, the organic layer may include, as the organometallic compound, Compound 1 and Compound 2. In this regard, Compound 1 and Compound 2 may be in the same layer (for example, Compound 1 and Compound 2 both may be in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode is an anode, and the second electrode is a cathode, and the organic layer may further include a hole transport region located between the first electrode and the emission layer, and an electron transport region located between the emission layer and the second electrode, the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" used herein refers to a single layer or a plurality of layers located between the first electrode and the second electrode of the organic light-emitting device. The "organic layer" may include, in addition to an organic compound, an organometallic complex including a metal.

The FIGURE is a schematic cross-sectional view of an organic light-emitting device 10 according to one or more embodiments. Hereinafter, the structure of an organic light-emitting device according to one or more embodiments of the present disclosure and a method of manufacturing an organic light-emitting device according to one or more embodiments of the present disclosure will be described in connection with the FIGURE. The organic light-emitting device 10 includes a first electrode 11, an organic layer 15, and a second electrode 19, which are sequentially stacked in this order.

A substrate may be additionally located under or beneath the first electrode 11 or above or on top of the second electrode 19. For use as the substrate, any substrate that is used in organic light-emitting devices, including those available in the art, may be used. In one or more embodiments, the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode 11 on the substrate. The first electrode 11 may be an anode. The material for forming the first electrode 11 may be chosen from materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a structure with a single layer, or the first electrode 11 may have a structure including two or more layers. For example, the first electrode 11 may have a three-layered structure of ITO/Ag/ITO, but the structure of the first electrode 11 is not limited thereto.

The organic layer 15 is located on the first electrode 11.

The organic layer 15 may include a hole transport region, an emission layer, and an electron transport region.

The hole transport region may be located between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. In one or more embodiments, the hole transport region may have a hole injection layer/hole transport layer structure, or a hole injection layer/hole transport layer/electron blocking layer structure, wherein, for each structure, each layer is sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 °C to about 500 °C, a vacuum pressure of about 1.33 x 10⁻⁶ Pa (10⁻⁸ torr) to about 0.133 Pa (10⁻³ torr), and a deposition rate of about 0.01 angstroms per second (Å/s) to about 100 Å/s. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80 °C to about 200 °C. However, the coating conditions are not limited thereto.

The conditions for forming the hole transport layer and the electron blocking layer may be the same as the conditions for forming the hole injection layer.

The hole transport region may include at least one of m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, or a compound represented by Formula 202:

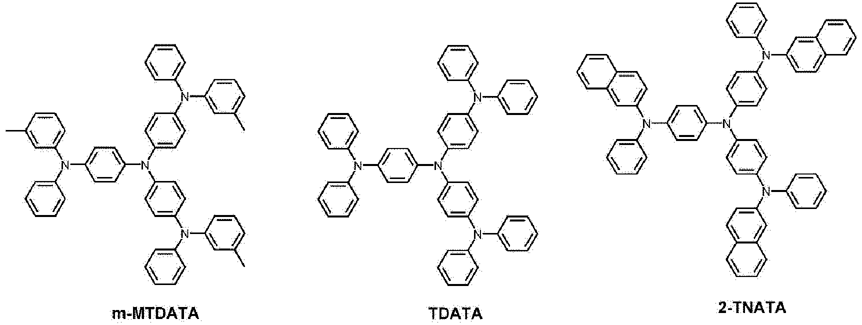

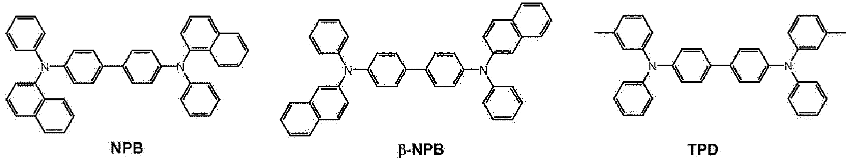

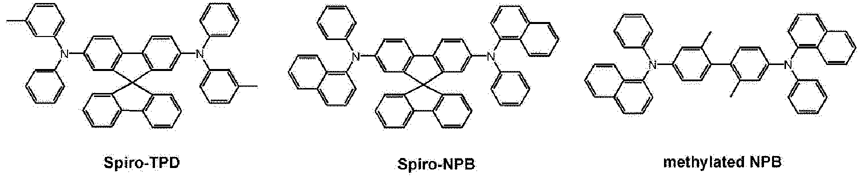

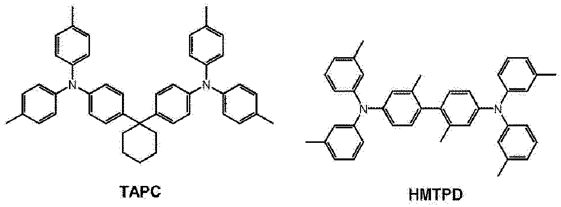

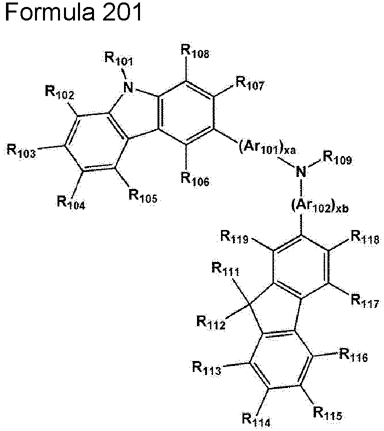

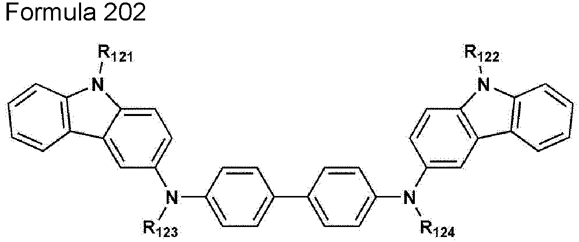

Ar₁₀₁ and Ar₁₀₂ in Formula 201 may each independently be:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with one or more of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₂-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group.

xa and xb in Formula 201 may each independently be an integer from 0 to 5, or 0, 1, or 2. For example, xa may be 1 and xb may be 0, but xa and xb are not limited thereto.

R₁₀₁ to R₁₀₈, R₁₁₁ to R₁₁₉ and R₁₂₁ to R₁₂₄ in Formulae 201 and 202 may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, or the like), or a C₁-C₁₀ alkoxy group (for example, a methoxy group, an ethoxy group, a propoxy group, a butoxy group, a pentoxy group, or the like);
a C₁-C₁₀ alkyl group or a C₁-C₁₀ alkoxy group, each substituted with one or more of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, or a phosphoric acid group or a salt thereof;
a phenyl group, a naphthyl group, an anthracenyl group, a fluorenyl group, or a pyrenyl group; or
a phenyl group, a naphthyl group, an anthracenyl group, a fluorenyl group, or a pyrenyl group, each substituted with one or more of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, or a C₁-C₁₀ alkoxy group, but embodiments of the present disclosure are not limited thereto.

R₁₀₉ in Formula 201 may be:
a phenyl group, a naphthyl group, an anthracenyl group, or a pyridinyl group; or
a phenyl group, a naphthyl group, an anthracenyl group, or a pyridinyl group, each substituted with one or more of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, or a pyridinyl group.

According to one or more embodiments, the compound represented by Formula 201 may be represented by Formula 201A, but embodiments of the present disclosure are not limited thereto:

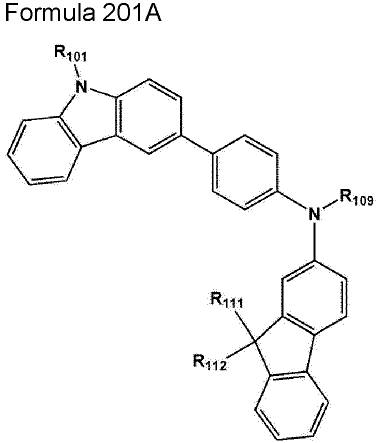

R₁₀₁, R₁₁₁, R₁₁₂, and R₁₀₉ in Formula 201A may be understood by referring to the description provided herein for these substituent groups.

For example, the compound represented by Formula 201, or the compound represented by Formula 202 may include one or more of Compounds HT1 to HT20, but are not limited thereto:

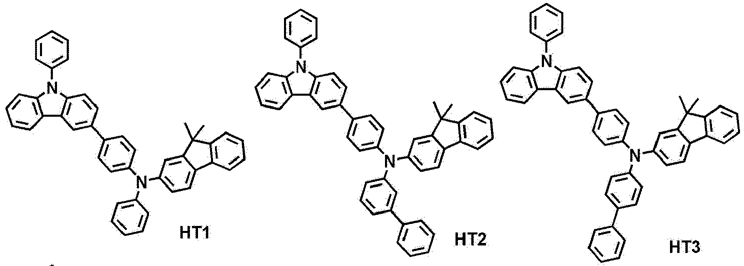

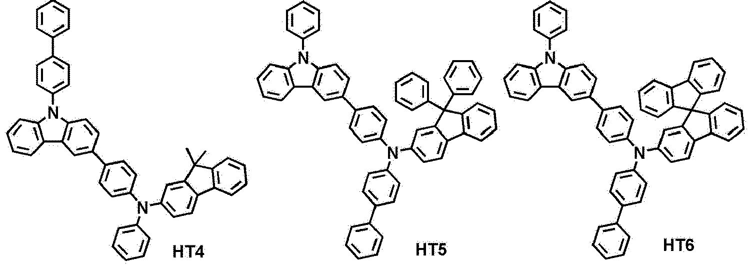

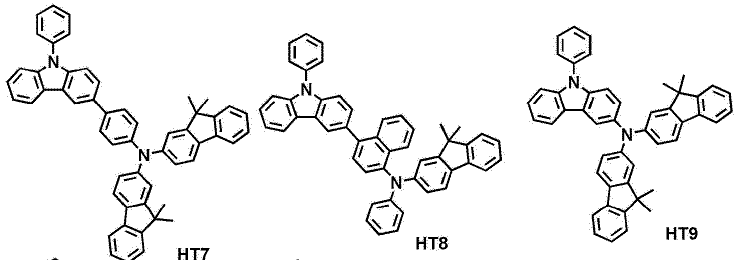

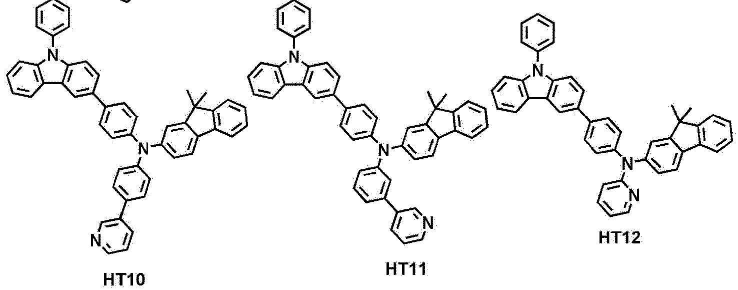

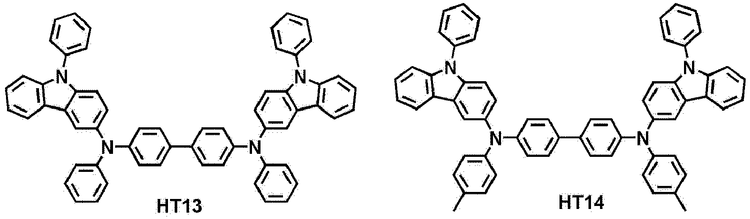

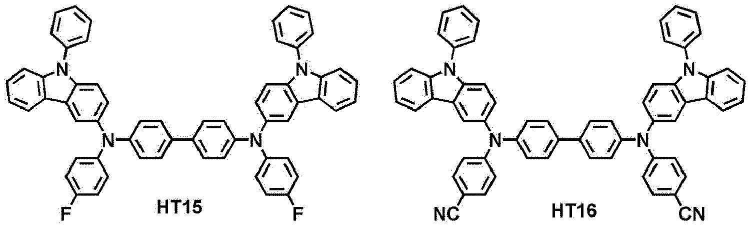

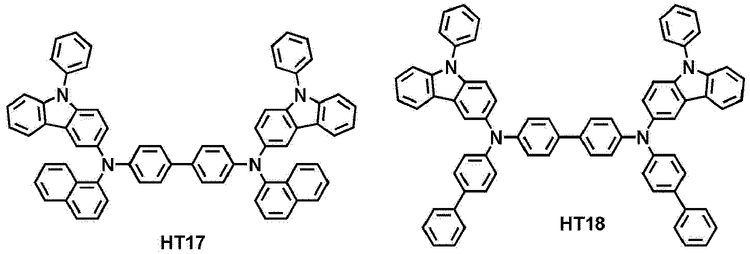

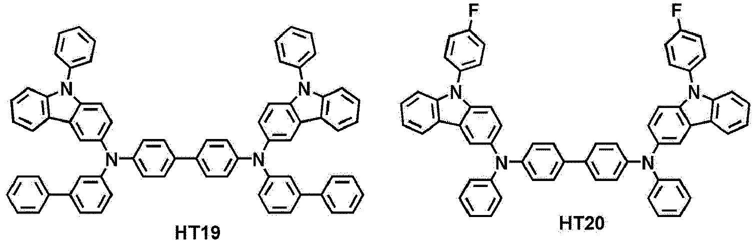

A thickness of the hole transport region may be in the range of about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. Without wishing to be bound to theory, when the thicknesses of the hole transport region, the hole injection layer, and the hole transport layer are within these ranges, satisfactory hole transport characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be a quinone derivative, a metal oxide, or a cyano group-containing compound, but embodiments of the present disclosure are not limited thereto. Non-limiting examples of the p-dopant are a quinone derivative, for example, tetracyanoquinodimethane (TCNQ) or 2,3,5,6-tetrafluoro-tetracyano-1,4-benzoquinodimethane (F4-TCNQ); a metal oxide, for example, a tungsten oxide or a molybdenum oxide; or a cyano group-containing compound, such as one of Compounds HT-D1 or F12, but embodiments of the present description are not limited thereto.

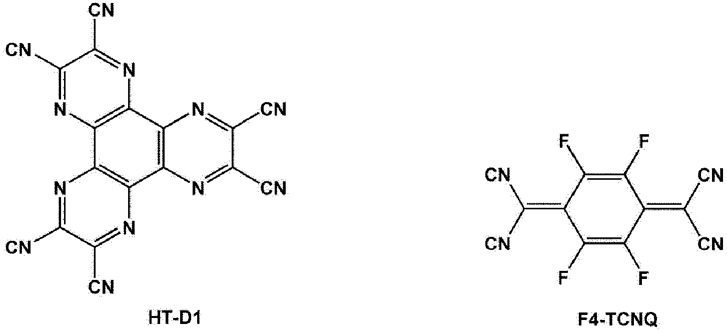

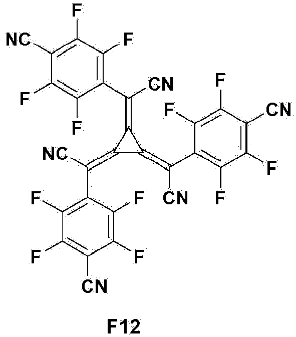

The hole transport region may include a buffer layer.

Without wishing to be bound to theory, the buffer layer may compensate for an optical resonance distance according to a wavelength of light emitted from the emission layer, and thus, the efficiency of a formed organic light-emitting device may be improved.

An emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

When the hole transport region includes an electron blocking layer, a material for the electron blocking layer may be a material for a hole transport region or a material for a host, as described herein. However, the material for the electron blocking layer is not limited thereto. For example, when the hole transport region includes an electron blocking layer, a material for the electron blocking layer may be mCP, as described herein in further detail.

The emission layer may include a host and a dopant, and the dopant may include at least one organometallic compound represented by Formula 1.

The host may include at least one of TPBi, TBADN, ADN (also referred to as "DNA"), CBP, CDBP, TCP, mCP, Compound H50, or Compound H51:

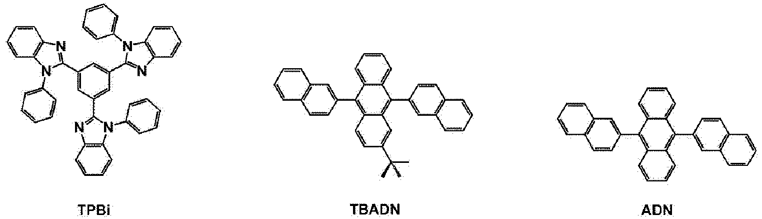

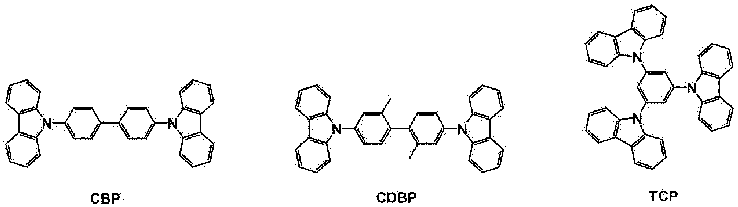

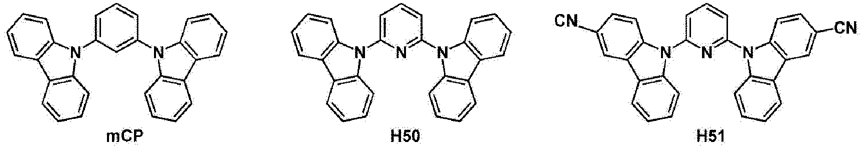

In one or more embodiments, the host may further include a compound represented by Formula 301:

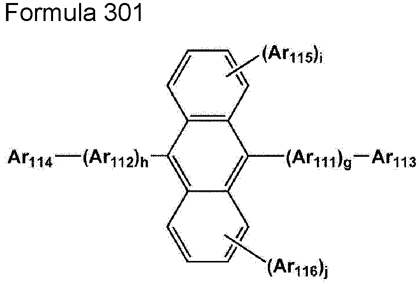

Ar₁₁₁ and Ar₁₁₂ in Formula 301 may each independently be:
a phenylene group, a naphthylene group, a phenanthrenylene group, or a pyrenylene group; or
a phenylene group, a naphthylene group, a phenanthrenylene group, or a pyrenylene group, each substituted with one or more of a phenyl group, a naphthyl group, or an anthracenyl group.

Ar₁₁₃ to Ar₁₁₆ in Formula 301 may each independently be:
a C₁-C₁₀ alkyl group, a phenyl group, a naphthyl group, a phenanthrenyl group, or a pyrenyl group; or
a phenyl group, a naphthyl group, a phenanthrenyl group, or a pyrenyl group, each substituted with one or more of a phenyl group, a naphthyl group, or an anthracenyl group.

g, h, i, and j in Formula 301 may each independently be an integer from 0 to 4, and may be, for example, 0, 1, or 2.

Ar₁₁₃ and Ar₁₁₆ in Formula 301 may each independently be:
a C₁-C₁₀ alkyl group that may be substituted with one or more of a phenyl group, a naphthyl group, or an anthracenyl group;
a phenyl group, a naphthyl group, an anthracenyl group, a pyrenyl group, a phenanthrenyl group, or a fluorenyl group;
a phenyl group, a naphthyl group, an anthracenyl group, a pyrenyl group, a phenanthrenyl group, or a fluorenyl group, each substituted with one or more of deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a phenyl group, a naphthyl group, an anthracenyl group, a pyrenyl group, a phenanthrenyl group, or a fluorenyl group; or

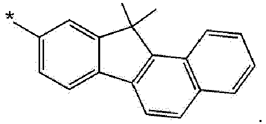

In one or more embodiments, the host may include a compound represented by Formula 302:

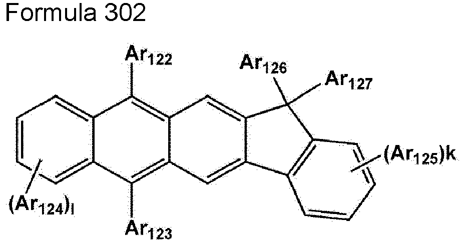

Ar₁₂₂ to Ar₁₂₅ in Formula 302 may be as described in further detail in connection with Ar₁₁₃ in Formula 301.

Ar₁₂₆ and Ar₁₂₇ in Formula 302 may each independently be a C₁-C₁₀ alkyl group (for example, a methyl group, an ethyl group, or a propyl group).

k and l in Formula 302 may each independently be an integer from 0 to 4. For example, k and I may be 0, 1, or 2.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light. Other various embodiments are possible.

When the emission layer includes a host and a dopant, an amount of the dopant may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

Then, an electron transport region may be located on the emission layer.

The electron transport region may include a hole blocking layer, an electron transport layer, an electron injection layer, or a combination thereof.

For example, the electron transport region may have a hole blocking layer/electron transport layer/electron injection layer structure or an electron transport layer/electron injection layer structure, and the structure of the electron transport region is not limited thereto. The electron transport layer may have a single-layered structure including a single material, or a multi-layered structure including two or more different materials.

Conditions for forming the hole blocking layer, the electron transport layer, and the electron injection layer, which constitute the electron transport region, may be understood by referring to the conditions described herein for forming the hole injection layer.

When the electron transport region includes a hole blocking layer, the hole blocking layer may include, for example, at least one of BCP, Bphen, or BAlq, but embodiments of the present disclosure are not limited thereto.

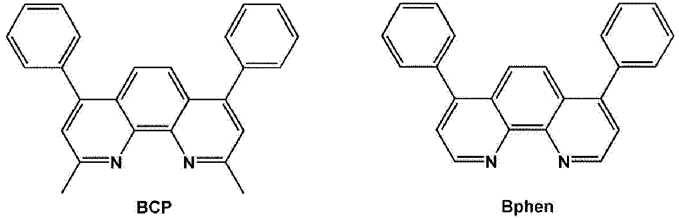

A thickness of the hole blocking layer may be in a range of about 20 Å to about 1,000 Å, for example, about 30 Å to about 300 Å. When the thickness of the hole blocking layer is within these ranges, excellent hole blocking characteristics may be obtained without a substantial increase in driving voltage.

The electron transport layer may include at least one of BCP, Bphen, Alq₃, BAlq, TAZ, or NTAZ.

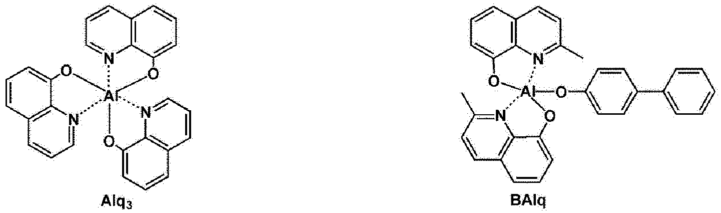

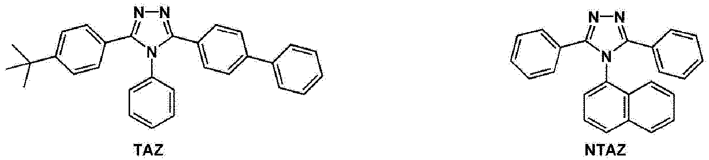

In one or more embodiments, the electron transport layer may include at least one of ET1 to ET25, but embodiments of the present description are not limited thereto:

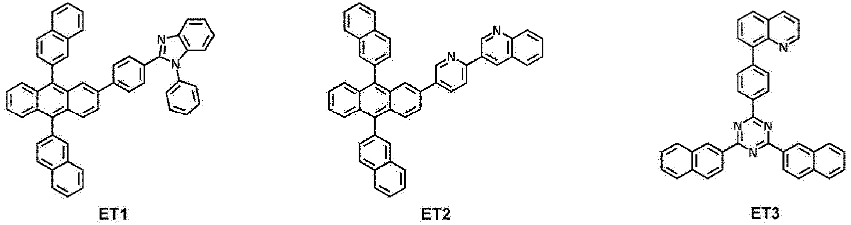

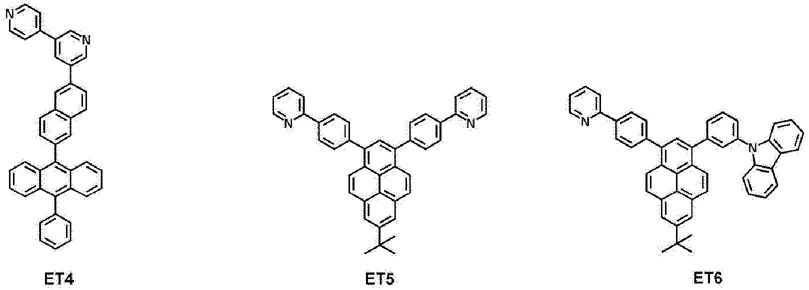

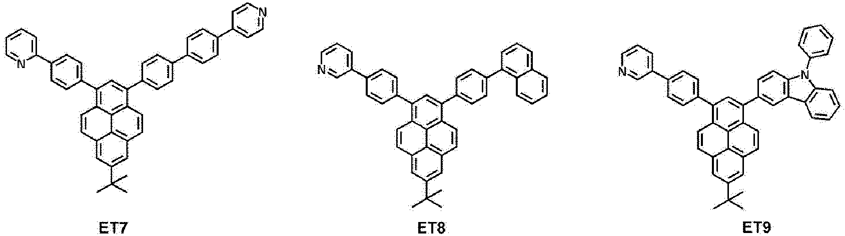

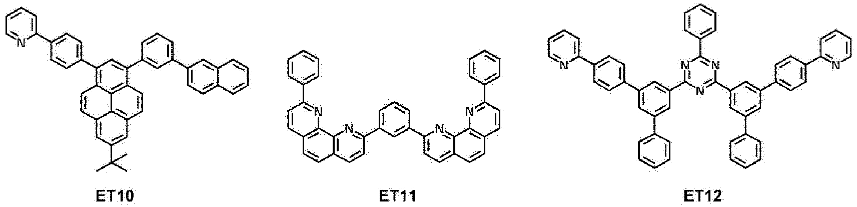

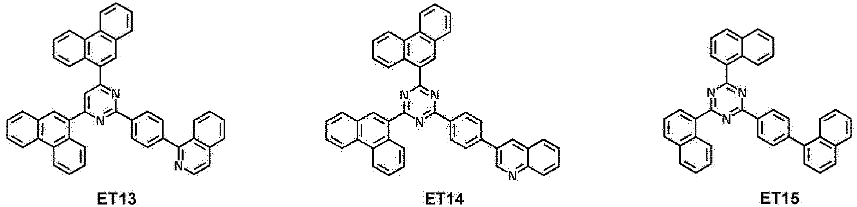

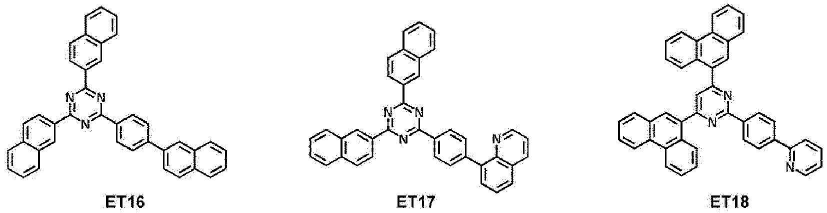

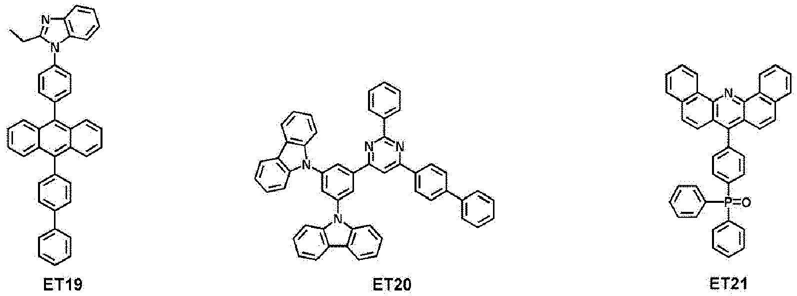

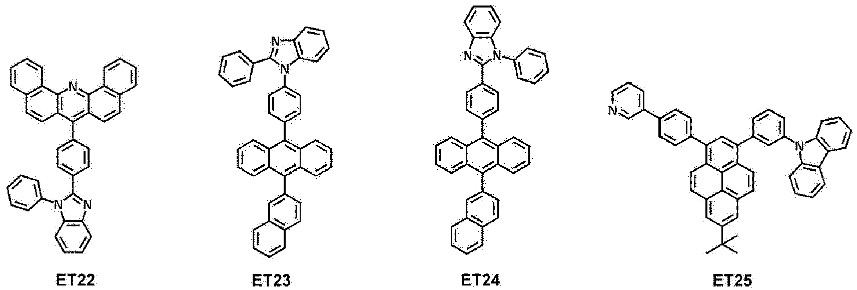

A thickness of the electron transport layer may be in the range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

The electron transport layer may include a material including a metal in addition to the material as described hereinabove.

The material including a metal may be a Li complex. The Li complex may include, for example, Compound ET-D1 (lithium quinolate, LiQ) or ET-D2:

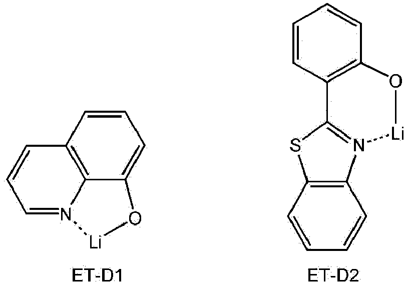

The electron transport region may include an electron injection layer that promotes the flow of electrons from the second electrode 19 thereinto.

The electron injection layer may include LiF, NaCl, CsF, Li₂O, BaO, or a combination thereof.

A thickness of the electron injection layer may be in a range of about 1 Å to about 100 Å, for example, about 3 Å to about 90 Å. When the thickness of the electron injection layer is within the range described above, the electron injection layer may have satisfactory electron injection characteristics without a substantial increase in driving voltage.

The second electrode 19 is located on the organic layer 15. The second electrode 19 may be a cathode. A material for forming the second electrode 19 may be a metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to the FIGURE, but embodiments of the present disclosure are not limited thereto.

Another aspect provides a diagnostic composition including at least one organometallic compound represented by Formula 1.

The organometallic compound represented by Formula 1 provides high luminescent efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "C₁-C₆₀ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an isoamyl group, and a hexyl group. The term "C₁-C₆₀ alkylene group" as used herein refers to a divalent group having the same structure as the C₁-C₆₀ alkyl group.

The term "C₁-C₆₀ alkoxy group" as used herein refers to a monovalent group represented by -OA₁₀₁ (wherein A₁₀₁ is the C₁-C₆₀ alkyl group), and examples thereof include a methoxy group, an ethoxy group, and an isopropyloxy group.

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent saturated monocyclic group having at least one heteroatom that is N, O, P, Si, or S as a ring-forming atom instead of at least one carbon atom, and 1 to 10 carbon atoms in the ring thereof, and non-limiting examples thereof include a tetrahydrofuranyl group and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₂-C₁₀ heterocycloalkenyl group" as used herein refers to a monovalent monocyclic group that has at least one heteroatom that is N, O, P, Si, or S as a ring-forming atom instead of at least one carbon, 2 to 10 carbon atoms, and at least one carbon-carbon double bond in its ring. Examples of the C₂-C₁₀ heterocycloalkenyl group are a 2,3-dihydrofuranyl group and a 2,3-dihydrothiophenyl group. The term "C₂-C₁₀ heterocycloalkenylene group" as used herein refers to a divalent group having the same structure as the C₂-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other. The term "C₇-C₆₀ alkyl aryl group" as used herein refers to a C₆-C₅₉ aryl group substituted with at least one C₁-C₅₄ alkyl group. The term "C₇-C₆₀ aryl alkyl group" as used herein refers to a C₁-C₅₄ alkyl group substituted with at least one C₆-C₅₉ aryl group.

The term "C₁-C₆₀ heteroaryl group" as used herein refers to a monovalent group having a cyclic aromatic system that has at least one heteroatom that is N, O, P, Si, or S as a ring-forming atom instead of at least one carbon atom, and 1 to 60 carbon atoms. The term "C₁-C₆₀ heteroarylene group" as used herein refers to a divalent group having a cyclic aromatic system that has at least one heteroatom that is N, O, P, Si, or S as a ring-forming atom instead of at least one carbon, and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other. The term "C₂-C₆₀ alkyl heteroaryl group" as used herein refers to a C₁-C₅₉ heteroaryl group substituted with at least one C₁-C₅₉ alkyl group. The term "C₂-C₆₀ heteroaryl alkyl group" as used herein refers to a C₁-C₅₉ alkyl group substituted with at least one C₁-C₅₉ heteroaryl group.

The term "C₆-C₆₀ aryloxy group" as used herein refers to -OA₁₀₂ (wherein A₁₀₂ is the C₆-C₆₀ aryl group), and the term "C₆-C₆₀ arylthio group" as used herein refers to -SA₁₀₃ (wherein A₁₀₃ is the C₆-C₆₀ aryl group).

The term "C₁-C₆₀ heteroaryloxy group" as used herein refers to -OA₁₀₄ (wherein A₁₀₄ is a C₁-C₆₀ heteroaryl group), and the term "C₁-C₆₀ heteroarylthio group" as used herein refers to -SA₁₀₅ (wherein A₁₀₅ is the C₁-C₆₀ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, at least one heteroatom that is N, O, P, Si, or S instead of at least one carbon atom, as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as a monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group.

The term "C₁-C₃₀ heterocyclic group" as used herein refers to a saturated or unsaturated cyclic group having, as a ring-forming atom, at least one heteroatom that is N, O, P, Si, or S instead of at least one carbon ring atom, and 1 to 30 carbon atoms. The C₁-C₃₀ heterocyclic group may be a monocyclic group or a polycyclic group.

The term "TMS" as used herein refers to -Si(CH₃)₃, and the term "TMG" as used herein refers to -Ge(CH₃)₃.

At least one substituent of the substituted C₅-C₃₀ carbocyclic group, the substituted C₁-C₃₀ heterocyclic group, the substituted C₁-C₆₀ alkyl group, the substituted C₂-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₂-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group,
a C₁-C₆₀ alkyl group, a C₂-C₆₀ alkenyl group, a C₂-C₆₀ alkynyl group, or a C₁-C₆₀ alkoxy group, each substituted with one or more of deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -N(Q₁₄)(Q₁₅), -B(Q₁₆)(Q₁₇), - P(Q₁₈)(Q₁₉), or -P(=O)(Q₁₈)(Q₁₉),
a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with one or more of deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), - Ge(Q₂₁)(Q₂₂)(Q₂₃), -N(Q₂₄)(Q₂₅), -B(Q₂₆)(Q₂₇), -P(Q₂₈)(Q₂₉), or - P(=O)(Q₂₈)(Q₂₉),
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), - P(Q₂₈)(Q₂₉), or -P(=O)(Q₃₈)(Q₃₉),
wherein Q₁ to Q₉, Q₁₁ to Q₁₉, Q₂₁ to Q₂₉, and Q₃₁ to Q₃₉ are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a C₁-C₆₀ heteroaryloxy group, a C₁-C₆₀ heteroarylthio group, a substituted or unsubstituted monovalent non-aromatic condensed polycyclic group, or a substituted or unsubstituted monovalent non-aromatic condensed heteropolycyclic group.

Hereinafter, a compound and an organic light-emitting device according to one or more embodiments are described in further detail with reference to Synthesis Example and Examples. However, the organic light-emitting device is not limited thereto. The wording "'B' was used instead of 'A'" used in describing Synthesis Examples means that an amount of 'A' used was identical to an amount of 'B' used, in terms of a molar equivalent.

### EXAMPLES

### Synthesis Example 1: Synthesis of Compound 1

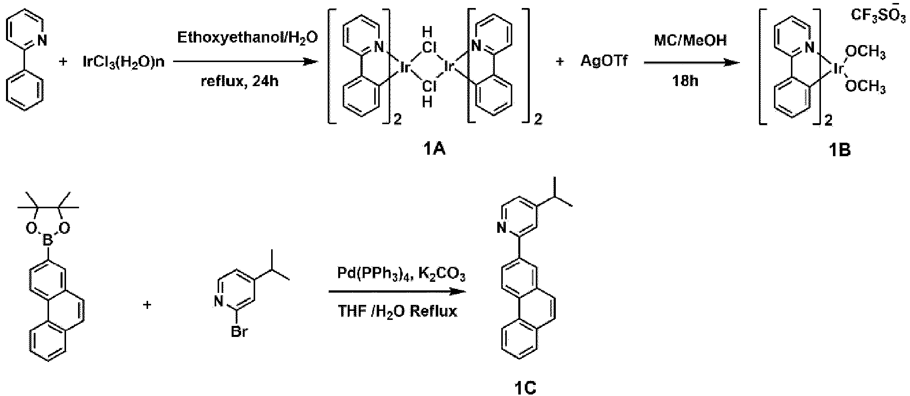

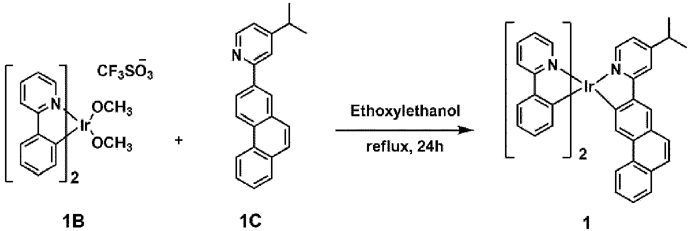

### (1) Synthesis of Compound 1A

In a reaction vessel, 2-phenylpyridine (5.2 grams (g), 33.2 millimoles (mmol)) and iridium chloride hydrate (5.2 g, 14.7 mmol) were mixed with 120 milliliters (mL) of ethoxyethanol and 40 mL of deionized (DI) water, and the resultant mixture was stirred a reflux for 24 hours, and then, the temperature was allowed to cool to room temperature. The resulting solid was separated by filtration, washed sufficiently with water, methanol, and hexane, in this stated order, and then dried in a vacuum oven to obtain 8.2 g (yield of 92%) of Compound 1A.

### (2) Synthesis of Compound 1B

In a reaction vessel, Compound 1A (1.6 g, 1.5 mmol) and 45 mL of methylene chloride (MC) were mixed, and then, silver trifluoromethanesulfonate (silver triflate, AgOTf) (0.8 g, 3.1 mmol) was added thereto after being mixed with 15 mL of methanol (MeOH). Thereafter, the mixture was stirred for 18 hours at room temperature while light was excluded from the interior of the reaction vessel with aluminum foil, and then the mixture was filtered through a diatomaceous earth plug to remove the resulting solid, and the filtrate was subjected to reduced pressure to obtain a solid (Compound 1B). Compound 1B was used in the next reaction without an additional purification process.

### (3) Synthesis of Compound 1C

In a reaction vessel under a nitrogen environment, 4,4,5,5-tetramethyl-2-(phenanthrene-2-yl)-1,3,2-dioxaborolane (3.7 g, 12.0 mmol) and 2-bromo-4-isopropyl-pyridine (2.0 g, 10.0 mmol) were dissolved in 140 mL of tetrahydrofuran (THF). Then, potassium carbonate (K₂CO₃) (3.2 g, 29.9 mmol) was dissolved in 25 mL of DI water, and then, the resultant solution was added to the tetrahydrofuran solution to form a reaction mixture, and a palladium catalyst (Pd(PPh₃)₄) (1.2 g, 1.2 mmol) was added thereto. Then, the reaction mixture was stirred at reflux at 100 °C for a period of time. After being allowed to cool to room temperature, a product was obtained by extraction and separated by filtration and the obtained solid was subjected to column chromatography (eluent: methylene chloride (MC) and hexane) to obtain 2.8 g (yield of 94%) of Compound 1C (4-isopropyl-2-(phenanthrene-2-yl)pyridine). The obtained compound was identified by high resolution mass spectrometry (HRMS, using matrix assisted laser desorption ionization, MALDI) and HPLC analysis.
HRMS (MALDI) calcd for C₂₂H₁₉N: m/z: 297.40 Found: 298.15

### (4) Synthesis of Compound 1

In a reaction vessel, Compound 1B (1.5 g, 2.1 mmol) and Compound 1C (4-isopropyl-2-(phenanthrene-2-yl)pyridine) (0.7 g, 2.3 mmol) were mixed with 100 mL of 2-ethoxyethanol, the resultant mixture was stirred at reflux for 24 hours, and then, the temperature was allowed to cool to room temperature. The obtained mixture was subjected to a reduced pressure, and the obtained solid was then subjected to column chromatography (eluent: methylene chloride (MC) and hexane) to obtain 0.75 g (yield of 45%) of Compound 1. The obtained compound was identified by HRMS and HPLC analysis.
HRMS (MALDI) calcd for C₄₄H₃₄IrN₃: m/z: 796.99 Found: 798.24

### Synthesis Example 2: Synthesis of Compound 2

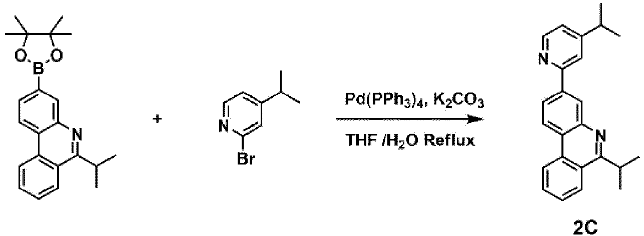

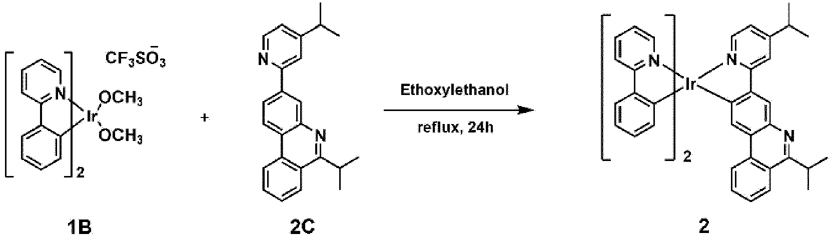

### (1) Synthesis of Compound 2C

2.7 g (yield of 79%) of Compound 2C (6-isopropyl-3-(4-isopropyl-pyridin-2-yl) phenanthridine) was obtained using a method similar to the method of synthesizing Compound 1C in Synthesis Example 1, except that, when synthesizing Compound 1C, 6-isopropyl-3-(4,4,5,5-tetramethyl-1,3,2-dioxoborolan-2-yl)phenanthridine (4.2 g, 12.0 mmol) was used instead of 4,4,5,5-tetramethyl-2-(phenanthrene-2-yl)-1,3,2-dioxaborolane. The obtained compound was identified by HRMS and HPLC analysis. HRMS (MALDI) calcd for C₂₄H₂₄N₂: m/z: 340.47 Found: 341.19

### (2) Synthesis of Compound 2

0.68 g (yield of 38%) of Compound 2 was obtained using a method similar to the method of synthesizing Compound 1 in Synthesis Example 1, except that Compound 2C (0.8 g, 2.3 mmol) was used instead of Compound 1C. The obtained compound was identified by HRMS and HPLC analysis.
HRMS (MADI) calcd for C₄₆H₃₉IrN₄: m/z: 840.06 Found: 841.28

### Synthesis Example 3: Synthesis of Compound 3

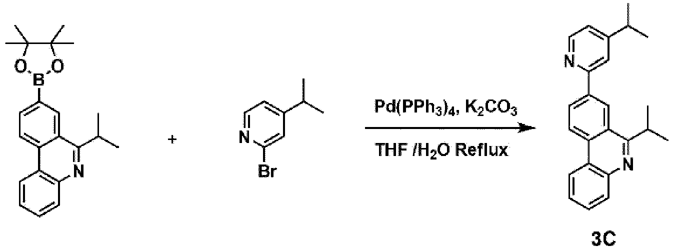

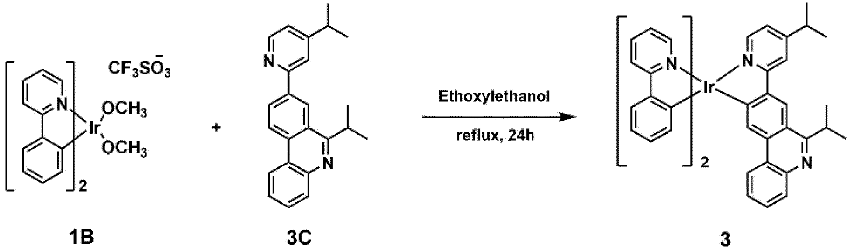

### (1) Synthesis of Compound 3C

2.9 g (yield of 85%) of Compound 3C (6-isopropyl-8-(4-isopropylpyridin-2-yl)phenanthridine) was obtained using a method similar to the method of synthesizing Compound 1C in Synthesis Example 1, except that, when synthesizing Compound 1C, 6-isopropyl-8-(4,4,5,5-tetramethyl-1,3,2-dioxoborolan-2-yl)phenanthridine (4.2 g, 12.0 mmol) was used instead of 4,4,5,5-tetramethyl-2-(phenanthrene-2-yl)-1,3,2-dioxaborolane. The obtained compound was identified by HRMS and HPLC analysis.
HRMS (MALDI) calcd for C₂₄H₂₄N₂: m/z: 340.47 Found: 341.62

### (2) Synthesis of Compound 3

0.80 g (yield of 45%) of Compound 2 was obtained using a method similar to the method of synthesizing Compound 1 in Synthesis Example 1, except that Compound 3C (0.8 g, 2.3 mmol) was used instead of Compound 1C. The obtained compound was identified by HRMS and HPLC analysis.
HRMS (MADI) calcd for C₄₆H₃₉IrN₄: m/z: 840.06 Found: 841.65

### Synthesis Example 4: Synthesis of Compound 4

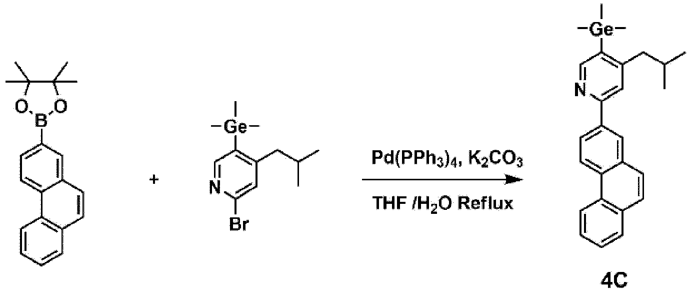

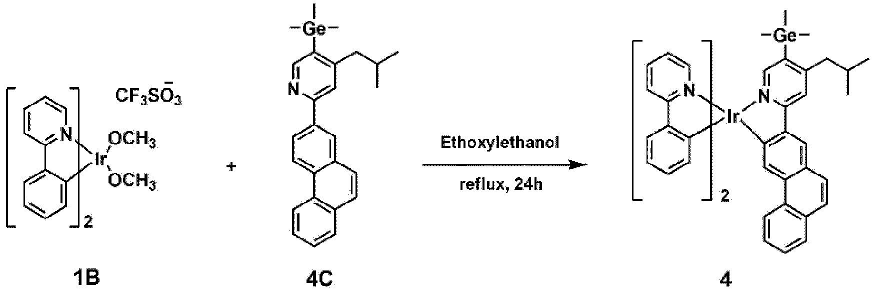

### (1) Synthesis of Compound 4C

2.2 g (yield of 85%) of Compound 4C (4-isobutyl-2-(phenanthrene-2-yl)-5-(trimethylgermyl)pyridine) was obtained using a method similar to the method of synthesizing Compound 1C in Synthesis Example 1, except that, when synthesizing Compound 1C, 2-bromo-4-isobutyl-5-(trimethylgermyl)pyridine (2.0 g, 6.0 mmol) was used instead of 2-bromo-4-isopropyl-pyridine. The obtained compound was identified by HRMS and HPLC analysis.
HRMS (MALDI) calcd for C₂₆H₂₉GeN: m/z: 428.16 Found: 430.11

### (2) Synthesis of Compound 4

0.72 g (yield of 37%) of Compound 4 was obtained using a method similar to the method of synthesizing Compound 1 in Synthesis Example 1, except that Compound 4C (4-isobutyl-2-(phenanthrene-2-yl)-5-(trimethylgermyl)pyridine) (1.0 g, 2.3 mmol) was used instead of Compound 1C. The obtained compound was identified by HRMS and HPLC analysis.
HRMS (MALDI) calcd for C₄₈H₄₄GeIrN₃: m/z: 927.75 Found: 929.30

### Example 1

As an anode, an ITO-patterned glass substrate was cut to a size of 50 mm x 50 mm x 0.5 mm, sonicated with isopropyl alcohol and DI water, each for 5 minutes, and then cleaned by exposure to ultraviolet rays and ozone for 30 minutes. The resultant glass substrate was loaded onto a vacuum deposition apparatus.

Compounds HT3 and F12(p-dopant) were co-deposited by vacuum on the anode at a weight ratio of 98:2 to form a hole injection layer having a thickness of 100 Å, and Compound HT3 was vacuum-deposited on the hole injection layer to form a hole transport layer having a thickness of 1,650 Å.

Then, GH3 (host) and Compound 1 (dopant) were co-deposited at a weight ratio of 92:8 on the hole transport layer to form an emission layer having a thickness of 400 Å.

Then, Compound ET3 and LiQ (n-dopant) were co-deposited on the emission layer at a volume ratio of 50:50 to form an electron transport layer having a thickness of 350 Å, LiQ was vacuum-deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device.

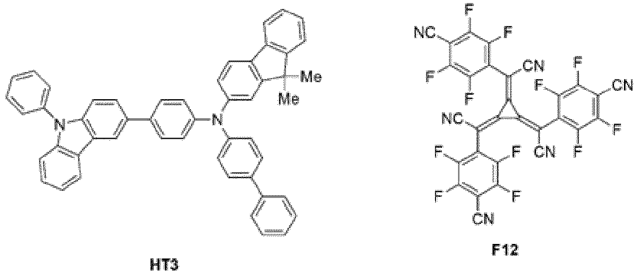

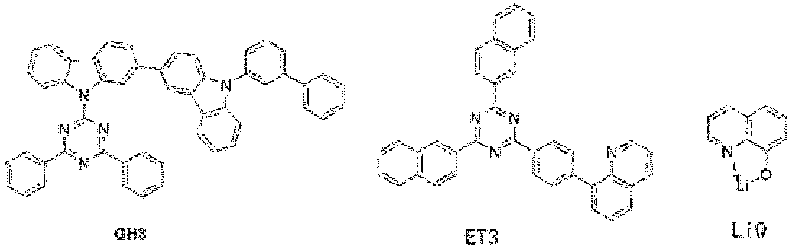

### Examples 2 to 4 and Comparative Examples 1 to 3

Organic light-emitting devices were manufactured in a manner similar to the method of manufacturing in Example 1, except that Compounds shown in Table 2 were each used instead of Compound 1 as a dopant in forming an emission layer.

The driving voltage (volts, V), external quantum efficiency (EQE, %), maximum emission wavelength (λₘₐₓ, nm), and FWHM (nm) of each of the organic light-emitting devices manufactured according to Examples 1 to 4 and Comparative Examples 1 to 3 were evaluated. Results thereof are shown in Table 2. A current-voltage meter (Keithley 2400) and a luminance meter (Minolta Cs-1000A) were used to obtain the data.

**Table 2**

| | Dopant in emission layer | Driving voltage (V) | External quantum efficiency (%) | Maximum emission wavelength (nm) | FWHM (nm) |
|---|---|---|---|---|---|
| Example 1 | Compound 1 | 4.2 | 21.5 | 524 | 78 |
| Example 2 | Compound 2 | 4.2 | 21.5 | 525 | 78 |
| Example 3 | Compound 3 | 4.2 | 20.5 | 515 | 76 |
| Example 4 | Compound 4 | 4.1 | 21.5 | 526 | 78 |
| Comparative Example 1 | Compound A | 4.3 | 21.0 | 529 | 80 |
| Comparative Example 2 | Compound B | 4.5 | 20.0 | 519 | 79 |
| Comparative Example 3 | Compound C | 4.3 | 21.0 | 538 | 82 |

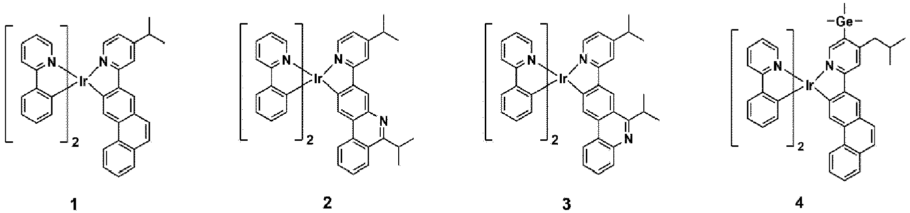

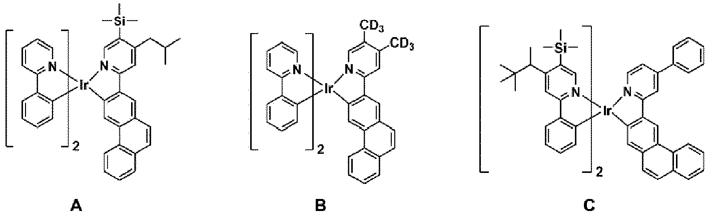

Referring to Table 2, it has been shown that the organic light-emitting devices of Examples 1 to 4 have low driving voltage, narrow FWHM, and excellent characteristics in terms of external quantum efficiency. In addition, it can be seen that the organic light-emitting devices of Examples 1 to 4 have a lower driving voltage, a similar level of or narrower FWHM, and a similar level of or higher external quantum efficiency than the organic light-emitting devices of Comparative Examples 1 to 3.

The organometallic compounds have excellent electrical characteristics and thermal stability. The organometallic compounds have a high glass transition temperature so that crystallization thereof may be limited and electric mobility thereof may be improved. Accordingly, an electronic device using the organometallic compounds described herein, for example, an organic light-emitting device using the organometallic compounds described herein, has a low driving voltage, high efficiency, a long lifespan, reduced roll-off ratio, and a relatively narrow EL spectrum emission peak FWHM.

Thus, due to the use of the organometallic compounds as described herein, a high-quality organic light-emitting device may be provided. Such organometallic compounds as described herein have excellent phosphorescent luminescent characteristics, and thus, when used for a diagnostic composition, a diagnostic composition having a high diagnostic efficiency may be provided.

## Claims

1. An organometallic compound represented by Formula 1:
Formula 1 M₁(Ln₁)ₙ₁(Ln₂)ₙ₂
wherein, in Formula 1,
M₁ is iridium (Ir), platinum (Pt), osmium (Os), or rhodium (Rh),
Ln₁ is a ligand represented by Formula 1A,
Ln₂ is a ligand represented by Formula 1B,
n1 is 0, 1, or 2, and
n2 is 1, 2, or 3, 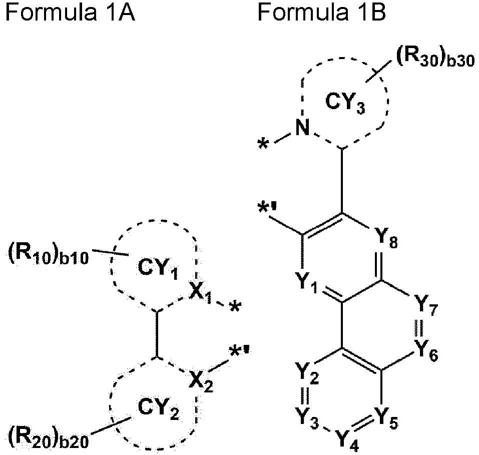 wherein, in Formulae 1A and 1B,
X₁ is C or N, and X₂ is C or N,
Y₁ is C(R₄₁) or N, Y₂ is C(R₄₂) or N, Y₃ is C(R₄₃) or N, Y₄ is C(R₄₄) or N, Y₅ is C(R₄₅) or N, Y₆ is C(R₄₆) or N, Y₇ is C(R₄₇) or N, Y₈ is C(R₄₈) or N,
CY₁ and CY₂ are each independently a C₅-C₃₀ carbocyclic group or a C₁-C₃₀ heterocyclic group,
CY₃ is a C₁-C₃₀ heterocyclic group comprising nitrogen,
R₁₀, R₂₀, and R₄₁ to R₄₈ are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), - Ge(Q₁)(Q₂)(Q₃), -N(Q₄)(Q₅), -B(Q₆)(Q₇), -P(Q₈)(Q₉), or -P(=O)(Q₈)(Q₉),
R₃₀ is hydrogen, a C₂-C₆₀ alkyl group, a C₂-C₆₀ alkyl group substituted with deuterium, or -Ge(Q₁)(Q₂)(Q₃),
two or more of a plurality of R₁₀(s) are optionally linked to each other to form a substituted or unsubstituted C₅-C₃₀ carbocyclic group or a substituted or unsubstituted C₁-C₃₀ heterocyclic group,
two or more of a plurality of R₂₀(s) are optionally linked to each other to form a substituted or unsubstituted C₅-C₃₀ carbocyclic group or a substituted or unsubstituted C₁-C₃₀ heterocyclic group,
two or more of a plurality of R₃₀(s) are optionally linked to each other to form a substituted or unsubstituted C₅-C₃₀ carbocyclic group or a substituted or unsubstituted C₁-C₃₀ heterocyclic group,
two or more neighboring substituents of R₁₀, R₂₀, and R₃₀ are optionally linked to each other to form a substituted or unsubstituted C₅-C₃₀ carbocyclic group or a substituted or unsubstituted C₁-C₃₀ heterocyclic group,
b10, b20, and b30 are each independently 1, 2, 3, 4, 5, 6, 7, 8, 9, or 10,
at least one substituent of the substituted C₅-C₃₀ carbocyclic group, the substituted C₁-C₃₀ heterocyclic group, the substituted C₁-C₆₀ alkyl group, the substituted C₂-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₂-C₁₀ heterocycloalkenyl group, the substituted C₆-C₆₀ aryl group, the substituted C₇-C₆₀ alkyl aryl group, the substituted C₈-C₆₀ aryl alkyl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₃-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with one or more of deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), - N(Q₁₄)(Q₁₅), -B(Q₁₆)(Q₁₇), -P(Q₈)(Q₉), or -P(=O)(Q₁₈)(Q₁₉),
a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each substituted with one or more of deuterium, -F, -Cl, -Br, - **I,** -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -Ge(Q₂₁)(Q₂₂)(Q₂₃), -N(Q₂₄)(Q₂₅), -B(Q₂₆)(Q₂₇), -P(Q₂₈)(Q₂₉), or -P(=O)(Q₂₈)(Q₂₉), or
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), -P(Q₃₈)(Q₃₉), or -P(=O)(Q₃₈)(Q₃₉),
wherein Q₁ to Q₉, Q₁₁ to Q₁₉, Q₂₁ to Q₂₉, and Q₃₁ to Q₃₉ are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group, and
wherein * and *' each indicate a binding site to M₁.

2. The organometallic compound of claim 1, wherein
M₁ is Ir, and
the sum of n1 and n2 is 3.

3. The organometallic compound of claims 1 or 2, wherein
CY₁ and CY₂ are each independently:
a cyclopentane group, a cyclohexane group, a cycloheptane group, a cyclopentene group, a cyclohexene group, a cycloheptene group, a phenyl group, a naphthalene group, a 1,2,3,4-tetrahydronaphthalene group, a anthracene group, a phenanthrene group, a triphenylene group, a pyrene group, a chrysene group, a cyclopentadiene group, a thiophene group, a furan group, a indole group, a benzoborole group, a benzophosphole group, a indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, a azaindole group, a azabenzoborole group, a azabenzophosphole group, a azaindene group, a azabenzosilole group, a azabenzogermole group, a azabenzothiophene group, a azabenzoselenophene group, a azabenzofuran group, a azacarbazole group, a azadibenzoborole group, a azadibenzophosphole group, a azafluorene group, a azadibenzosilole group, a azadibenzogermole group, a azadibenzothiophene group, a azadibenzoselenophene group, a azadibenzofuran group, a azadibenzothiophene 5-oxide group, a aza-9H-fluoren-9-one group, a azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, a imidazole group, a triazole group, a oxazole group, a isoxazole group, a thiazole group, a isothiazole group, a oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group; or
a group represented by Formula 8-1 or 8-2: 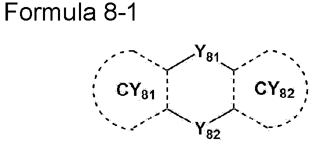 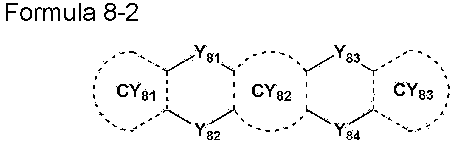 wherein, in Formulae 8-1 and 8-2,
Y₈₁ to Y₈₄ are each independently a single bond, O, S, N(R₈₁), C(R₈₁)(R₈₂), Si(R₈₁)(R₈₂), C(=O), S(=O), S(=O)₂, B(R₈₁), P(R₈₁), or P(=O)(R₈₁),
CY₈₁ to CY₈₃ are each independently a phenyl group, a naphthalene group, a 1,2,3,4-tetrahydronaphthalene group, a phenanthrene group, a pyridine group, a pyrimidine group, a pyrazine group, a triazine group, a quinoline group, an isoquinoline group, a quinoxaline group, a quinazoline group, a phenanthroline group, a benzofuran group, a benzothiophene group, a fluorene group, a carbazole group, a dibenzofuran group, a dibenzothiophene group, a dibenzosilole group, a azafluorene group, a azacarbazole group, a azadibenzofuran group, a azadibenzothiophene group, or a azadibenzosilole group, and
R₈₁ and R₈₂ are each independently as described in connection with R₁₀ and R₂₀ in claim 1; and/or
wherein
CY₃ is a pyridine group, a pyrimidine group, a pyrazine group, a triazine group, a quinoline group, an isoquinoline group, a quinoxaline group, or a quinazoline group.

4. The organometallic compound of any of claims 1-3, wherein
R₁₀, R₂₀, and R₄₁ to R₄₈ are each independently: hydrogen, deuterium, -F, -Cl, -Br, -I, -CD₃, -CD₂H, -CDH₂, -CF₃, -CF₂H, -CFH₂, -SF₅, a C₁-C₆₀ alkyl group, a C₂-C₆₀ alkenyl group, a C₂-C₆₀ alkynyl group, a C₁-C₆₀ alkoxy group, -Si(Q₁)(Q₂)(Q₃), or - Ge(Q₁)(Q₂)(Q₃); or
a group represented by one of Formulae 9-1 to 9-61, 9-201 to 9-237, 10-1 to 10-141, or 10-201 to 10-350: 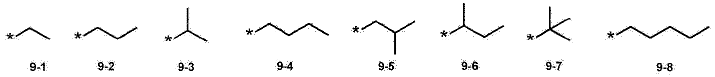 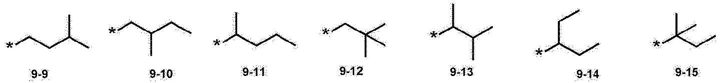 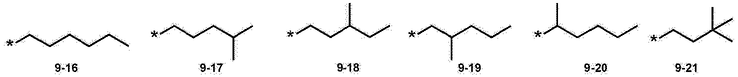 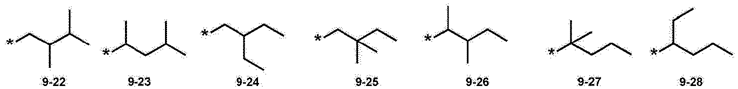 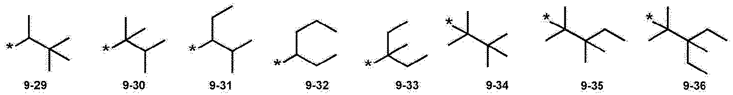 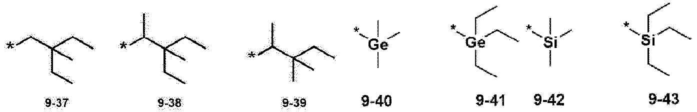 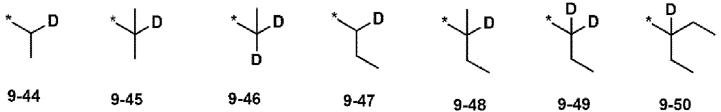 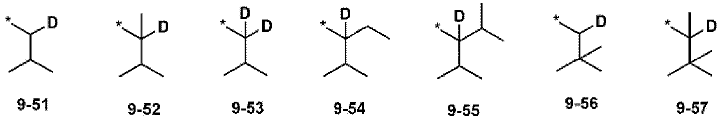 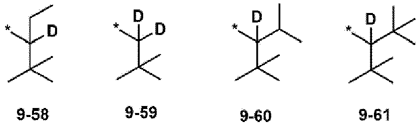 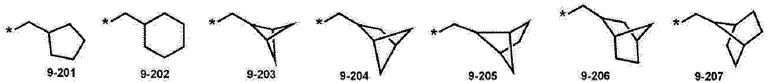 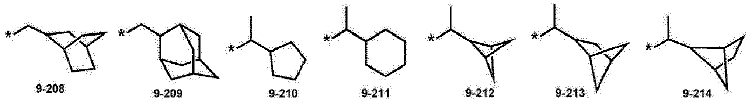 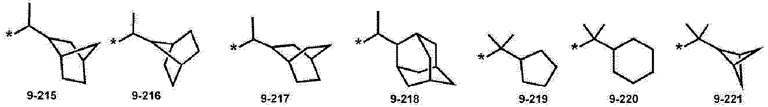 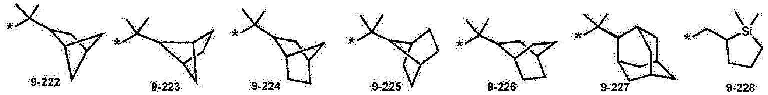 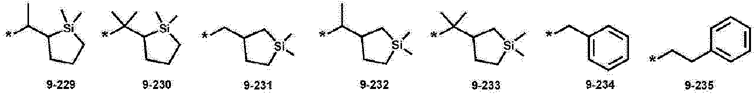 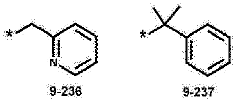 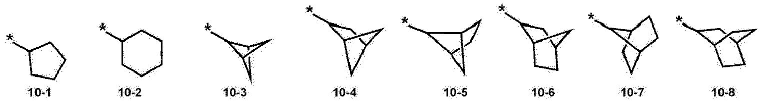 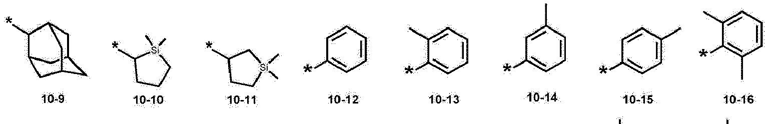 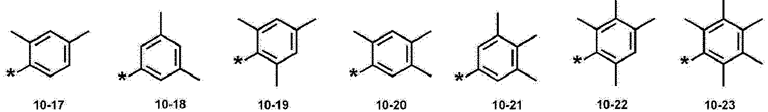 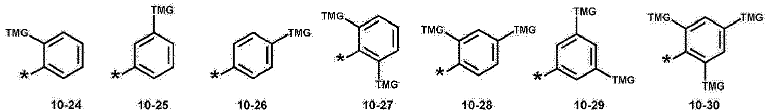 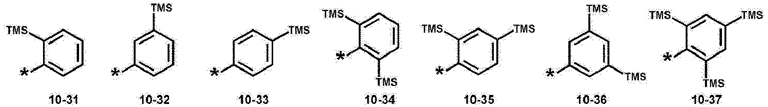 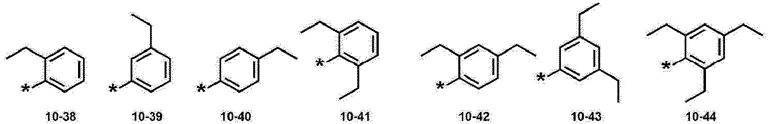 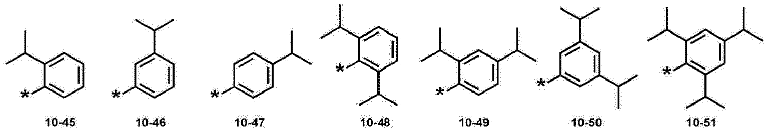 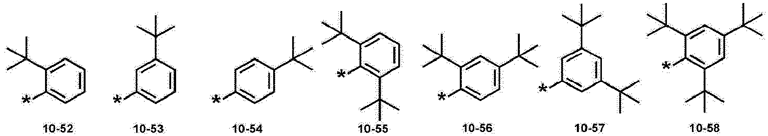 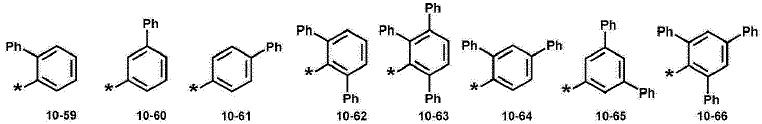 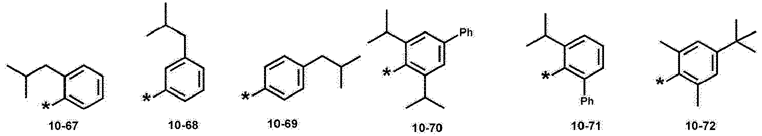 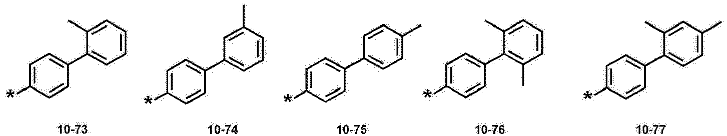 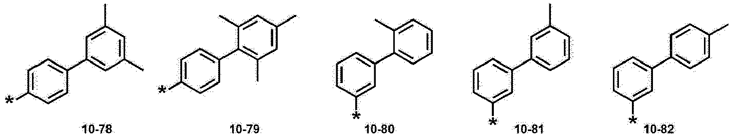 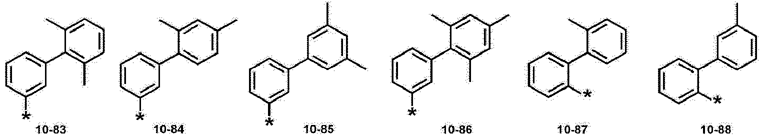 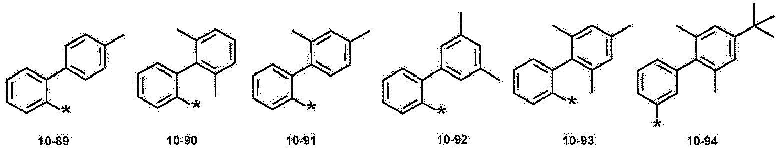 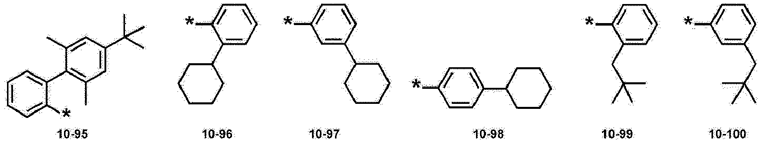 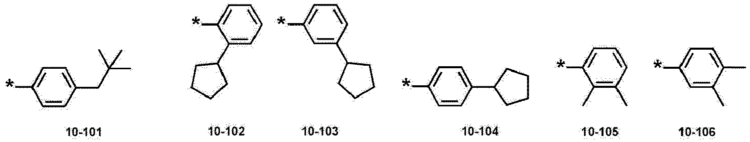 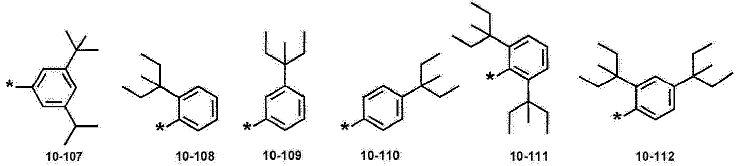 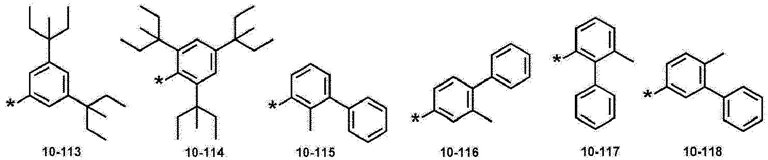 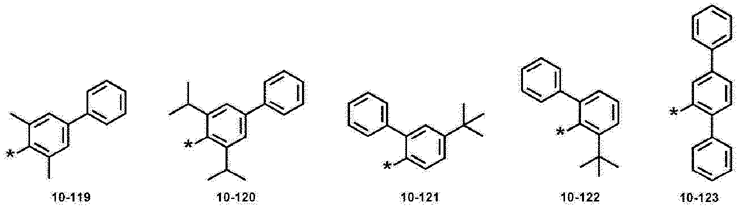 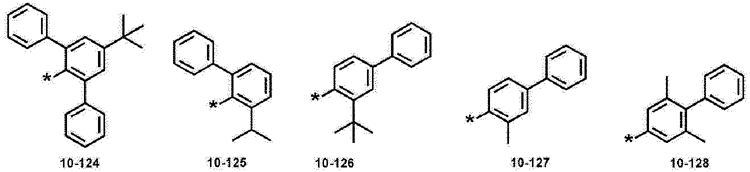 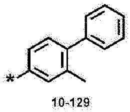 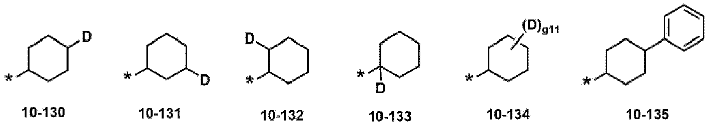 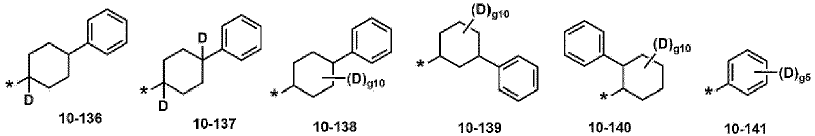 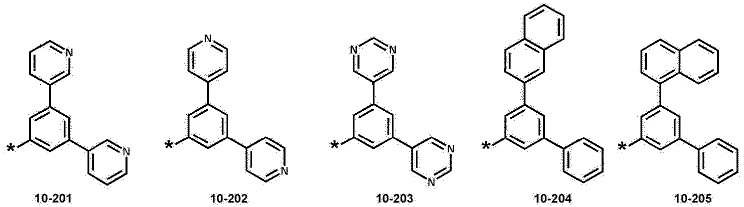 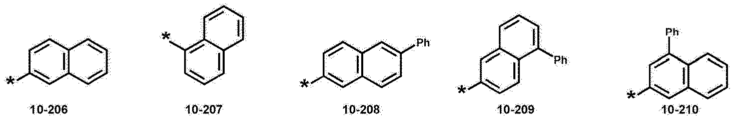 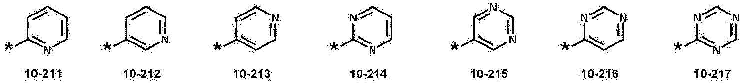 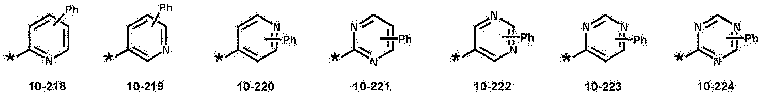 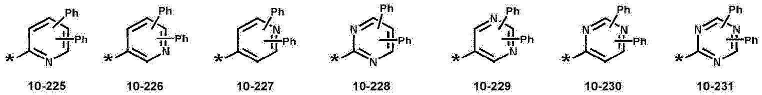 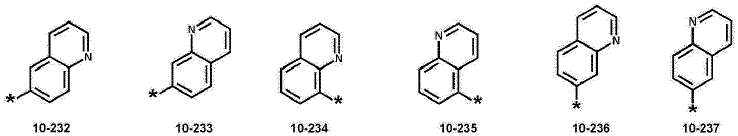 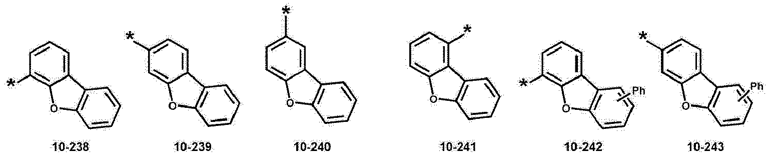 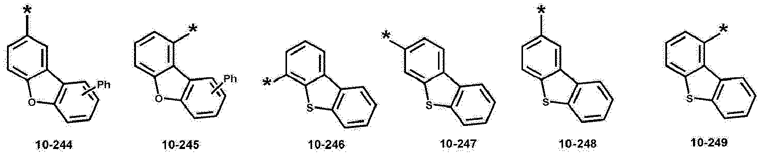 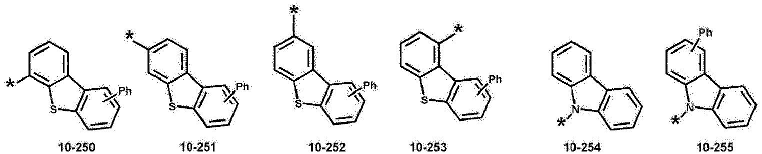 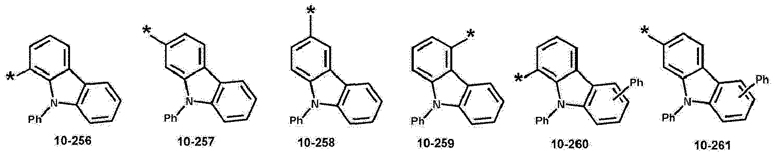 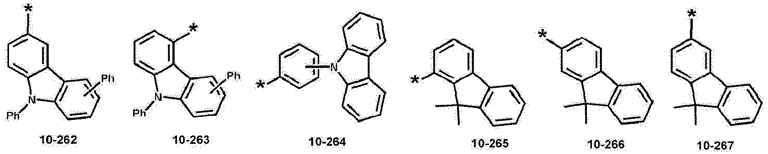 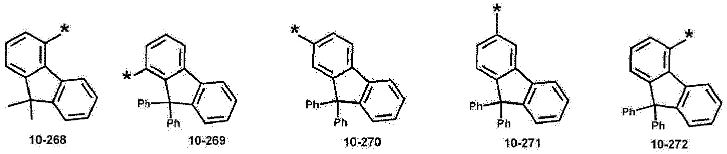 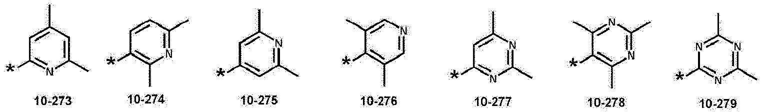 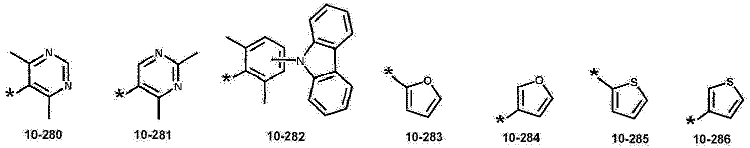 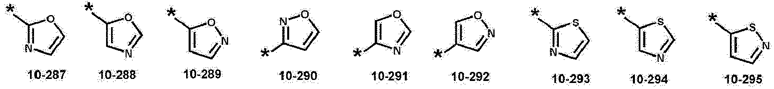 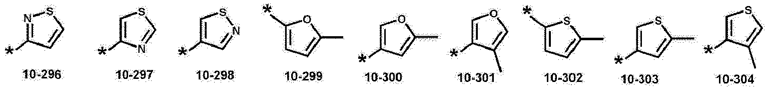 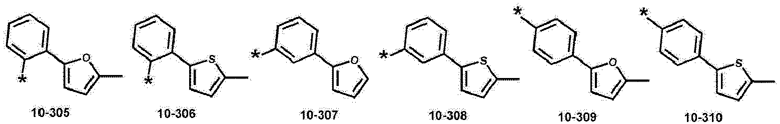 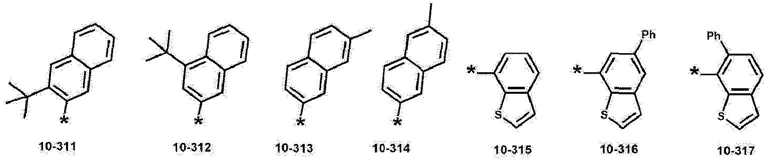 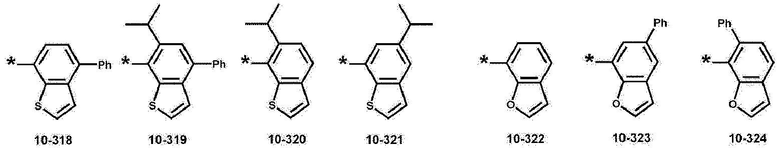 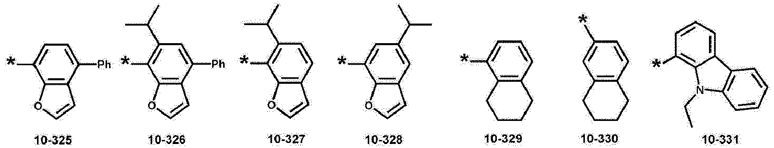 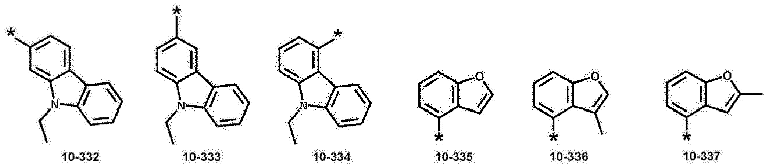 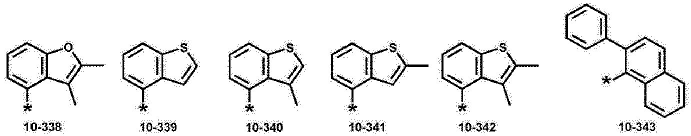 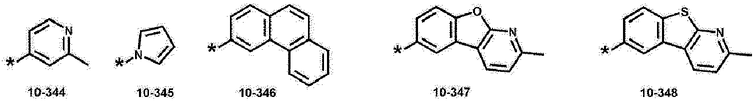 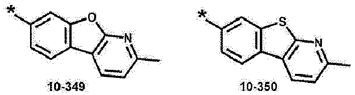 wherein, in Formulae 9-1 to 9-61, 9-201 to 9-237, 10-1 to 10-141, or 10-201 to 10-350,
* indicates a binding site to a neighboring atom,
Ph is a phenyl group,
TMS is a trimethylsilyl group,
TMG is a trimethylgermyl group,
g5 is an integer from 1 to 5,
g10 is an integer from 1 to 10, and
g11 is an integer from 1 to 11.

5. The organometallic compound of any of claims 1-4, wherein R₃₀ is a group represented by one of Formulae 9-1 to 9-61: 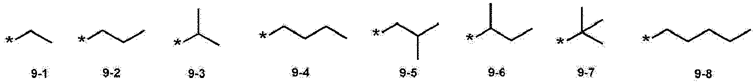 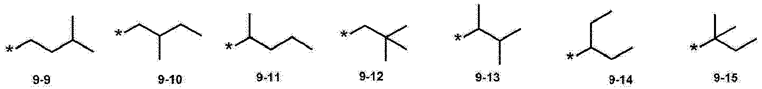 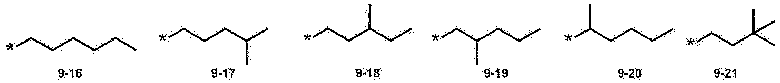 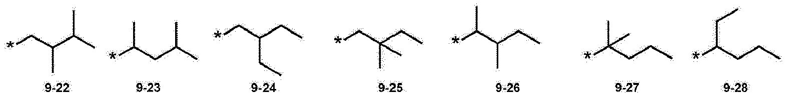 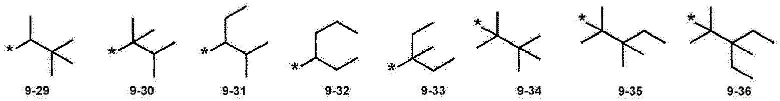 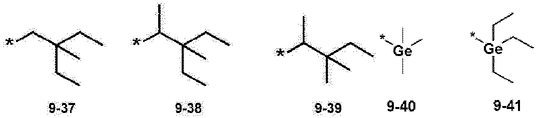 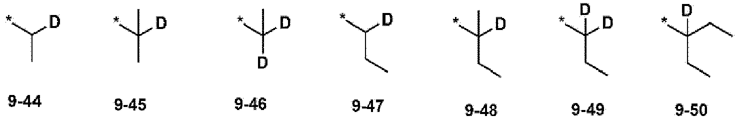 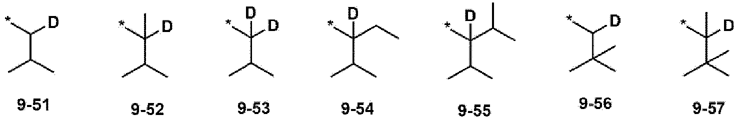 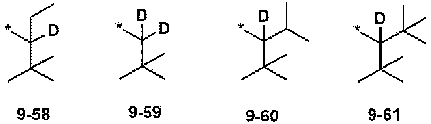 wherein, in Formulae 9-1 to 9-61,
* indicates a binding site to a neighboring atom.

6. The organometallic compound of any of claims 1-5, wherein CY₁ is represented by one of Formulae 1-1 to 1-16: 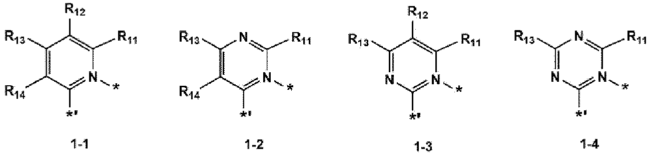 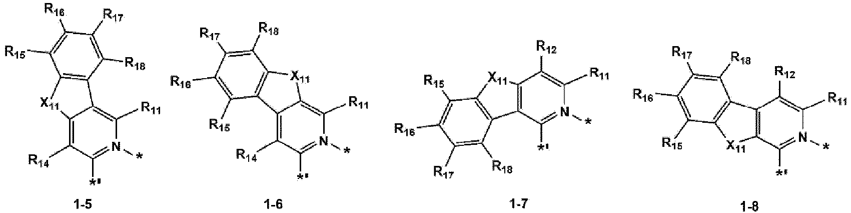 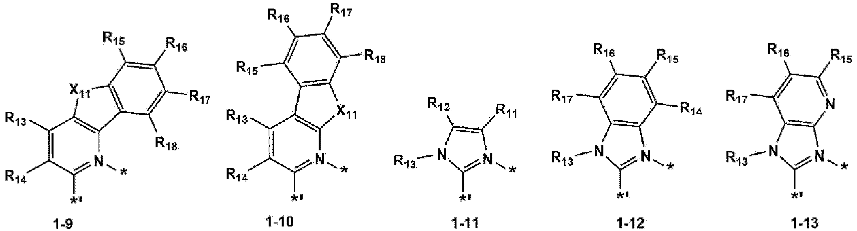 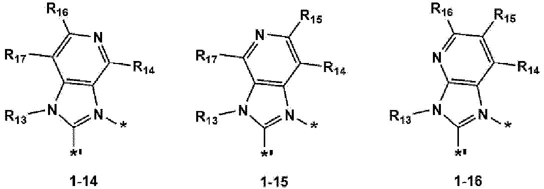 wherein, in Formulae 1-1 to 1-16,
X₁₁ is O, S, N(R₁₉ₐ), C(R₁₉ₐ)(R_{19b}), or Si(R₁₉ₐ)(R_{19b}),
R₁₁ to R₁₈, R₁₉ₐ, and R_{19b} are each independently as described in connection with R₁₀ in claim 1,
two or more neighboring substituents of R₁₁ to R₁₈, R₁₉ₐ, or R_{19b} are optionally linked to each other to form a substituted or unsubstituted C₅-C₃₀ carbocyclic group or a substituted or unsubstituted C₁-C₃₀ heterocyclic group, and
wherein, when R₁₁ to R₁₈, R₁₉ₐ, or R_{19b} is -Si(Q₁)(Q₂)(Q₃) or -Ge(Q₁)(Q₂)(Q₃), Q₁ to Q₃ are each independently:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂,
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with one or more of deuterium, a C₁-C₁₀ alkyl group, or a phenyl group,
* indicates a binding site to M₁, and
*' indicates a binding site to CY₂; and/or
wherein
CY₂ is represented by one of Formulae 2-1 to 2-22: 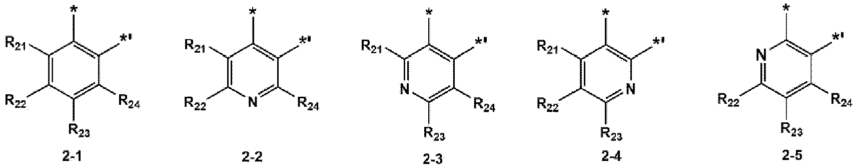 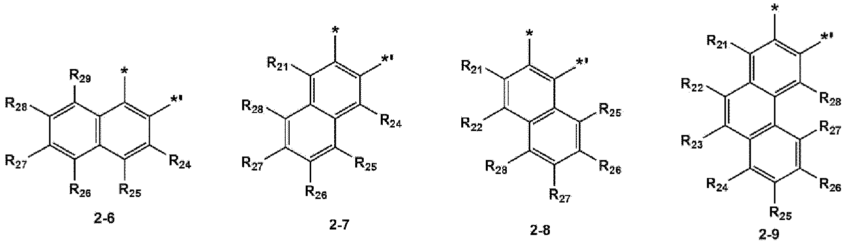 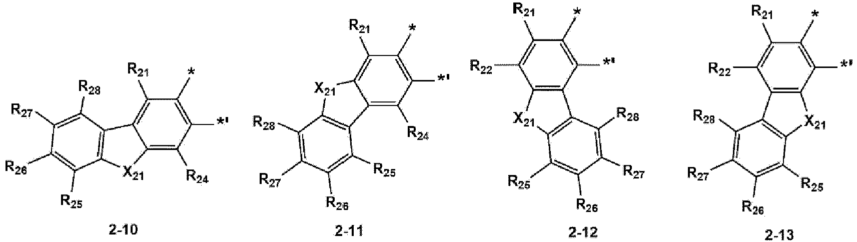 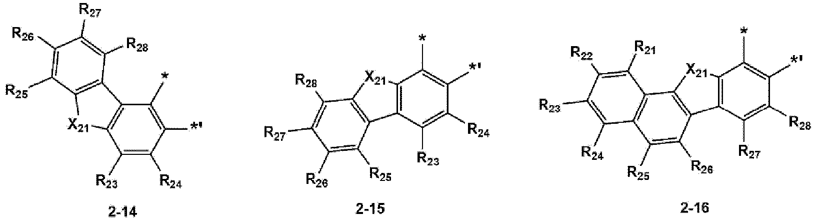 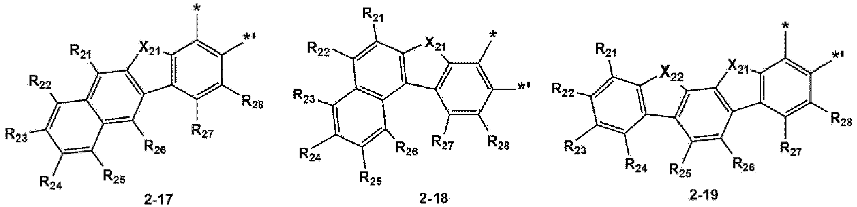 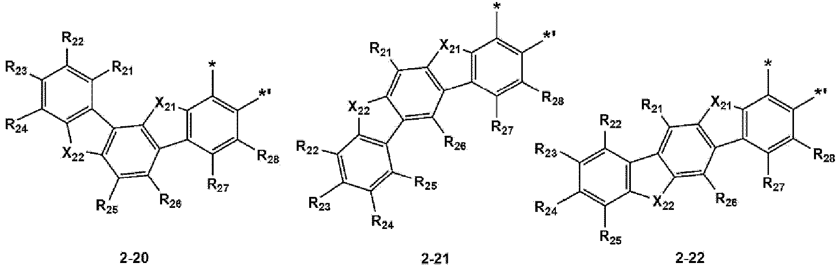 wherein, in Formulae 2-1 to 2-22,
X₂₁ and X₂₂ are each independently O, S, N(R₂₉ₐ), C(R₂₉ₐ)(R_{29b}), or Si(R₂₉ₐ)(R_{29b}),
R₂₁ to R₂₈, R₂₉ₐ, and R_{29b} are each independently as described in connection with R₂₀ in claim 1, and
two or more neighboring substituents of R₂₁ to R₂₈, R₂₉ₐ, and R_{29b} are optionally linked to each other to form a substituted or unsubstituted C₅-C₃₀ carbocyclic group or a substituted or unsubstituted C₁-C₃₀ heterocyclic group,
wherein, when R₂₁ to R₂₈, R₂₉ₐ, or R_{29b} is -Si(Q₁)(Q₂)(Q₃) or -Ge(Q₁)(Q₂)(Q₃), Q₁ to Q₃ are each independently:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with one or more of deuterium, a C₁-C₁₀ alkyl group, or a phenyl group,
* indicates a binding site to CY₁, and
*' indicates a binding site to M₁.

7. The organometallic compound of any of claims 1-6, wherein
CY₃ is represented by one of Formulae 3-1 to 3-16: 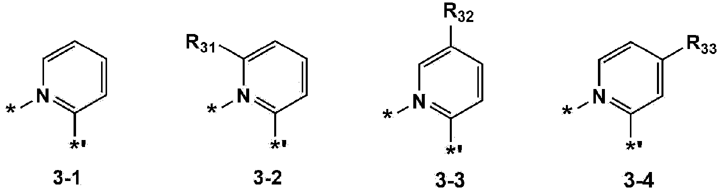 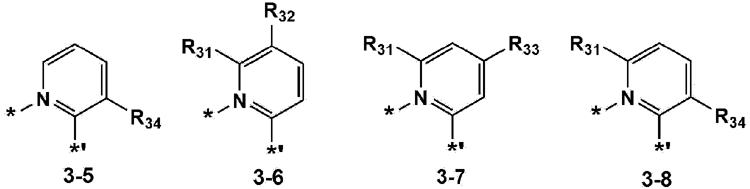 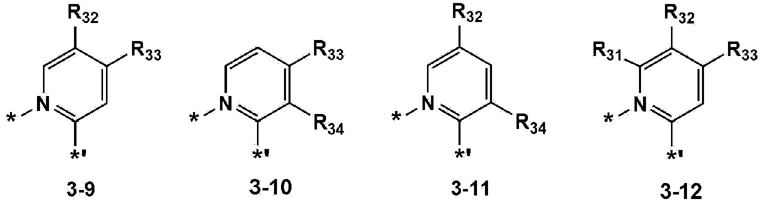 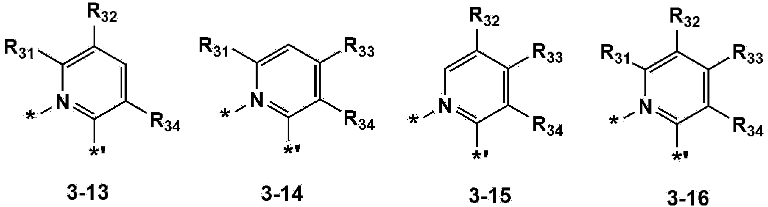 wherein, in Formulae 3-1 to 3-16,
R₃₁ to R₃₄ are each independently as described in connection with R₃₀ in claim 1, and
* indicates a binding site to M₁, and
*' indicates a binding site to a neighboring atom.

8. The organometallic compound of any of claims 1-7, wherein the organometallic compound is a compound represented by Formula 11-1: 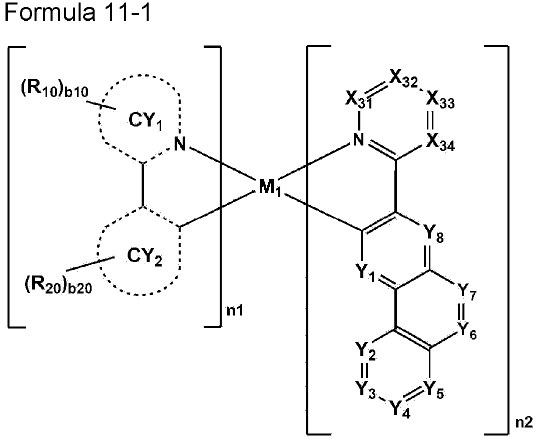 wherein, in Formula 11-1,
M₁, n1, n2, CY₁, CY₂, Y₁ to Y₈, R₁₀, R₂₀, b10, and b20 each are as described in claim 1,
X₃₁ is C(R₃₁) or N, X₃₂ is C(R₃₂) or N, X₃₃ is C(R₃₃) or N, and X₃₄ is C(R₃₄) or N,
R₃₁ to R₃₄ are each independently as described in connection with R₃₀ in claim 1, and
two or more of R₃₁ to R₃₄ are optionally linked to form a substituted or unsubstituted C₅-C₃₀ carbocyclic group or a substituted or unsubstituted C₁-C₃₀ heterocyclic group.

9. The organometallic compound of any of claims 1-8, wherein
the organometallic compound is a compound represented by Formula 12-1: 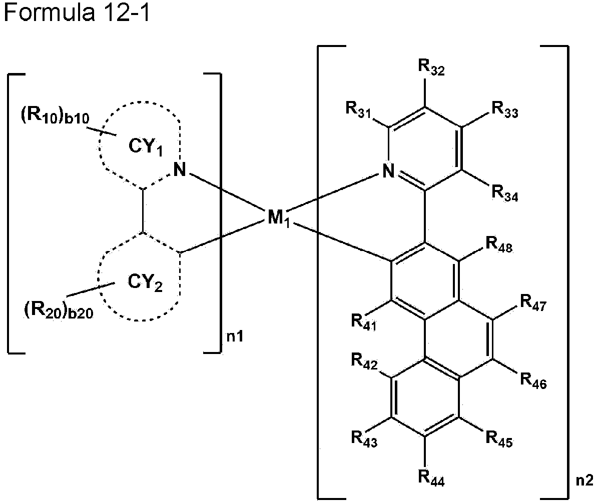 wherein, in Formula 12-1,
M₁, n1, n2, CY₁, CY₂, R₁₀, R₂₀, b10, b20, and R₄₁ to R₄₈ are each as described in claim 1, and
R₃₁ to R₃₄ are each independently as described in connection with R₃₀ in claim 1.

10. The organometallic compound of any of claims 1-9, wherein the organometallic compound is electrically neutral; and/or
wherein the organometallic compound is one of Compounds 1 to 7, 9 to 101, and 112 to 179:

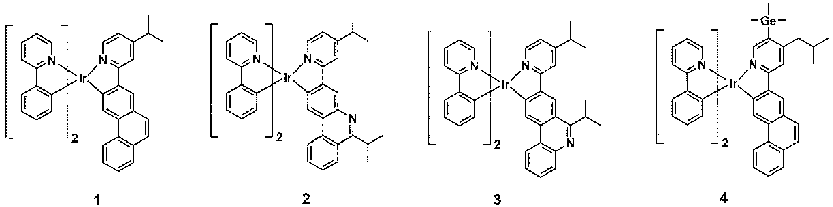

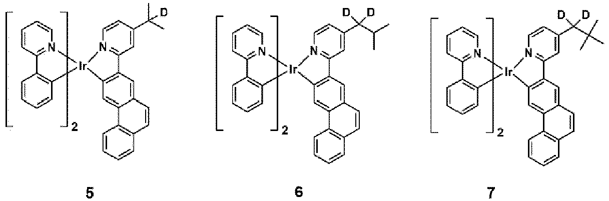

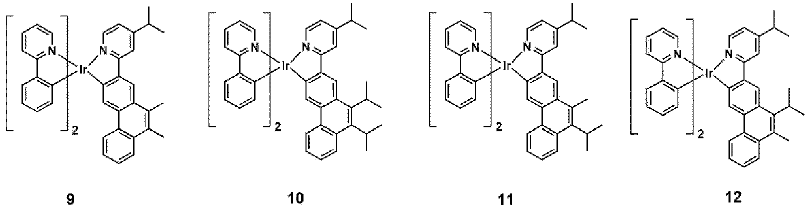

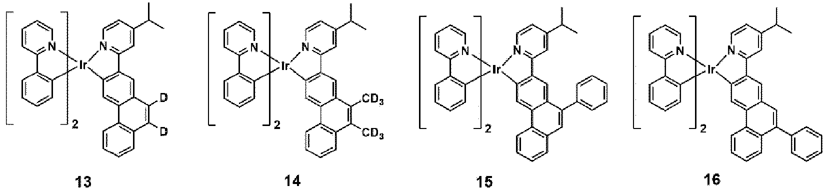

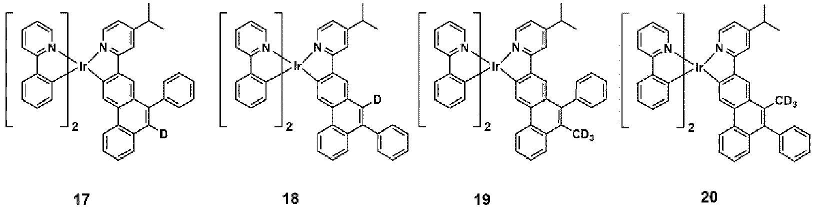

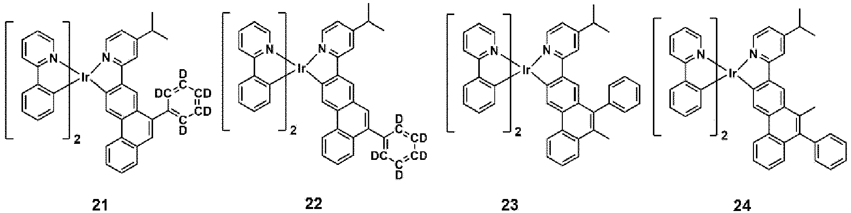

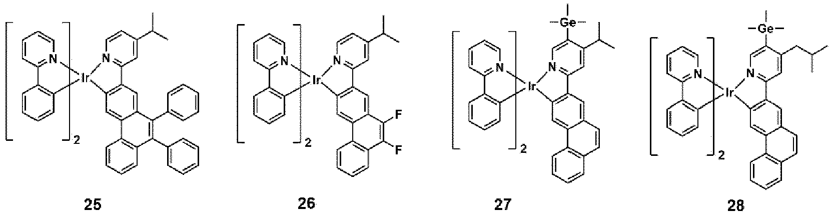

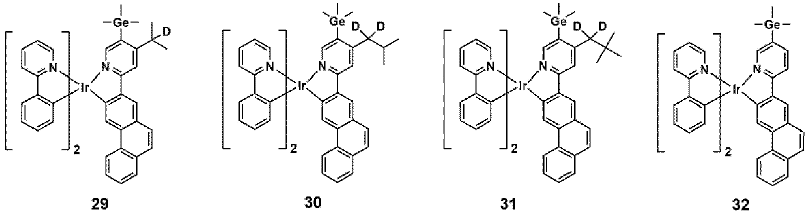

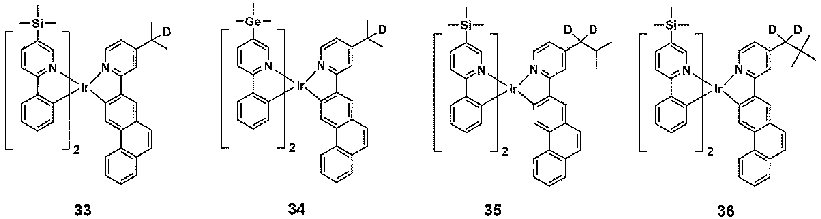

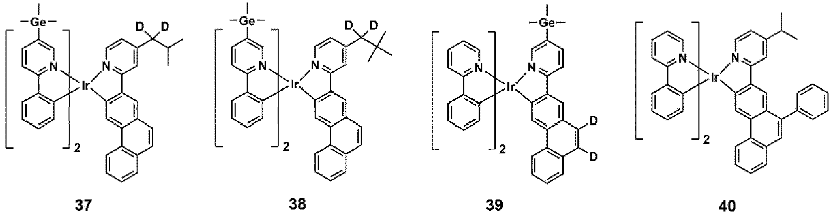

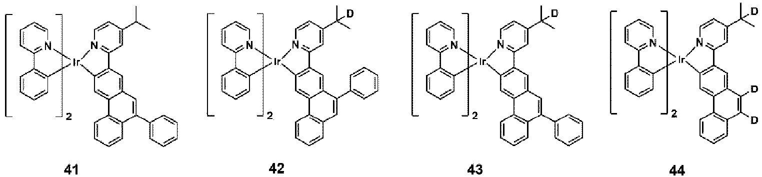

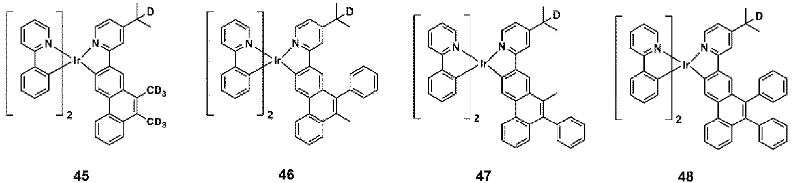

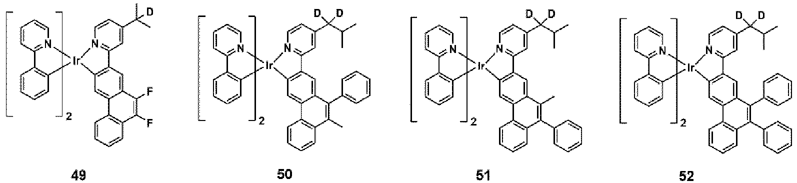

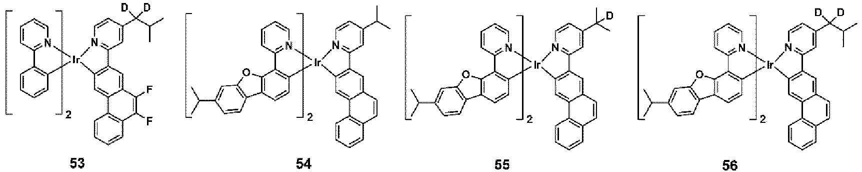

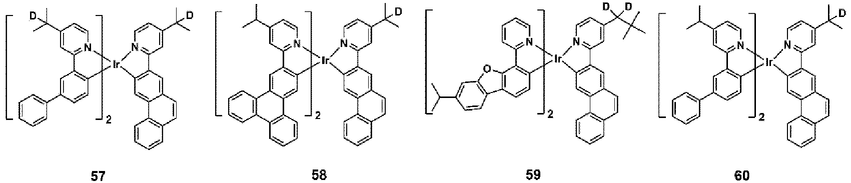

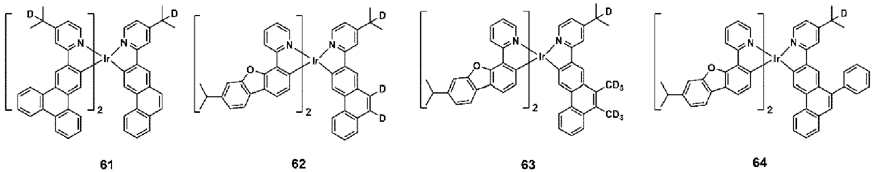

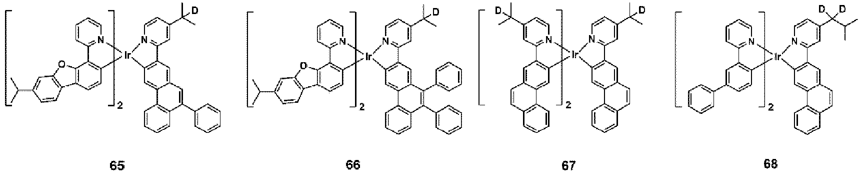

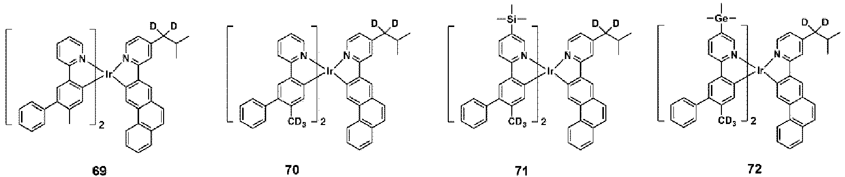

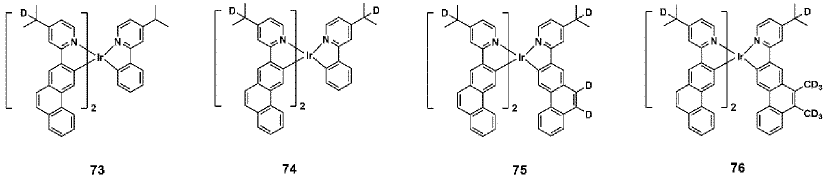

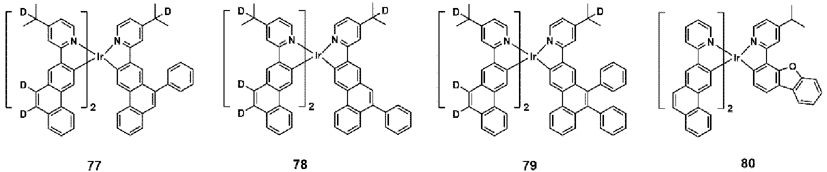

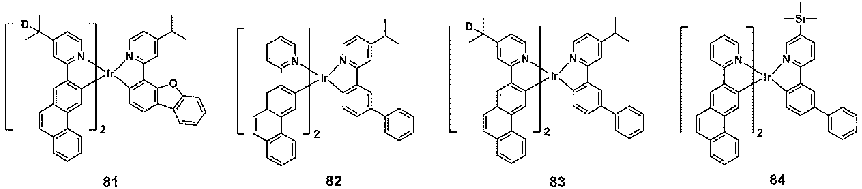

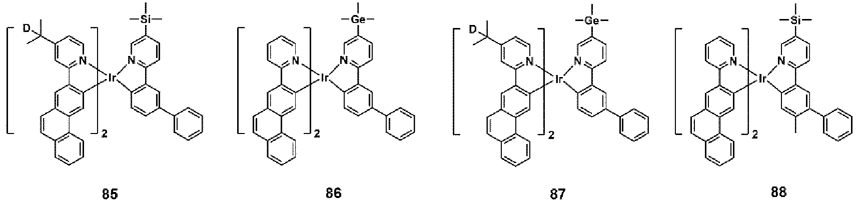

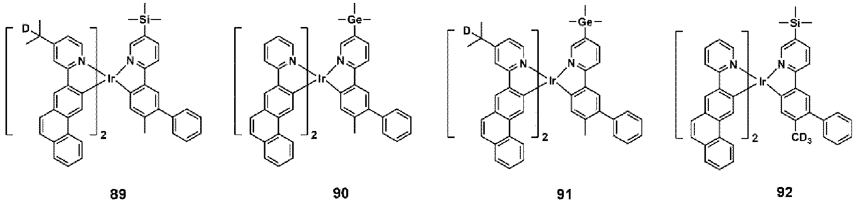

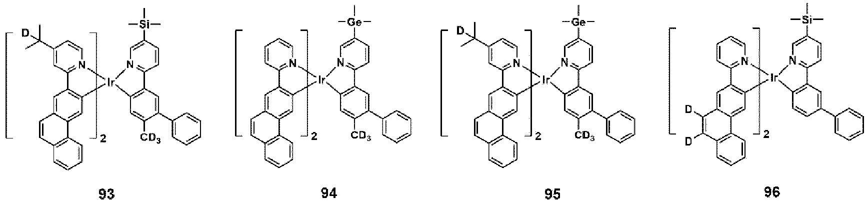

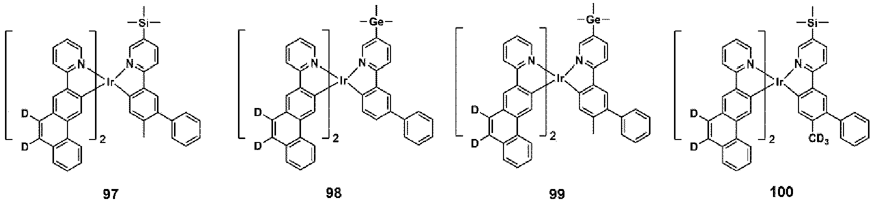

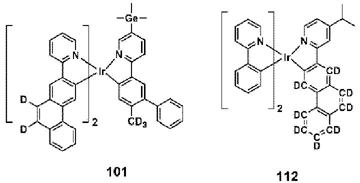

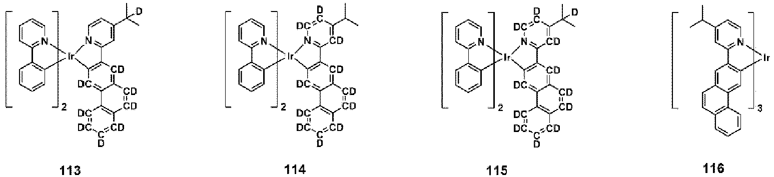

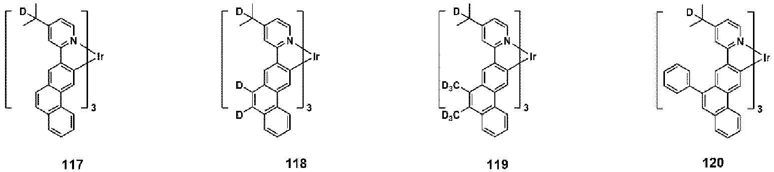

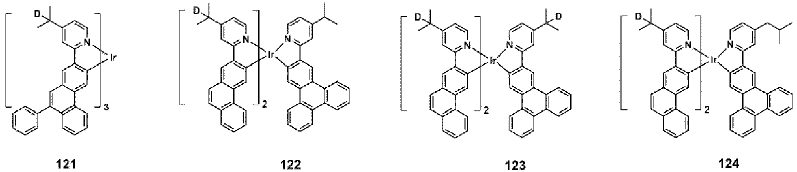

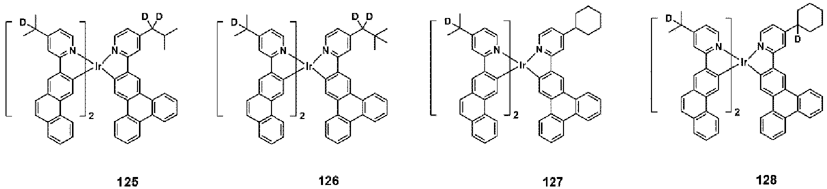

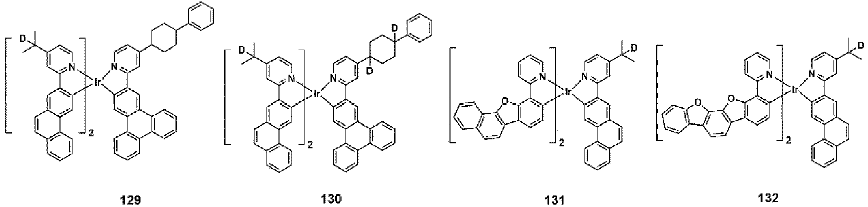

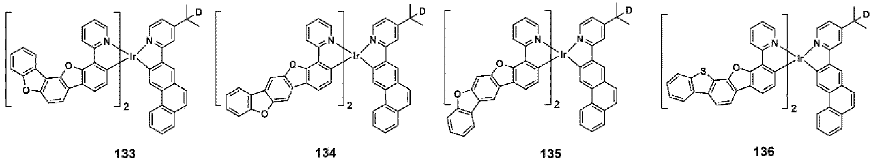

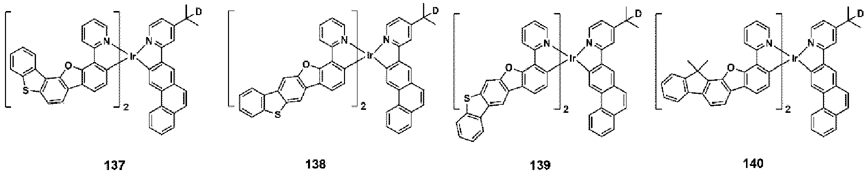

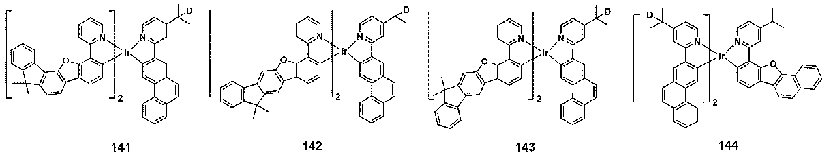

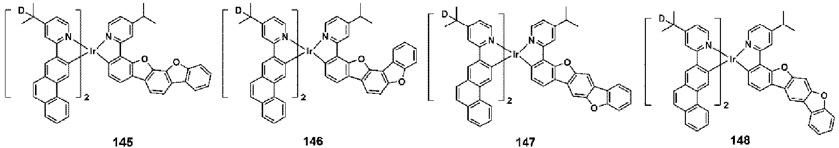

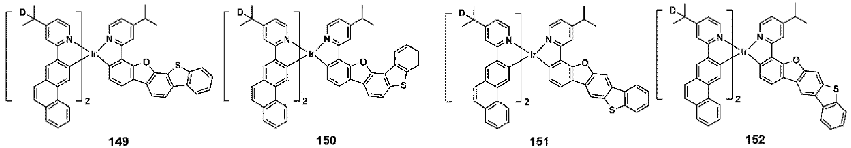

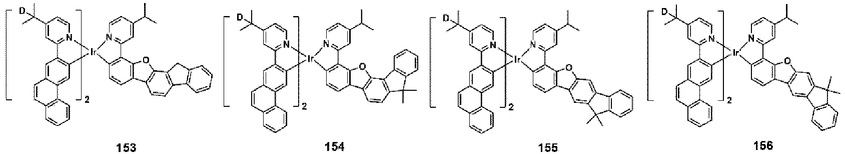

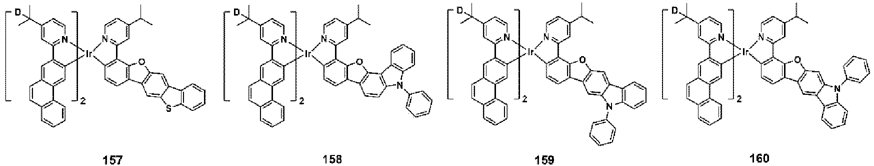

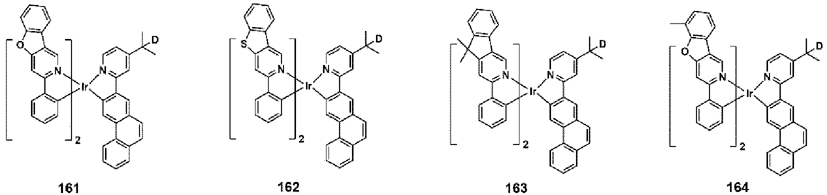

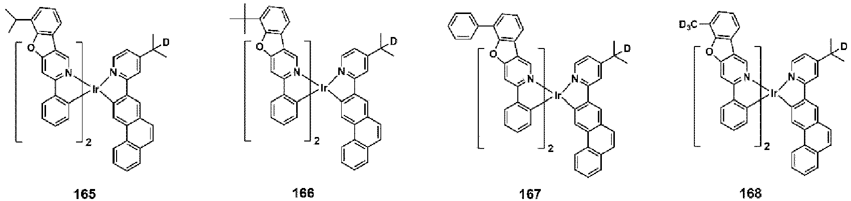

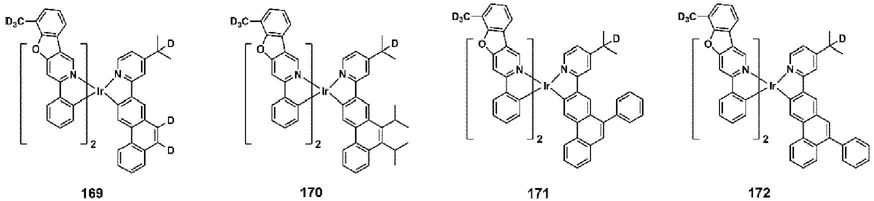

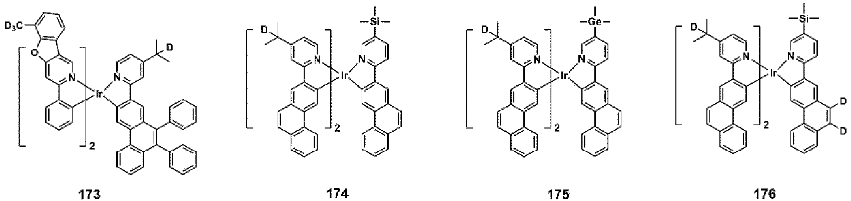

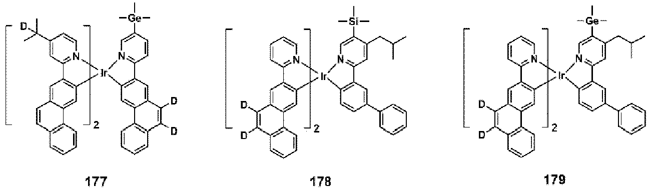

11. An organic light-emitting device, comprising:
a first electrode;
a second electrode; and
an organic layer located between the first electrode and the second electrode,
wherein the organic layer comprises an emission layer, and
wherein the organic layer comprises at least one of the organometallic compound of any of claims 1 to 10.

12. The organic light-emitting device of claim 11, wherein
the emission layer comprises the organometallic compound.

13. The organic light-emitting device of claim 12, wherein
the emission layer further comprises a host, and
the amount of the host in the emission layer is greater than the amount of the organometallic compound in the emission layer;
preferably wherein
the emission layer emits green light having a maximum emission wavelength of 500 nanometers to 600 nanometers.

14. The organic light-emitting device of claims 12 or 13, wherein
the first electrode is an anode,
the second electrode is a cathode,
the organic layer further comprises a hole transport region located between the first electrode and the emission layer, and an electron transport region located between the emission layer and the second electrode, wherein
the hole transport region comprises a hole injection layer, a hole transport layer, an electron blocking layer, a buffer layer, or a combination thereof, and
the electron transport region comprises a hole blocking layer, an electron transport layer, an electron injection layer, or a combination thereof.

15. A diagnostic composition comprising at least one of the organometallic compound of any of claims 1 to 10.

## Patentansprüche

1. Organometallische Verbindung dargestellt durch Formel 1:
Formel 1 M₁(Ln₁)ₙ₁(Ln₂)ₙ₂
wobei in Formel 1
M₁ Iridium (Ir), Platin (Pt), Osmium (Os) oder Rhodium (Rh) ist,
Ln₁ ein Ligand dargestellt durch Formel 1A ist,
Ln₂ ein Ligand dargestellt durch Formel 1B ist,
n1 0, 1 oder 2 ist, und
n2 1, 2 oder 3 ist, 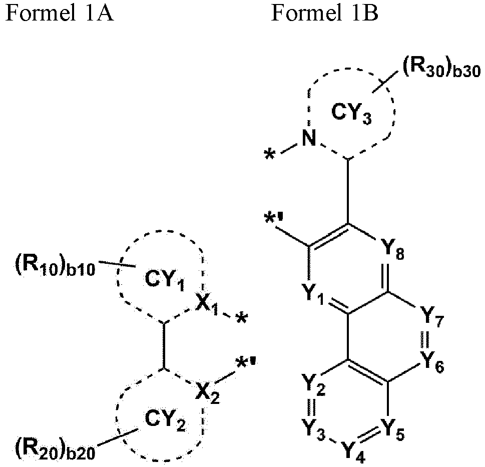 wobei in Formel 1A und 1B,
X₁ C oder N ist und X₂ C oder N ist,
Y₁ C(R₄₁) oder N ist, Y₂ C(R₄₂) oder N ist, Y₃ C(R₄₃) oder N ist, Y₄ C(R₄₄) oder N ist, Y₅ C(R₄₅) oder N ist, Y₆ C(R₄₆) oder N ist, Y₇ C(R₄₇) oder N ist, Y₈ C(R₄₈) oder N ist,
CY₁ and CY₂ jeweils unabhängig eine carbocyclische C₅-C₃₀-Gruppe oder eine heterocyclische C₁-C₃₀-Gruppe sind,
CY₃ eine heterocyclische C₁-C₃₀-Gruppe ist, die Stickstoff umfasst,
R₁₀, R₂₀ und R₄₁ bis R₄₈ jeweils unabhängig Wasserstoff, Deuterium, -F, -Cl, -Br, -I, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, -SF₅, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₂-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe, eine substituierte oder unsubstituierte einwertige nichtaromatische kondensierte heteropolycyclische Gruppe, -Si(Q₁)(Q₂)(Q₃), -Ge(Q₁)(Q₂)(Q₃), - N(Q₄)(Q₅), -B(Q₆)(Q₇), -P(Q₈)(Q₉) oder -P(=O)(Q₈)(Q₉) sind,
R₃₀ Wasserstoff, eine C₂-C₆₀-Alkylgruppe, eine C₂-C₆₀-Alkylgruppe substituiert mit Deuterium oder -Ge(Q₁)(Q₂)(Q₃) ist,
zwei oder mehr aus einer Vielzahl von R₁₀(s) optional miteinander verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zwei oder mehr aus einer Vielzahl von R₂₀(s) optional miteinander verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zwei oder mehr aus einer Vielzahl von R₃₀(s) optional miteinander verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zwei oder mehr benachbarte Substituenten von R₁₀, R₂₀ und R₃₀ optional miteinander verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
b10, b20 und b30 jeweils unabhängig 1, 2, 3, 4, 5, 6, 7, 8, 9 oder 10 sind,
zumindest ein Substituent der substituierten carbocyclischen C₅-C₃₀-Gruppe, der substituierten heterocyclischen C₁-C₃₀-Gruppe, der substituierten C₁-C₆₀-Alkylgruppe, der substituierten C₂-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₂-C₁₀-Heterocycloalkenylgruppe, der substituierten C₆-C₆₀-Arylgruppe, der substituierten C₇-C₆₀-Alkylarylgruppe, der substituierten C₈-C₆₀-Arylalkylgruppe, der substituierten C₇-C₆₀-Arylalkylgruppe, der substituierten C₆-C₆₀-Aryloxygruppe, der substituierten C₆-C₆₀-Arylthiogruppe, der substituierten C₁-C₆₀-Heteroarylgruppe, der substituierten C₂-C₆₀-Alkylheteroarylgruppe, der substituierten C₂-C₆₀-Heteroarylalkylgruppe, der substituierten C₃-C₆₀-Heteroarylalkylgruppe, der substituierten C₁-C₆₀-Heteroaryloxygruppe, der substituierten C₁-C₆₀-Heteroarylthiogruppe, der substituierten einwertigen nichtaromatischen kondensierten polycyclischen Gruppe und der substituierten einwertigen nichtaromatischen kondensierten heteropolycyclischen Gruppe wie folgt ist:
Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe oder eine C₁-C₆₀-Alkoxygruppe;
eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils substituiert mit einem oder mehreren von Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₂-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer C₁-C₆₀-Heteroaryloxygruppe, einer C₁-C₆₀-Heteroarylthiogruppe, einer einwertigen nichtaromatischen kondensierten polycyclischen Gruppe, einer einwertigen nichtaromatischen kondensierten heteropolycyclischen Gruppe, - Si(Q₁₁)(Q₁₂)(Q₁₃), -Ge(Q₁₁)(Q₁₂)(Q₁₃), -N(Q₁₄)(Q₁₅), -B(Q₁₆)(Q₁₇), -P(Q₈)(Q₉) oder - P(=O)(Q₁₈)(Q₁₉);
eine C₃-C₁₀-Cycloalkylgruppe, eine C₁-C₁₀-Heterocycloalkylgruppe, eine C₃-C₁₀-Cycloalkenylgruppe, eine C₂-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine C₁-C₆₀-Heteroaryloxygruppe, eine C₁-C₆₀-Heteroarylthiogruppe, eine einwertige nichtaromatische kondensierte polycyclische Gruppe oder eine einwertige nichtaromatische kondensierte heteropolycyclische Gruppe;
eine C₃-C₁₀-Cycloalkylgruppe, eine C₁-C₁₀-Heterocycloalkylgruppe, eine C₃-C₁₀-Cycloalkenylgruppe, eine C₂-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine einwertige nichtaromatische kondensierte polycyclische Gruppe oder eine einwertige nichtaromatische kondensierte heteropolycyclische Gruppe, jeweils substituiert mit einem oder mehreren von Deuterium, -F, -Cl, -Br, - I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₁-C₆₀-Alkylthiogruppe, einer C₃-C₁₀-Cycloalkylgruppe, einer C₁-C₁₀-Heterocycloalkylgruppe, einer C₃-C₁₀-Cycloalkenylgruppe, einer C₂-C₁₀-Heterocycloalkenylgruppe, einer C₆-C₆₀-Arylgruppe, einer C₇-C₆₀-Alkylarylgruppe, einer C₇-C₆₀-Arylalkylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₂-C₆₀-Heteroarylalkylgruppe, einer C₁-C₆₀-Heteroaryloxygruppe, einer C₁-C₆₀-Heteroarylthiogruppe, einer einwertigen nichtaromatischen kondensierten polycyclischen Gruppe, einer einwertigen nichtaromatischen kondensierten heteropolycyclischen Gruppe, -Si(Q₂₁)(Q₂₂)(Q₂₃), -Ge(Q₂₁)(Q₂₂)(Q₂₃), - N(Q₂₄)(Q₂₅), -B(Q₂₆)(Q₂₇), -P(Q₂₈)(Q₂₉) oder -P(=O)(Q₂₈)(Q₂₉), oder
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), -P(Q₃₈)(Q₃₉) oder - P(=O)(Q₃₈)(Q₃₉),
wobei Q₁ bis Q₉, Q₁₁ bis Q₁₉, Q₂₁ bis Q₂₉ und Q₃₁ bis Q₃₉ jeweils unabhängig Wasserstoff, Deuterium, -F, -Cl, -Br, -I, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₂-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe oder eine substituierte oder unsubstituierte einwertige nichtaromatische kondensierte heteropolycyclische Gruppe sind, und
wobei * und *' jeweils eine Bindungsstelle zu M₁ angeben.

2. Organometallische Verbindung nach Anspruch 1, wobei
M₁ Ir ist, und
die Summe von n1 und n2 3 ist.

3. Organometallische Verbindung nach Anspruch 1 oder 2, wobei
CY₁ und CY₂ jeweils unabhängig wie folgt sind:
eine Cyclopentangruppe, eine Cyclohexangruppe, eine Cycloheptangruppe, eine Cyclopentengruppe, eine Cyclohexengruppe, eine Cycloheptengruppe, eine Phenylgruppe, eine Naphthalengruppe, eine 1,2,3,4-Tetrahydronaphthalengruppe, eine Anthracengruppe, eine Phenanthrengruppe, eine Triphenylengruppe, eine Pyrengruppe, eine Chrysengruppe, eine Cyclopentadiengruppe, eine Thiophengruppe, eine Furangruppe, eine Indolgruppe, eine Benzoborolgruppe, eine Benzophospholgruppe, eine Indengruppe, eine Benzosilolgruppe, eine Benzogermolgruppe, eine Benzothiophengruppe, eine Benzoselenophengruppe, eine Benzofurangruppe, eine Carbazolgruppe, eine Dibenzoborolgruppe, eine Dibenzophospholgruppe, eine Fluorengruppe, eine Dibenzosilolgruppe, eine Dibenzogermolgruppe, eine Dibenzothiophengruppe, eine Dibenzoselenophengruppe, eine Dibenzofurangruppe, eine Dibenzothiophen-5-Oxidgruppe, eine 9H-Fluoren-9-on-Gruppe, eine Dibenzothiophen-5,5-Dioxidgruppe, eine Azaindolgruppe, eine Azabenzoborolgruppe, eine Azabenzophospholgruppe, eine Azaindengruppe, eine Azabenzosilolgruppe, eine Azabenzogermolgruppe, eine Azabenzothiophengruppe, eine Azabenzoselenophengruppe, eine Azabenzofurangruppe, eine Azacarbazolgruppe, eine Azadibenzoborolgruppe, eine Azadibenzophospholgruppe, eine Azafluorengruppe, eine Azadibenzosilolgruppe, eine Azadibenzogermolgruppe, eine Azadibenzothiophengruppe, eine Azadibenzoselenophengruppe, eine Azadibenzofurangruppe, eine Azadibenzothiophen-5-Oxidgruppe, eine Aza-9H-Fluoren-9-on-Gruppe, eine Azadibenzothiophen-5,5-Dioxidgruppe, eine Pyridingruppe, eine Pyrimidingruppe, eine Pyrazingruppe, eine Pyridazingruppe, eine Triazingruppe, eine Chinolingruppe, eine Isochinolingruppe, eine Chinoxalingruppe, eine Chinazolingruppe, eine Phenanthrolingruppe, eine Pyrrolgruppe, eine Pyrazolgruppe, eine Imidazolgruppe, eine Triazolgruppe, eine Oxazolgruppe, eine Isoxazolgruppe, eine Thiazolgruppe, eine Isothiazolgruppe, eine Oxadiazolgruppe, eine Thiadiazolgruppe, eine Benzopyrazolgruppe, eine Benzimidazolgruppe, eine Benzoxazolgruppe, eine Benzothiazolgruppe, eine Benzoxadiazolgruppe, eine Benzothiadiazolgruppe, eine 5,6,7,8-Tetrahydroisochinolingruppe oder eine 5,6,7,8-Tetrahydrochinolingruppe; oder
eine Gruppe dargestellt durch Formel 8-1 oder 8-2: 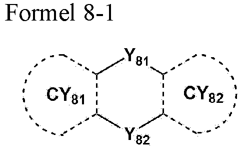 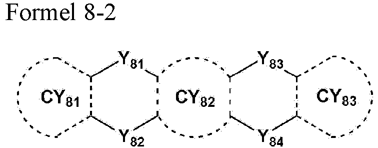 wobei in Formel 8-1 und 8-2
Y₈₁ bis Y₈₄ jeweils unabhängig eine Einfachbindung, O, S, N(R₈₁), C(R₈₁)(R₈₂), Si(R₈₁)(R₈₂), C(=O), S(=O), S(=O)₂, B(R₈₁), P(R₈₁) oder P(=O)(R₈₁) sind,
CY₈₁ bis CY₈₃ jeweils unabhängig eine Phenylgruppe, eine Naphthalengruppe, eine 1,2,3,4-Tetrahydronaphthalengruppe, eine Phenanthrengruppe, eine Pyridingruppe, eine Pyrimidingruppe, eine Pyrazingruppe, eine Triazingruppe, eine Chinolingruppe, eine Isochinolingruppe, eine Chinoxalingruppe, eine Chinazolingruppe, eine Phenanthrolingruppe, eine Benzofurangruppe, eine Benzothiophengruppe, eine Fluorengruppe, eine Carbazolgruppe, eine Dibenzofurangruppe, eine Dibenzothiophengruppe, eine Dibenzosilolgruppe, eine Azafluorengruppe, eine Azacarbazolgruppe, eine Azadibenzofurangruppe, eine Azadibenzothiophengruppe oder eine Azadibenzosilolgruppe sind, und
R₈₁ und R₈₂ jeweils unabhängig wie beschrieben in Verbindung mit R₁₀ und R₂₀ in Anspruch 1 sind; und/oder
wobei
CY₃ eine Pyridingruppe, eine Pyrimidingruppe, eine Pyrazingruppe, eine Triazingruppe, eine Chinolingruppe, eine Isochinolingruppe, eine Chinoxalingruppe oder eine Chinazolingruppe ist.

4. Organometallische Verbindung nach einem der Ansprüche 1-3, wobei
R₁₀, R₂₀ und R₄₁ bis R₄₈ jeweils unabhängig sind: Wasserstoff, Deuterium, -F, -Cl, -Br, -I, -CD₃, -CD₂H, -CDH₂, -CF₃, -CF₂H, -CFH₂, -SF₅, eine C₁-C₆₀-Alkylgruppe, eine C₂-C₆₀-Alkenylgruppe, eine C₂-C₆₀-Alkinylgruppe, eine C₁-C₆₀-Alkoxygruppe, -Si(Q₁)(Q₂)(Q₃) oder - Ge(Q₁)(Q₂)(Q₃); oder
eine Gruppe dargestellt durch eine der Formeln 9-1 bis 9-61, 9-201 bis 9-237, 10-1 bis 10-141 oder 10-201 bis 10-350: 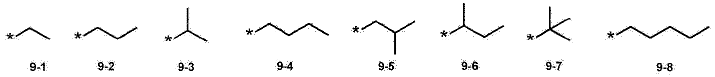 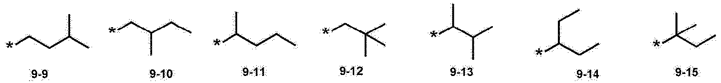 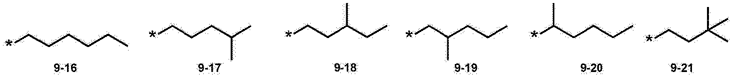 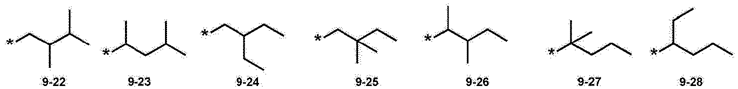 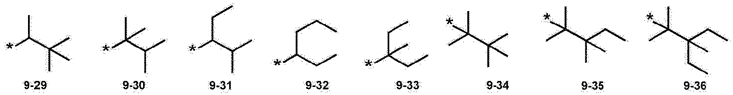 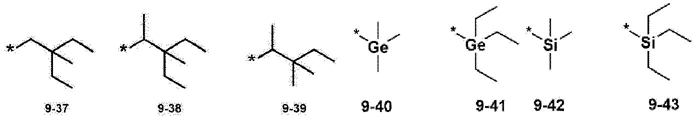 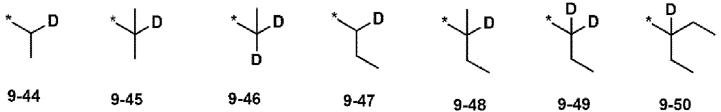 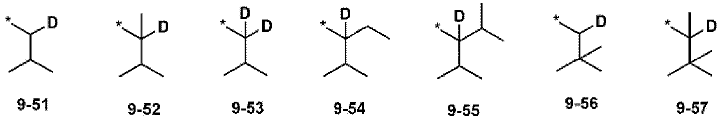 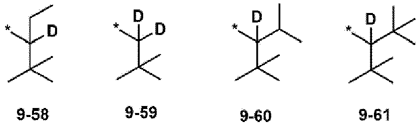 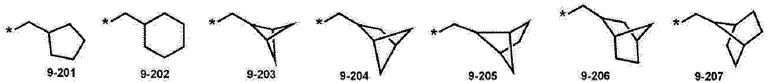 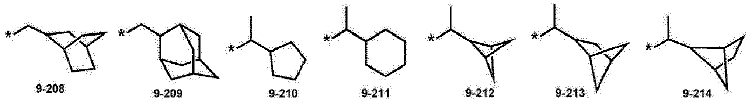 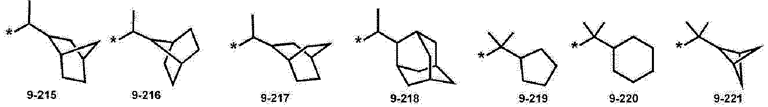 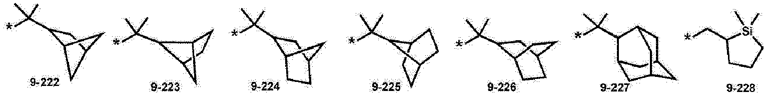 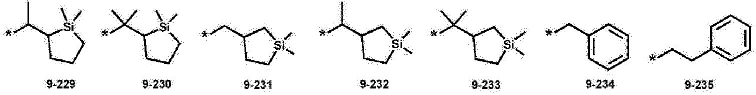 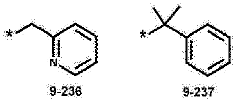 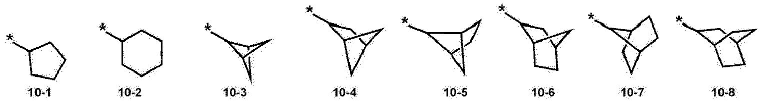 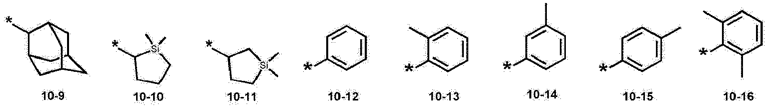 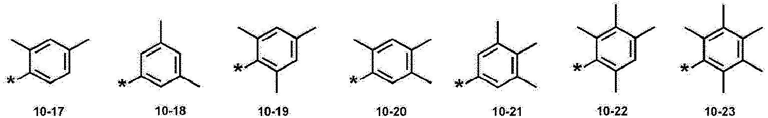 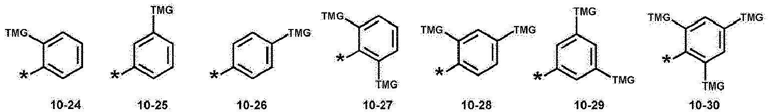 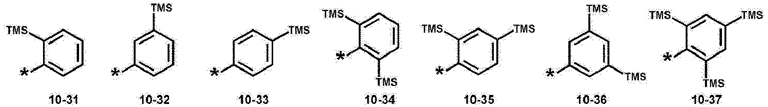 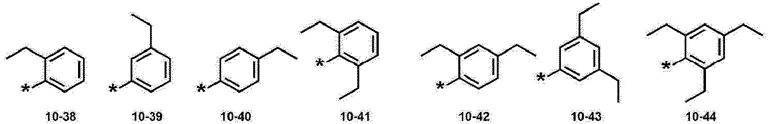 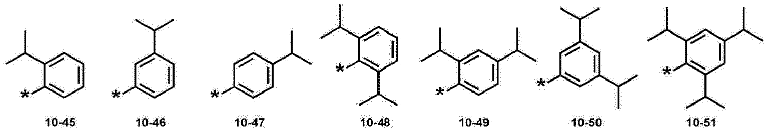 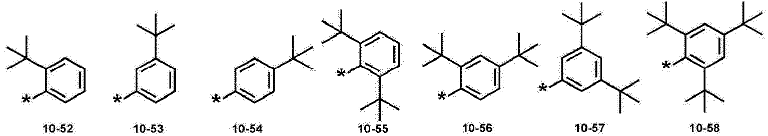 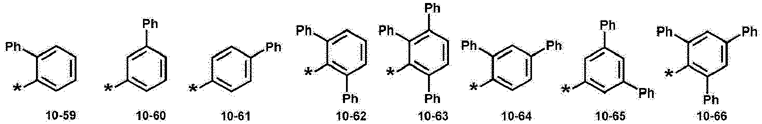 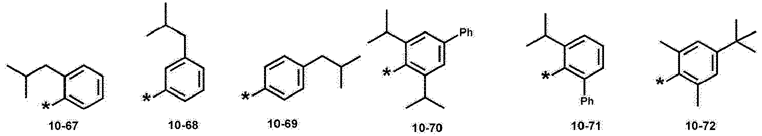 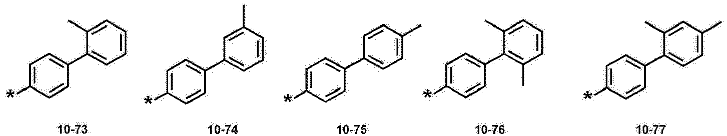 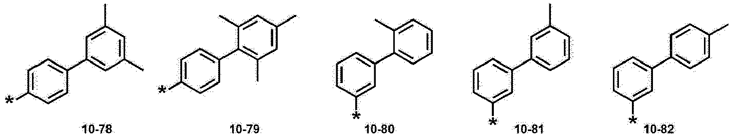 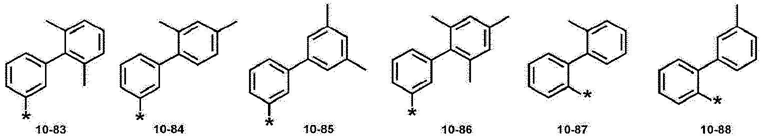 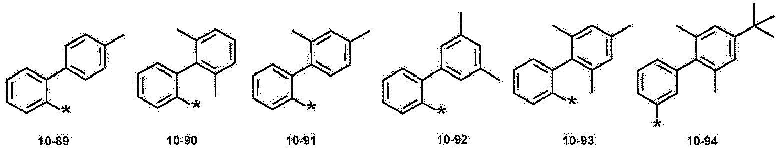 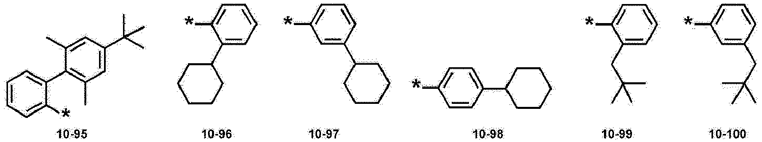 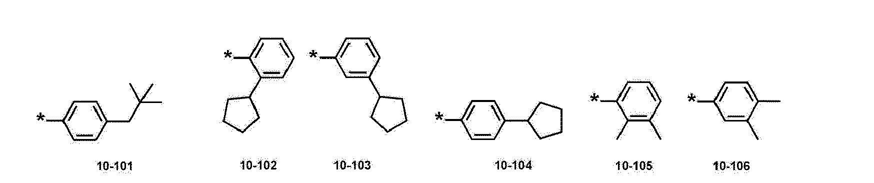 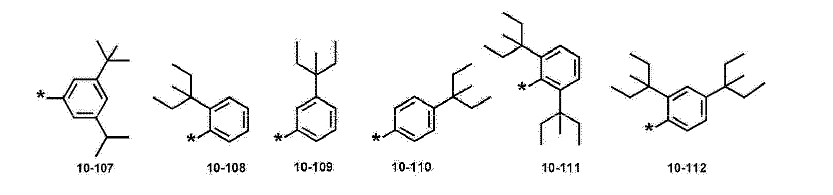 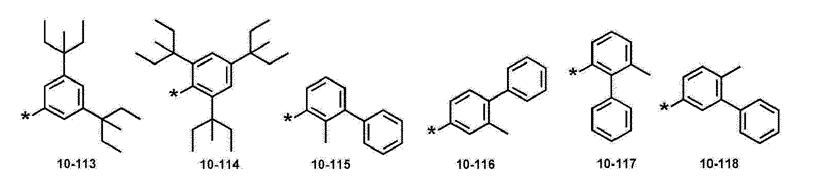 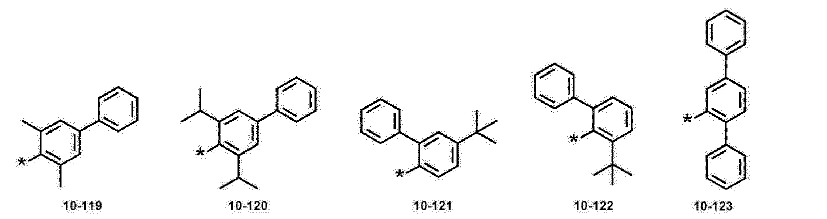 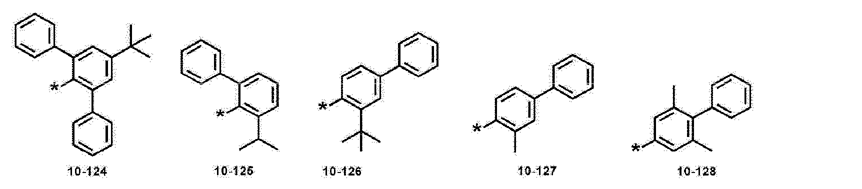 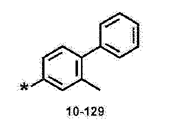 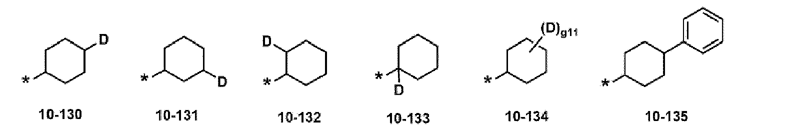 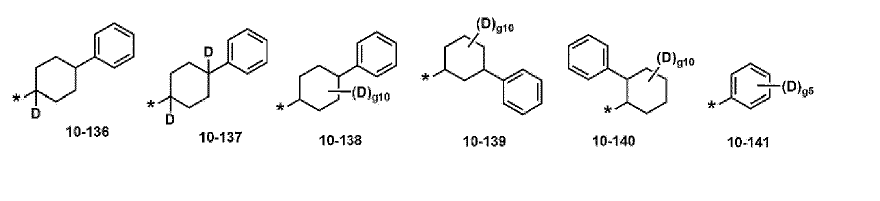 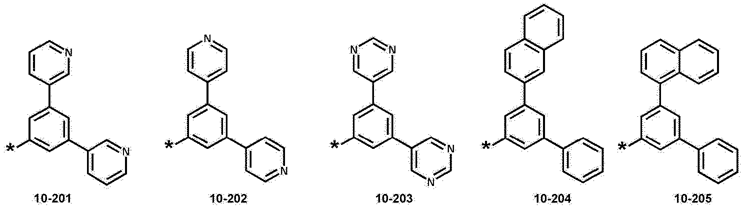 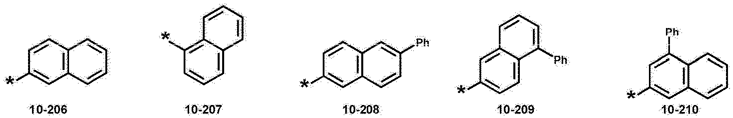 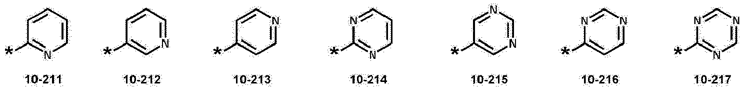 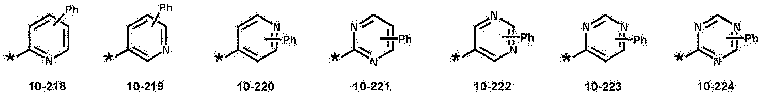 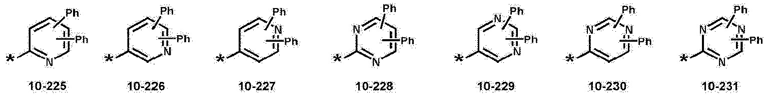 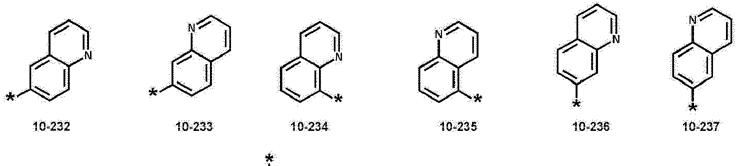 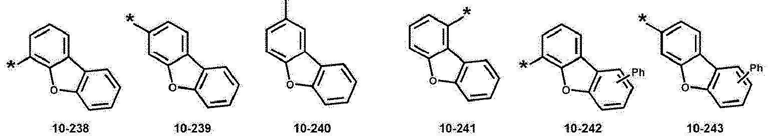 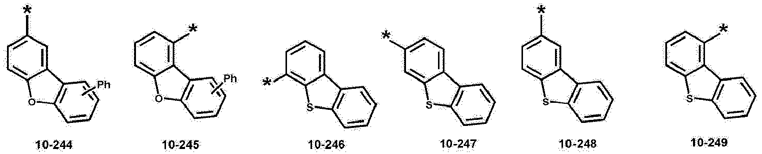 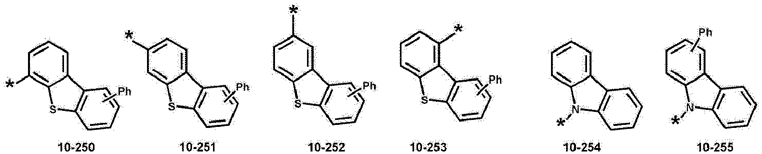 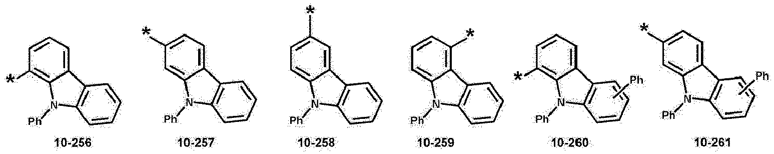 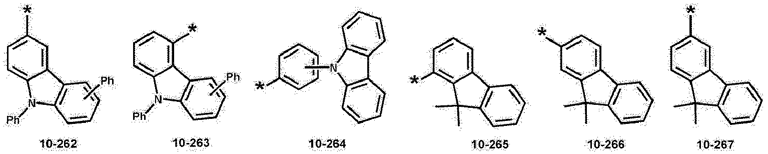 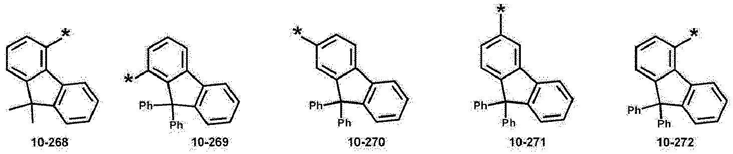 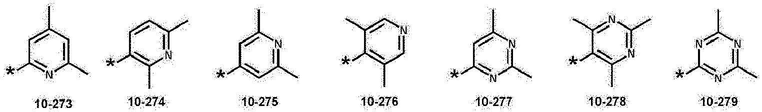 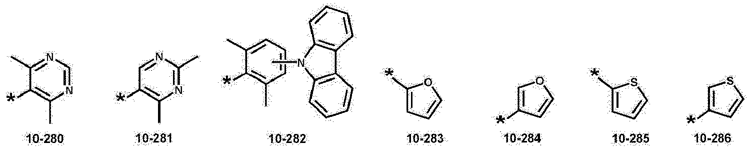 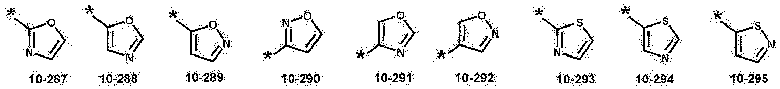 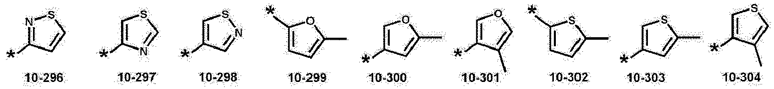 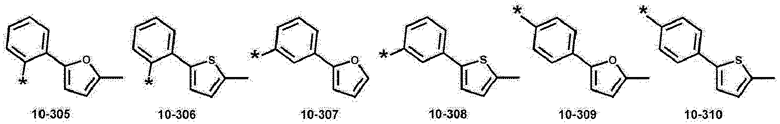 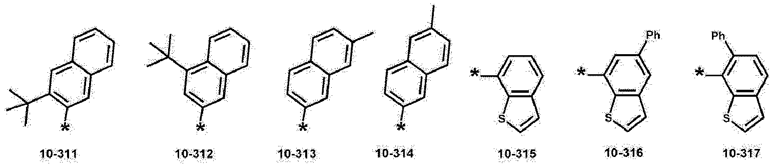 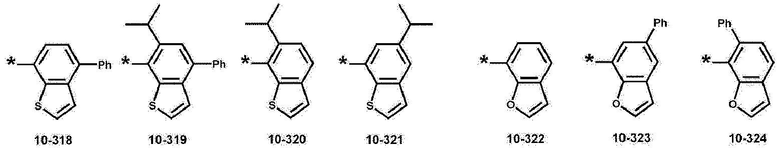 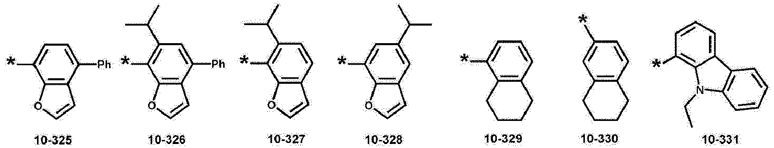 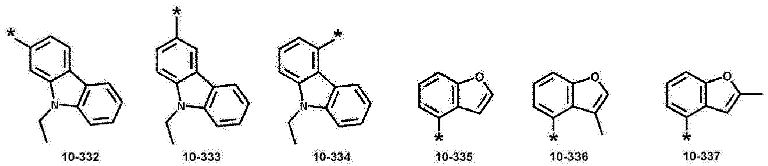 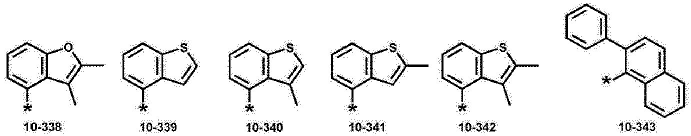 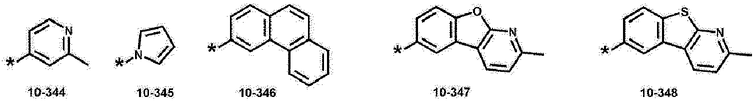 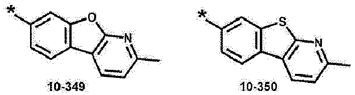 wobei in den Formeln 9-1 bis 9-61, 9-201 bis 9-237, 10-1 bis 10-141 oder 10-201 bis 10-350
* eine Bindungsstelle zu einem benachbarten Atom angibt,
Ph eine Phenylgruppe ist,
TMS eine Trimethylsilylgruppe ist,
TMG eine Trimethylgermylgruppe ist,
g5 eine ganze Zahl von 1 bis 5 ist,
g10 eine ganze Zahl von 1 bis 10 ist, und
g11 eine ganze Zahl von 1 bis 11 ist.

5. Organometallische Verbindung nach einem der Ansprüche 1-4, wobei R₃₀ eine Gruppe dargestellt durch eine der Formeln 9-1 bis 9-61 ist: 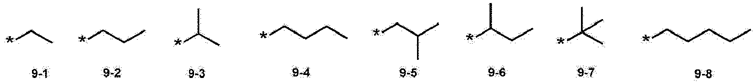 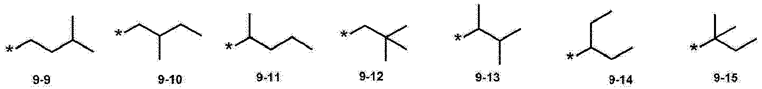 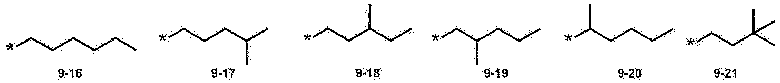 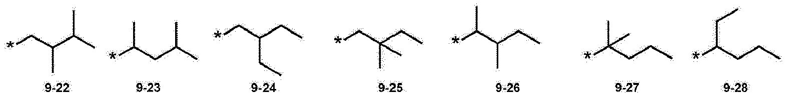 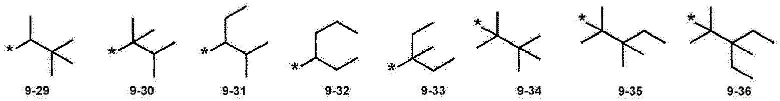 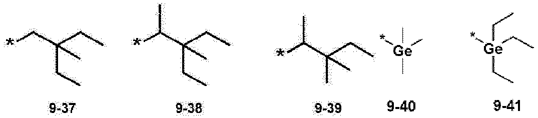 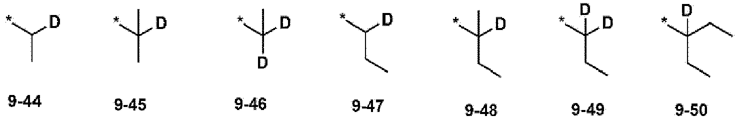 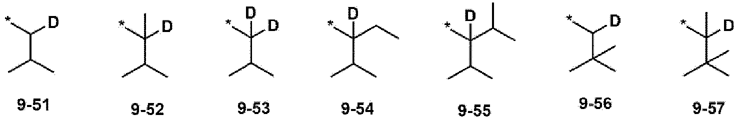 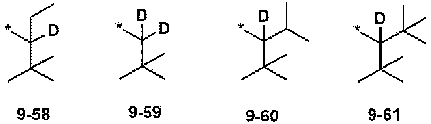 wobei in den Formeln 9-1 bis 9-61
* eine Bindungsstelle zu einem benachbarten Atom angibt.

6. Organometallische Verbindung nach einem der Ansprüche 1-5, wobei CY₁ dargestellt ist durch eine der Formeln 1-1 bis 1-16: 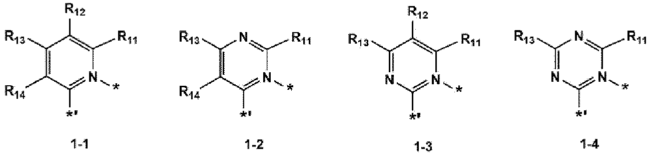 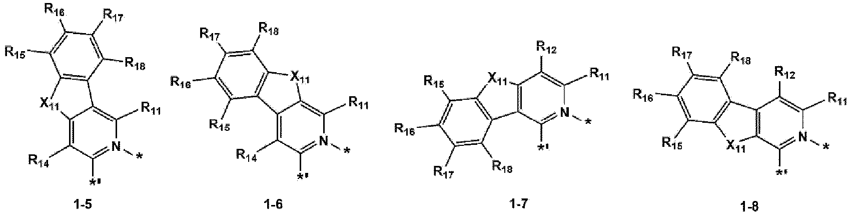 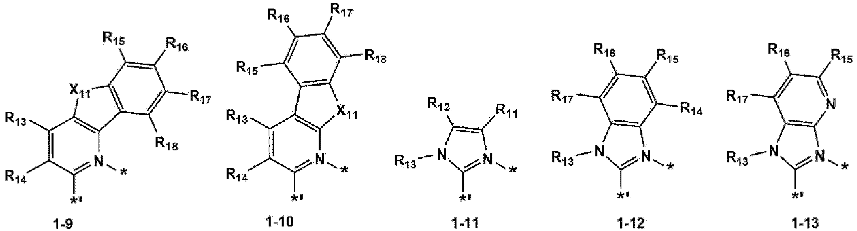 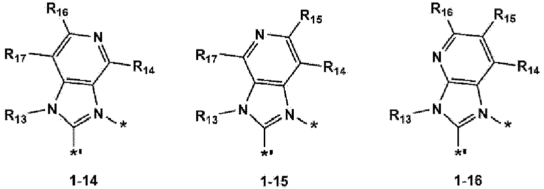 wobei in den Formeln 1-1 bis 1-16
X₁₁ O, S, N(R₁₉ₐ), C(R₁₉ₐ)(R_{19b}) oder Si(R₁₉ₐ)(R_{19b}) ist,
R₁₁ bis R₁₈, R₁₉ₐ und R_{19b} jeweils unabhängig wie beschrieben in Verbindung mit R₁₀ in Anspruch 1 sind,
zwei oder mehr benachbarte Substituenten von R₁₁ bis R₁₈, R₁₉ₐ oder R_{19b} optional miteinander verknüpft sind, um eine substituierte oder unsubstituierte carbocyclische C₅-C₃₀-Gruppe oder eine substituierte oder unsubstituierte heterocyclische C₁-C₃₀-Gruppe zu bilden, und
wobei, wenn R₁₁ bis R₁₈, R₁₉ₐ oder R_{19b} -Si(Q₁)(Q₂)(Q₃) oder -Ge(Q₁)(Q₂)(Q₃) ist, Q₁ bis Q₃ jeweils unabhängig wie folgt sind:
-CH₃, -CD₃, -CD₂H, -CDH₂, -CH₂CH₃, -CH₂CD₃, -CH₂CD₂H, -CH₂CDH₂, - CHDCH3, - CHDCD₂H, -CHDCDH₂, -CHDCD₃, -CD₂CD₃, -CD₂CD₂H oder -CD₂CDH₂;
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe; oder
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe, jeweils substituiert mit einem oder mehreren von Deuterium, einer C₁-C₁₀-Alkylgruppe oder einer Phenylgruppe,
* eine Bindungsstelle zu M₁ angibt, und
*' eine Bindungsstelle zu CY₂ angibt; und/oder
wobei
CY₂ dargestellt ist durch eine der Formeln 2-1 bis 2-22: 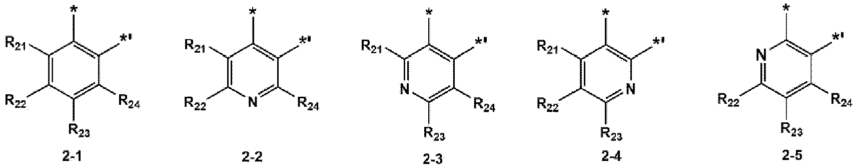 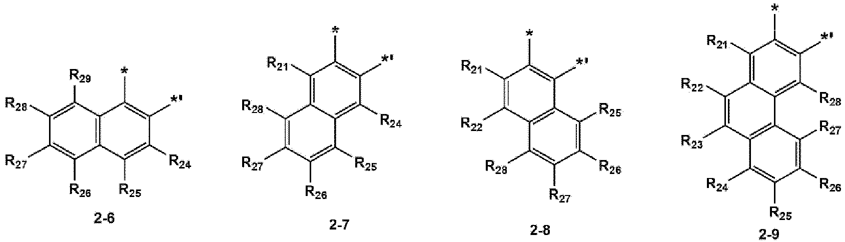 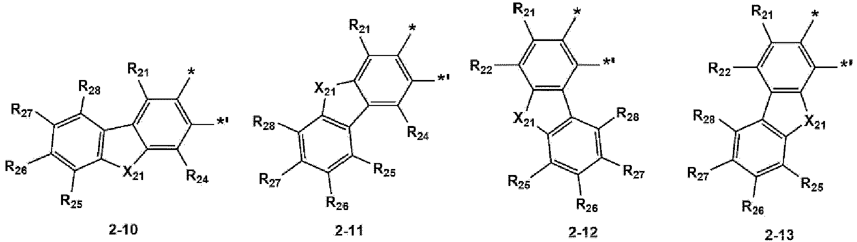 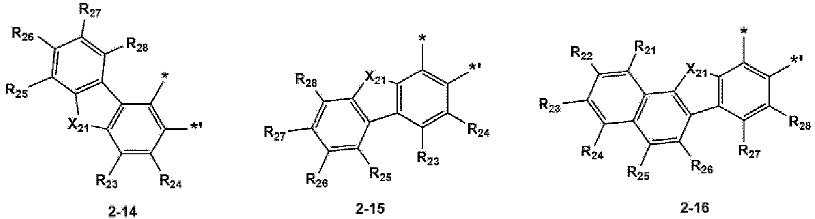 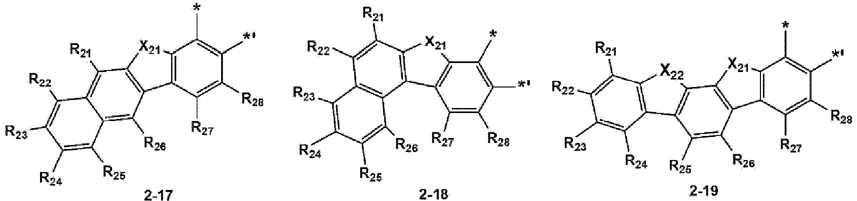 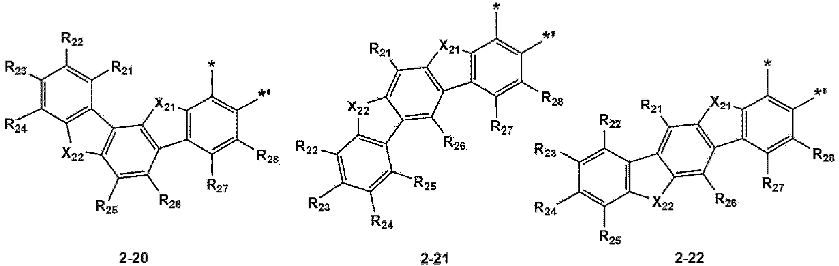 wobei in den Formeln 2-1 bis 2-22
X₂₁ und X₂₂ jeweils unabhängig O, S, N(R₂₉ₐ), C(R₂₉ₐ)(R_{29b}) oder Si(R₂₉ₐ)(R_{29b}) sind,
R₂₁ bis R₂₈, R₂₉ₐ und R_{29b} jeweils unabhängig wie beschrieben in Verbindung mit R₂₀ in Anspruch 1 sind, und
zwei oder mehr benachbarte Substituenten von R₂₁ bis R₂₈, R₂₉ₐ und R_{29b} optional miteinander verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
wobei, wenn R₂₁ bis R₂₈, R₂₉ₐ oder R_{29b} -Si(Q₁)(Q₂)(Q₃) oder -Ge(Q₁)(Q₂)(Q₃) ist, Q₁ bis Q₃ jeweils unabhängig wie folgt sind:
-CH₃, -CD₃, -CD₂H, -CDH₂, -CH₂CH₃, -CH₂CD₃, -CH₂CD₂H, -CH₂CDH₂, - CHDCH₃, - CHDCD₂H, -CHDCDH₂, -CHDCD₃, -CD₂CD₃, -CD₂CD₂H oder -CD₂CDH₂;
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe; oder
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe, jeweils substituiert mit einem oder mehreren von Deuterium, einer C₁-C₁₀-Alkylgruppe oder einer Phenylgruppe,
* eine Bindungsstelle zu CY₁ angibt, und
*' eine Bindungsstelle zu M₁ angibt.

7. Organometallische Verbindung nach einem der Ansprüche 1-6, wobei
CY₃ dargestellt ist durch eine der Formeln 3-1 bis 3-16: 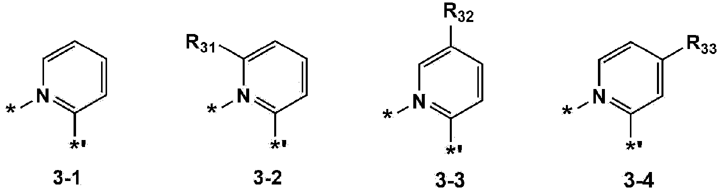 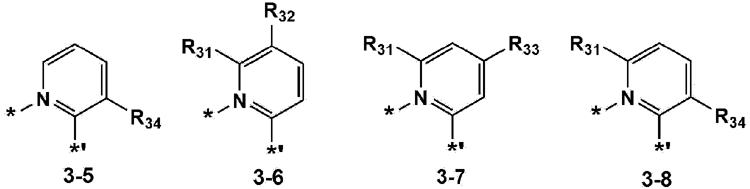 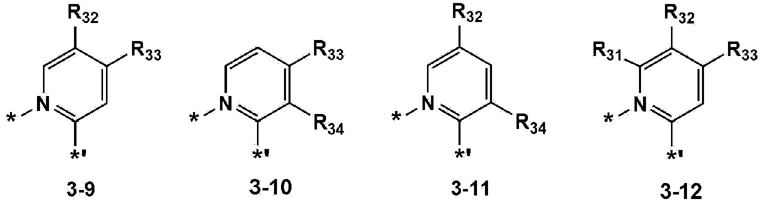 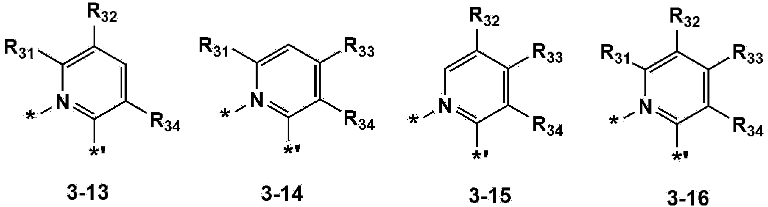 wobei in den Formeln 3-1 bis 3-16
R₃₁ bis R₃₄ jeweils unabhängig wie beschrieben in Verbindung mit R₃₀ in Anspruch 1 sind, und
* eine Bindungsstelle zu M₁ angibt, und
*' eine Bindungsstelle zu einem benachbarten Atom angibt.

8. Organometallische Verbindung nach einem der Ansprüche 1-7, wobei
die organometallische Verbindung eine Verbindung dargestellt durch Formel 11-1 ist: 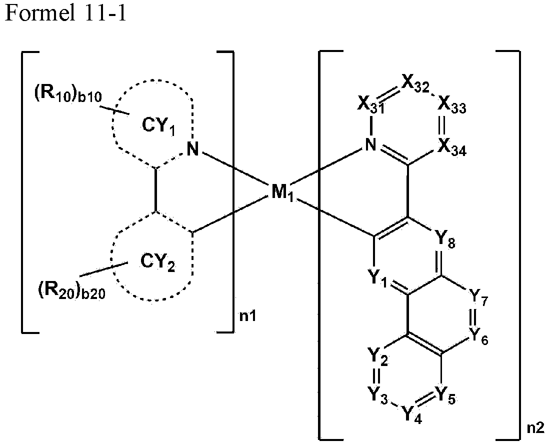 wobei in Formel 11-1
M₁, n1, n2, CY₁, CY₂, Y₁ bis Y₈, R₁₀, R₂₀, b10 und b20 jeweils wie beschrieben in Anspruch 1 sind,
X₃₁ C(R₃₁) oder N ist, X₃₂ C(R₃₂) oder N ist, X₃₃ C(R₃₃) oder N ist und X₃₄ C(R₃₄) oder N ist,
R₃₁ bis R₃₄ jeweils unabhängig wie beschrieben in Verbindung mit R₃₀ in Anspruch 1 sind, und
zwei oder mehr von R₃₁ bis R₃₄ optional verknüpft sind, um eine substituierte oder unsubstituierte carbocyclische C₅-C₃₀-Gruppe oder eine substituierte oder unsubstituierte heterocyclische C₁-C₃₀-Gruppe zu bilden.

9. Organometallische Verbindung nach einem der Ansprüche 1-8, wobei
die organometallische Verbindung eine Verbindung dargestellt durch Formel 12-1 ist: 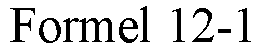 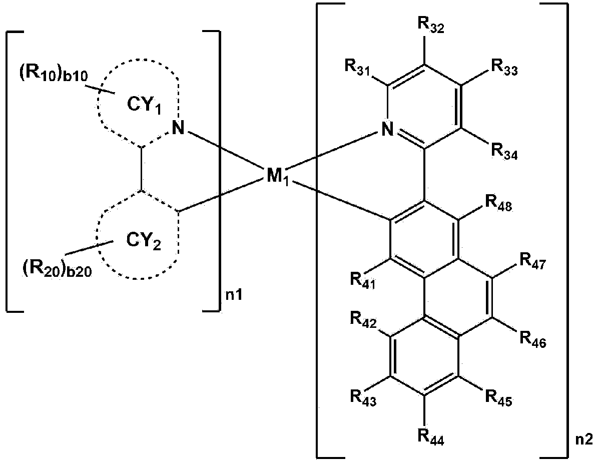 wobei in Formel 12-1
M₁, n1, n2, CY₁, CY₂, R₁₀, R₂₀, b10, b20 und R₄₁ bis R₄₈ jeweils wie beschrieben in Anspruch 1 sind, und
R₃₁ bis R₃₄ jeweils unabhängig wie beschrieben in Verbindung mit R₃₀ in Anspruch 1 sind.

10. Organometallische Verbindung nach einem der Ansprüche 1-9, wobei die organometallische Verbindung elektrisch neutral ist; und/oder
wobei die organometallische Verbindung eine von Verbindung 1 bis 7, 9 bis 101 und 112 bis 179 ist:

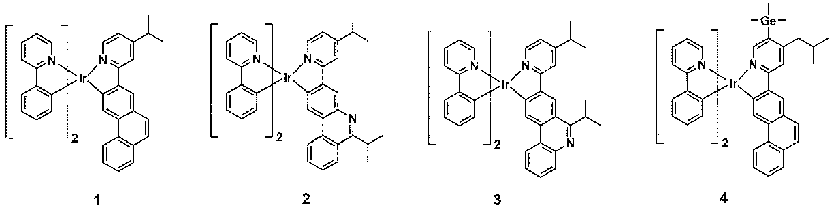

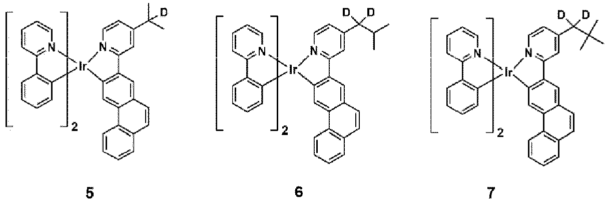

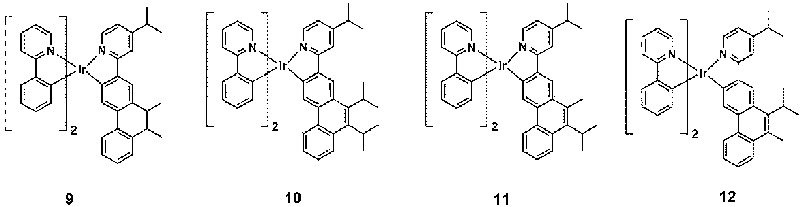

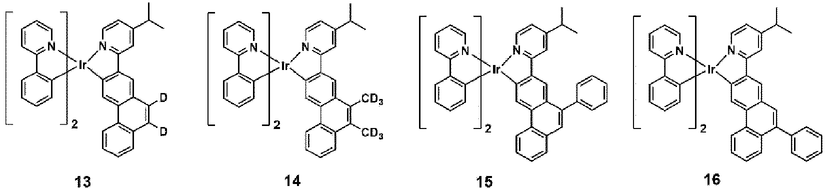

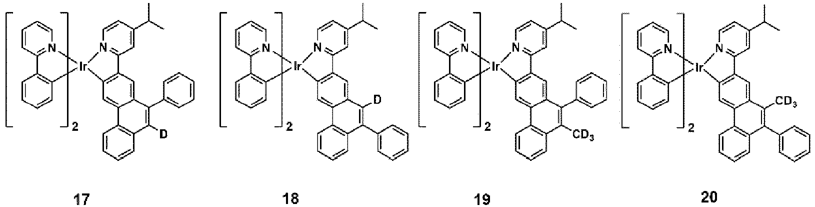

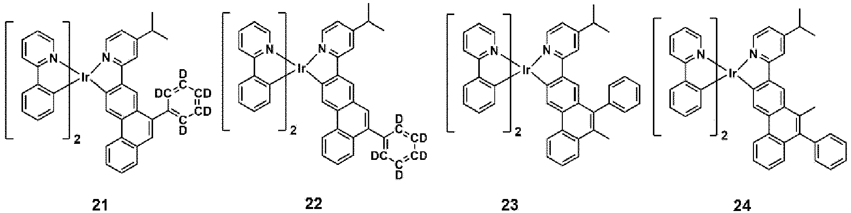

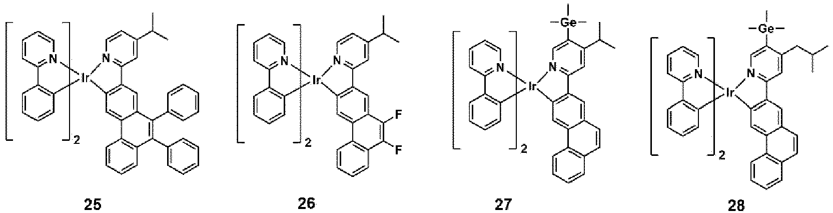

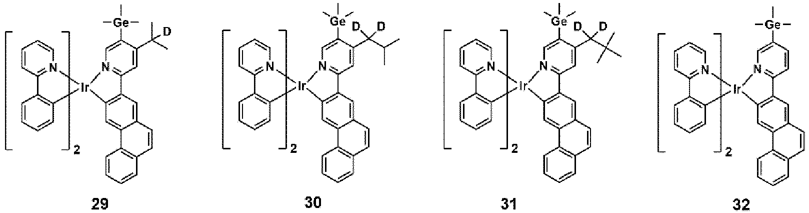

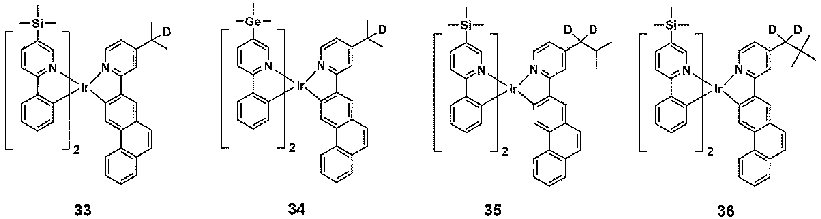

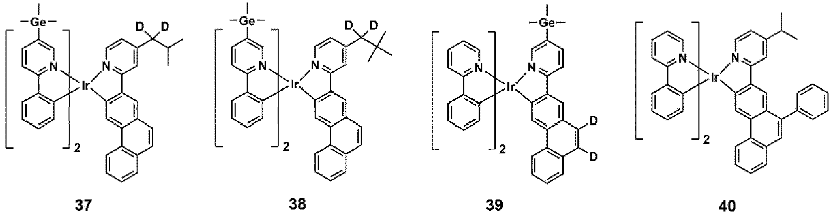

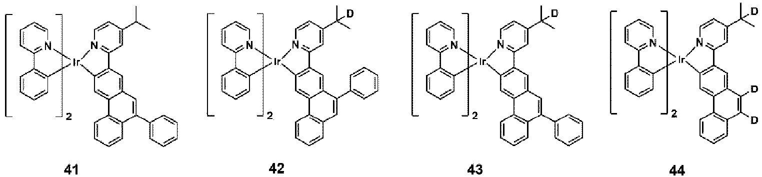

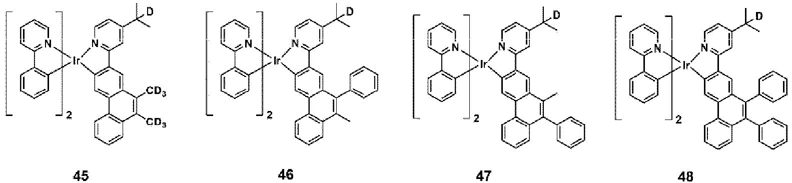

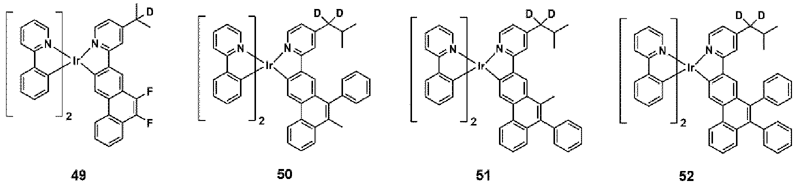

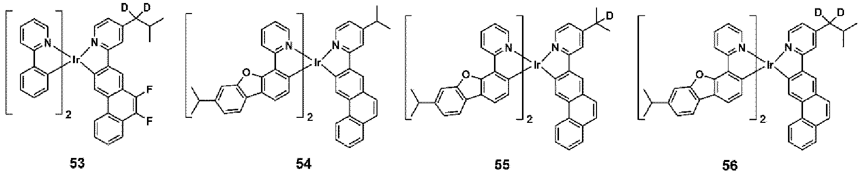

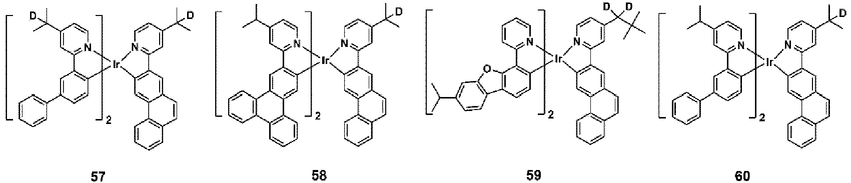

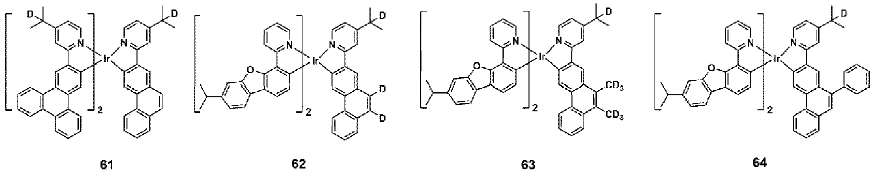

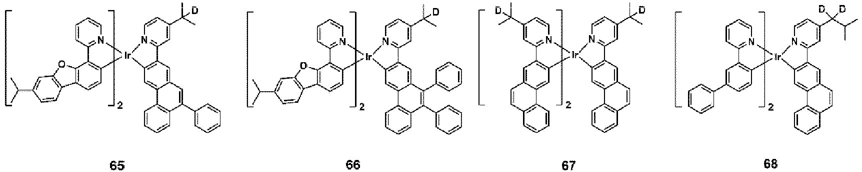

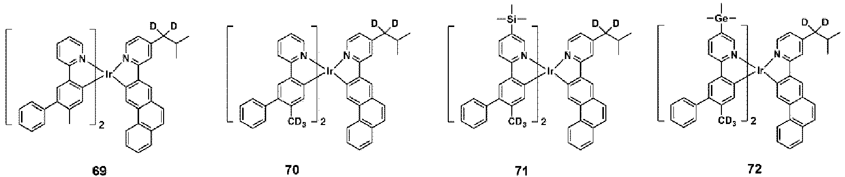

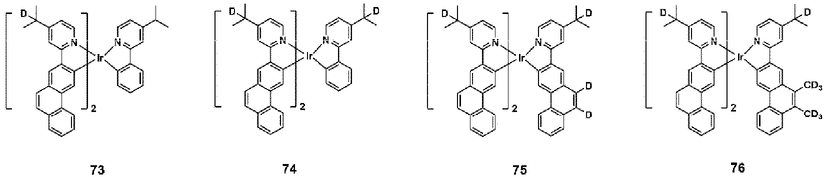

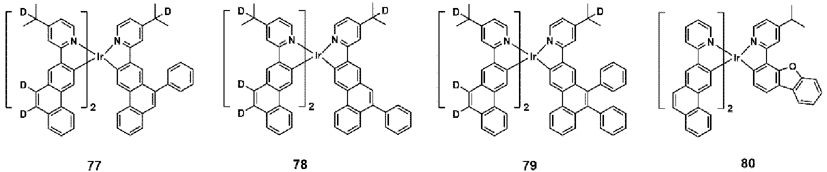

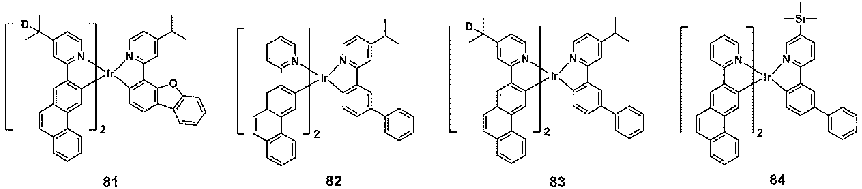

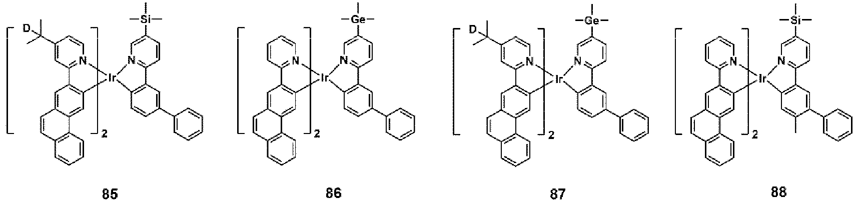

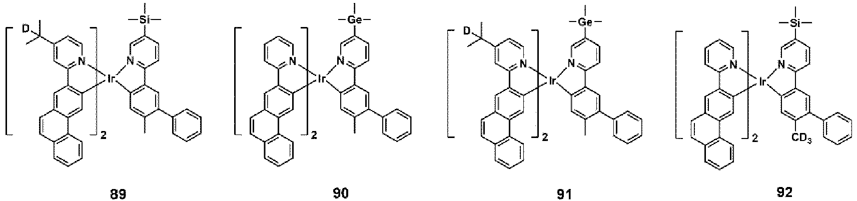

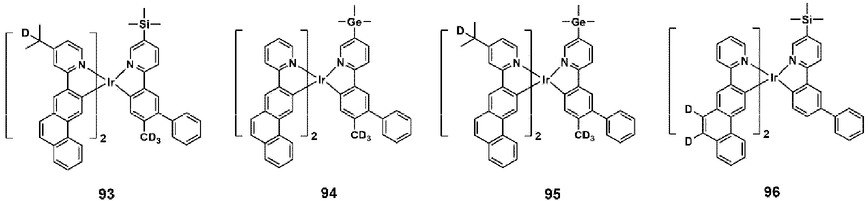

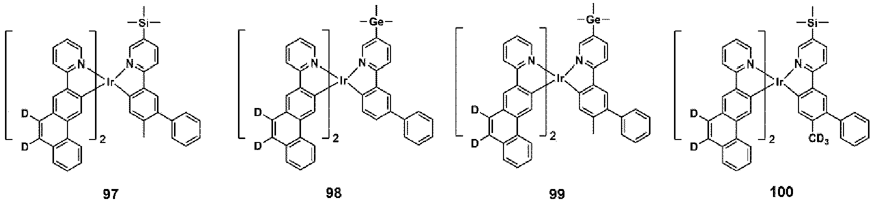

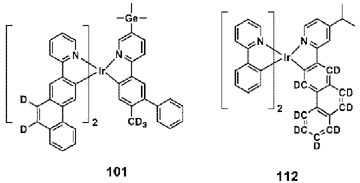

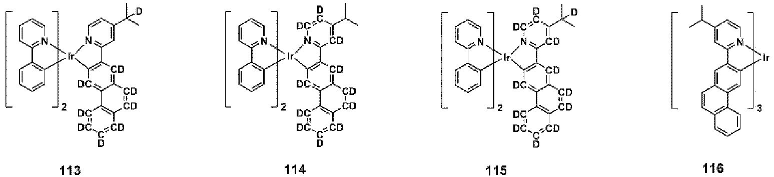

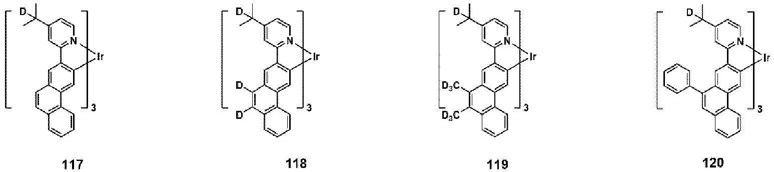

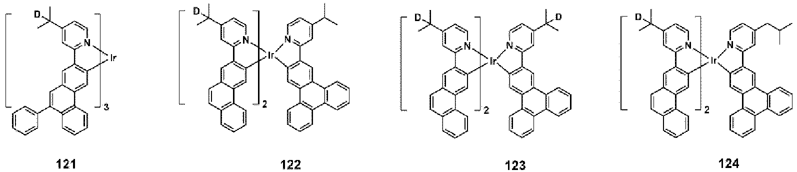

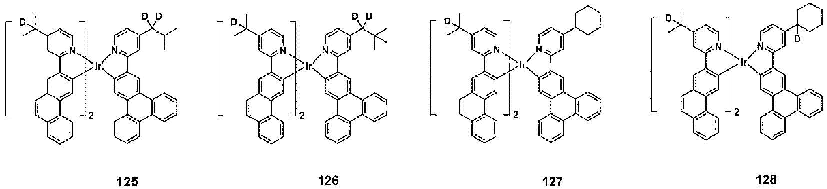

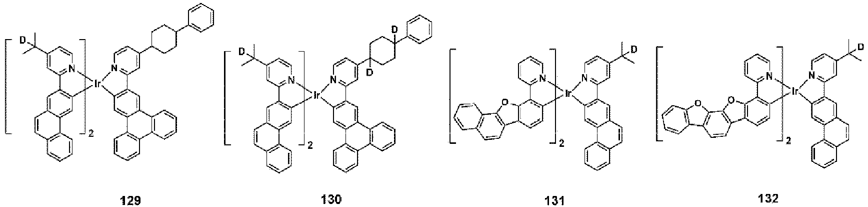

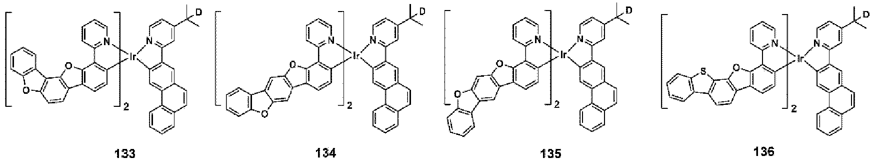

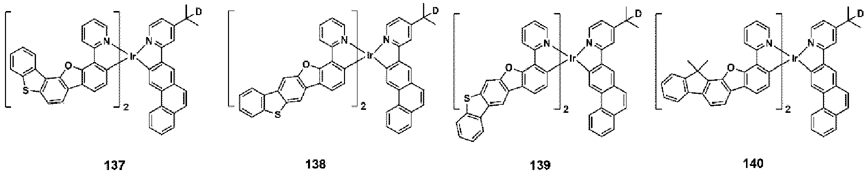

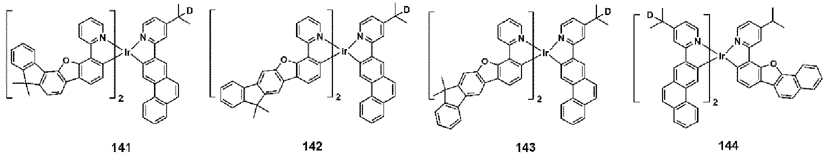

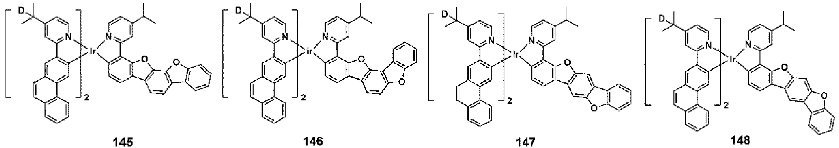

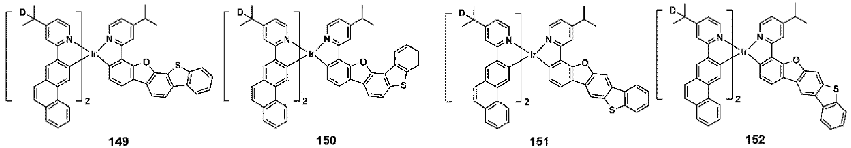

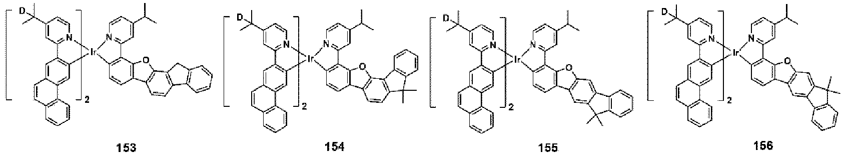

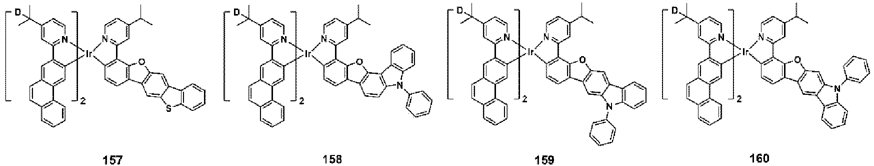

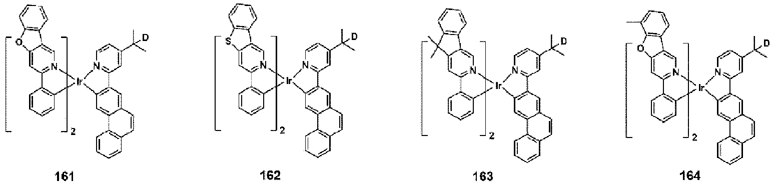

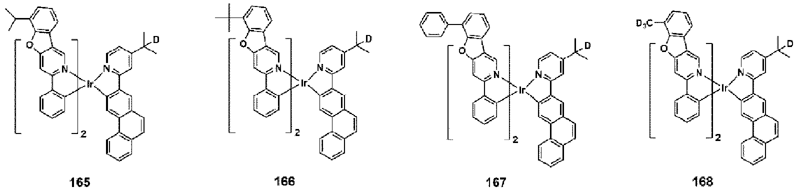

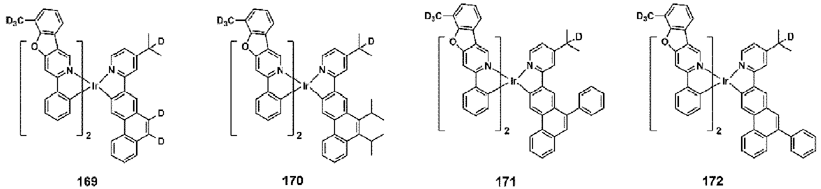

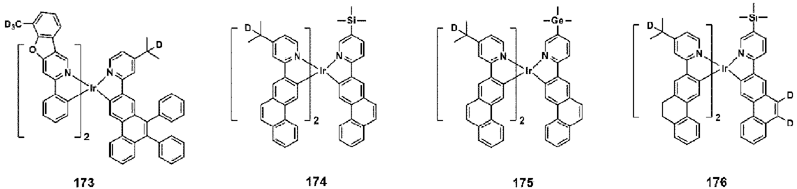

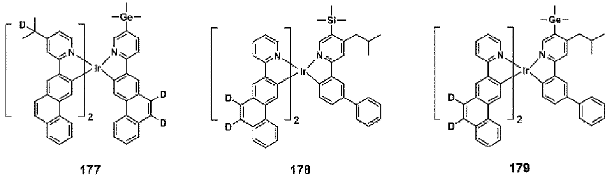

11. Organische lichtemittierende Vorrichtung, umfassend:
eine erste Elektrode;
eine zweite Elektrode; und
eine organische Schicht, die sich zwischen der ersten Elektrode und der zweiten Elektrode befindet,
wobei die organische Schicht eine Emissionsschicht umfasst, und
wobei die organische Schicht zumindest eine von der organometallischen Verbindung nach einem von Anspruch 1 bis 10 umfasst.

12. Organische lichtemittierende Vorrichtung nach Anspruch 11, wobei die Emissionsschicht die organometallische Verbindung umfasst.

13. Organische lichtemittierende Vorrichtung nach Anspruch 12, wobei
die Emissionsschicht ferner einen Wirt umfasst, und
die Menge des Wirts in der Emissionsschicht größer als die Menge der organometallischen Verbindung in der Emissionsschicht ist;
wobei bevorzugt
die Emissionsschicht grünes Licht mit einer maximalen Emissionswellenlänge von 500 Nanometern bis 600 Nanometern emittiert.

14. Organische lichtemittierende Vorrichtung nach Anspruch 12 oder 13, wobei
die erste Elektrode eine Anode ist,
die zweite Elektrode eine Kathode ist,
die organische Schicht ferner eine Lochtransportregion, die sich zwischen der ersten Elektrode und der Emissionsschicht befindet, und eine Elektronentransportregion, die sich zwischen der Emissionsschicht und der zweiten Elektrode befindet, umfasst, wobei
die Lochtransportregion eine Locheinspritzschicht, eine Lochtransportschicht, eine Elektronenblockierschicht, eine Pufferschicht oder eine Kombination davon umfasst, und
die Elektronentransportregion eine Lochblockierschicht, eine Elektronentransportschicht, eine Elektroneneinspritzschicht oder eine Kombination davon umfasst.

15. Diagnostische Zusammensetzung, umfassend zumindest eine von der metallorganischen Verbindung nach einem der Ansprüche 1 bis 10.

## Revendications

1. Composé organométallique représenté par la Formule 1 :
Formule 1 M₁(Ln₁)ₙ₁(Ln₂)ₙ₂
dans lequel, dans la Formule 1,
M₁ est l'iridium (Ir), le platine (Pt), l'osmium (Os) ou le rhodium (Rh),
Ln₁ est un ligand représenté par la Formule 1A,
Ln₂ est un ligand représenté par la Formule 1B,
n1 vaut 0, 1 ou 2, et
n2 vaut 1, 2 ou 3, 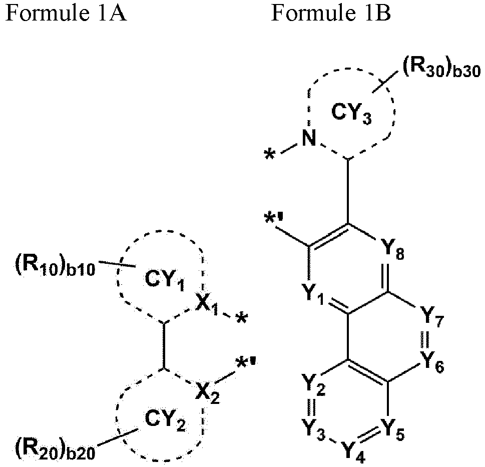 dans lequel, dans les Formules 1A et 1B,
X₁ est C ou N, et X₂ est C ou N,
Y₁ est C(R₄₁) ou N, Y₂ est C(R₄₂) ou N, Y₃ est C(R₄₃) ou N, Y₄ est C(R₄₄) ou N, Y₅ est C(R₄₅) ou N, Y₆ est C(R₄₆) ou N, Y₇ est C(R₄₇) ou N, Y₈ est C(R₄₈) ou N,
CY₁ et CY₂ sont chacun indépendamment un groupe carbocyclique en C₅-C₃₀ ou un groupe hétérocyclique en C₁-C₃₀,
CY₃ est un groupe hétérocyclique en C₁-C₃₀ comprenant l'azote,
R₁₀, R₂₀ et R₄₁ à R₄₈ sont chacun indépendamment un hydrogène, un deutérium, - F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, -SF₅, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe alkylthio en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₂-C₁₀ substitué ou non substitué, un groupe aryle en C₆-C₆₀ substitué ou non substitué, un groupe alkylaryle en C₇-C₆₀ substitué ou non substitué, un groupe arylalkyle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe hétéroarylalkyle en C₂-C₆₀ substitué ou non substitué, un groupe hétéroaryloxy en C₁-C₆₀ substitué ou non substitué, un groupe hétéroarylthio en C₁-C₆₀ substitué ou non substitué, un groupe polycyclique condensé non aromatique monovalent substitué ou non substitué, un groupe hétéropolycyclique condensé non aromatique monovalent substitué ou non substitué, -Si(Q₁)(Q₂)(Q₃), -Ge(Q₁)(Q₂)(Q₃), -N(Q₄)(Q₅), -B(Q₆)(Q₇), -P(Q₈)(Q₉) ou -P(=O)(Q₈)(Q₉),
R₃₀ est un hydrogène, un groupe alkyle en C₂-C₆₀, un groupe alkyle en C₂-C₆₀ substitué par un deutérium ou-Ge(Q₁)(Q₂)(Q₃),
deux d'une pluralité de R₁₀ ou plus sont éventuellement liés les uns aux autres pour former un groupe carbocyclique en C₅-C₃₀ substitué ou non substitué ou un groupe hétérocyclique en C₁-C₃₀ substitué ou non substitué,
deux d'une pluralité de R₂₀ ou plus sont éventuellement liés les uns aux autres pour former un groupe carbocyclique en C₅-C₃₀ substitué ou non substitué ou un groupe hétérocyclique en C₁-C₃₀ substitué ou non substitué,
deux d'une pluralité de R₃₀ ou plus sont éventuellement liés les uns aux autres pour former un groupe carbocyclique en C₅-C₃₀ substitué ou non substitué ou un groupe hétérocyclique en C₁-C₃₀ substitué ou non substitué,
deux substituants voisins ou plus de R₁₀, R₂₀ et R₃₀ sont éventuellement liés les uns aux autres pour former un groupe carbocyclique en C₅-C₃₀ substitué ou non substitué ou un groupe hétérocyclique en C₁-C₃₀ substitué ou non substitué,
b10, b20 et b30 valent chacun indépendamment 1, 2, 3, 4, 5, 6, 7, 8, 9 ou 10,
au moins un substituant du groupe carbocyclique en C₅-C₃₀ substitué, du groupe hétérocyclique en C₁-C₃₀ substitué, du groupe alkyle en C₁-C₆₀ substitué, du groupe alkyle en C₂-C₆₀ substitué, du groupe alcényle en C₂-C₆₀ substitué, du groupe alcynyle en C₂-C₆₀ substitué, du groupe alcoxy en C₁-C₆₀ substitué, du groupe alkylthio en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₂-C₁₀ substitué, du groupe aryle en C₆-C₆₀ substitué, du groupe alkylaryle en C₇-C₆₀ substitué, du groupe arylalkyle en C₈-C₆₀ substitué, du groupe arylalkyle en C₇-C₆₀ substitué, du groupe aryloxy en C₆-C₆₀ substitué, du groupe arylthio en C₆-C₆₀ substitué, du groupe hétéroaryle en C₁-C₆₀ substitué, du groupe alkylhétéroaryle en C₂-C₆₀ substitué, du groupe hétéroarylalkyle en C₂-C₆₀ substitué, du groupe hétéroarylalkyle en C₃-C₆₀ substitué, du groupe hétéroaryloxy en C₁-C₆₀ substitué, du groupe hétéroarylthio en C₁-C₆₀ substitué, du groupe polycyclique condensé non aromatique monovalent substitué et du groupe hétéropolycyclique condensé non aromatique monovalent substitué est :
un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀ ou un groupe alcoxy en C₁-C₆₀ ;
un groupe alkyle en C₁-C₆₀, un groupe alcényle en C₂-C₆₀, un groupe alcynyle en C₂-C₆₀, ou un groupe alcoxy en C₁-C₆₀, chacun étant substitué par l'un ou plusieurs parmi un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃-C₁₀, un groupe hétérocycloalkyle en C₁-C₁₀, un groupe cycloalcényle en C₃-C₁₀, un groupe hétérocycloalcényle en C₂-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe hétéroaryloxy en C₁-C₆₀, un groupe hétéroarylthio en C₁-C₆₀, un groupe polycyclique condensé non aromatique monovalent, un groupe hétéropolycyclique condensé non aromatique monovalent, -Si(Q₁₁)(Q₁₂)(Q₁₃), - Ge(Q₁₁)(Q₁₂)(Q₁₃), -N(Q₁₄)(Q₁₅), -B(Q₁₆)(Q₁₇), -P(Q₈)(Q₉) ou -P(=O)(Q₁₈)(Q₁₉) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₂-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe hétéroaryloxy en C₁-C₆₀, un groupe hétéroarylthio en C₁-C₆₀, un groupe polycyclique condensé non aromatique monovalent ou un groupe hétéropolycyclique condensé non aromatique monovalent ;
un groupe cycloalkyle en C₃-C₁₀, un groupe hétérocycloalkyle en C₁-C₁₀, un groupe cycloalcényle en C₃-C₁₀, un groupe hétérocycloalcényle en C₂-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, ou un groupe hétéropolycyclique condensé non aromatique monovalent, chacun étant substitué par l'un ou plusieurs parmi un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀, un groupe alkylthio en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₂-C₁₀, un groupe aryle en C₆-C₆₀, un groupe alkylaryle en C₇-C₆₀, un groupe arylalkyle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroarylalkyle en C₂-C₆₀, un groupe hétéroaryloxy en C₁-C₆₀, un groupe hétéroarylthio en C₁-C₆₀, un groupe polycyclique condensé non aromatique monovalent, un groupe hétéropolycyclique condensé non aromatique monovalent, -Si(Q₂₁)(Q₂₂)(Q₂₃), -Ge(Q₂₁)(Q₂₂)(Q₂₃), -N(Q₂₄)(Q₂₅), -B(Q₂₆)(Q₂₇), -P(Q₂₈)(Q₂₉) ou -P(=O)(Q₂₈)(Q₂₉) ; ou
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), -P(Q₃₈)(Q₃₉), ou - P(=O)(Q₃₈)(Q₃₉),
dans lequel Q₁ à Q₉, Q₁₁ à Q₁₉, Q₂₁ à Q₂₉ et Q₃₁ à Q₃₉ sont chacun indépendamment un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe alkylthio en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₂-C₁₀ substitué ou non substitué, un groupe aryle en C₆-C₆₀ substitué ou non substitué, un groupe alkylaryle en C₇-C₆₀ substitué ou non substitué, un groupe arylalkyle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe hétéroarylalkyle en C₂-C₆₀ substitué ou non substitué, un groupe hétéroaryloxy en C₁-C₆₀ substitué ou non substitué, un groupe hétéroarylthio en C₁-C₆₀ substitué ou non substitué, un groupe polycyclique condensé non aromatique monovalent substitué ou non substitué ou un groupe hétéropolycyclique condensé non aromatique monovalent substitué ou non substitué, et
dans lequel * et *' indiquent chacun un site de liaison à M₁.

2. Composé organométallique de la revendication 1, dans lequel M₁ est Ir, et la somme de n1 et n2 vaut 3.

3. Composé organométallique de l'une des revendications 1 ou 2, dans lequel CY₁ et CY₂ sont chacun indépendamment :
un groupe cyclopentane, un groupe cyclohexane, un groupe cycloheptane, un groupe cyclopentène, un groupe cyclohexène, un groupe cycloheptène, un groupe phényle, un groupe naphtalène, un groupe 1,2,3,4-tétrahydronaphtalène, un groupe anthracène, un groupe phénanthrène, un groupe triphénylène, un groupe pyrène, un groupe chrysène, un groupe cyclopentadiène, un groupe thiophène, un groupe furane, un groupe indole, un groupe benzoborole, un groupe benzophosphole, un groupe indène, un groupe benzosilole, un groupe benzogermole, un groupe benzothiophène, un groupe benzosélénophène, un groupe benzofurane, un groupe carbazole, un groupe dibenzoborole, un groupe dibenzophosphole, un groupe fluorène, un groupe dibenzosilole, un groupe dibenzogermole, un groupe dibenzothiophène, un groupe dibenzosélénophène, un groupe dibenzofurane, un groupe 5-oxyde de dibenzothiophène, un groupe 9H-fluorène-9-one, un groupe 5,5-dioxyde de dibenzothiophène, un groupe azaindole, un groupe azabenzoborole, un groupe azabenzophosphole, un groupe azaindène, un groupe azabenzosilole, un groupe azabenzogermole, un groupe azabenzothiophène, un groupe azabenzosélénophène, un groupe azabenzofurane, un groupe azacarbazole, un groupe azadibenzoborole, un groupe azadibenzophosphoIe, un groupe azafluorène, un groupe azadibenzosilole, un groupe azadibenzogermole, un groupe azadibenzothiophène, un groupe azadibenzosélénophène, un groupe azadibenzofurane, un groupe 5-oxyde d'azadibenzothiophène, un groupe aza-9H-fluorène-9-one, un groupe 5,5-dioxyde d'azadibenzothiophène, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénantroline, un groupe pyrrole, un groupe pyrazole, un groupe imidazole, un groupe triazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe 5,6,7,8-tétrahydroisoquinoléine ou un groupe 5,6,7,8-tétrahydroquinoléine ; ou
un groupe représenté par la Formule 8-1 ou 8-2 : 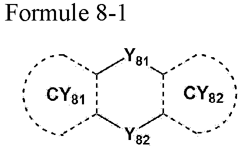 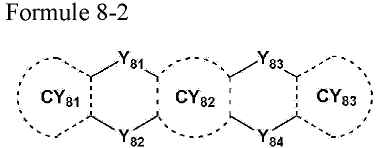 dans lequel, dans les Formules 8-1 et 8-2,
Y₈₁ à Y₈₄ sont chacun indépendamment une liaison simple, O, S, N(R₈₁), C(R₈₁)(R₈₂), Si(R₈₁)(R₈₂), C(=O), S(=O), S(=O)₂, B(R₈₁), P(R₈₁) ou P(=O)(R₈₁),
CY₈₁ à CY₈₃ sont chacun indépendamment un groupe phényle, un groupe naphtalène, un groupe 1,2,3,4-tétrahydronaphtalène, un groupe phénanthrène, un groupe pyridine, un groupe pyrimidine, un groupe pyrazine, un groupe triazine, un groupe quinoléine, un groupe isoquinoléine, un groupe quinoxaline, un groupe quinazoline, un groupe phénanthroline, un groupe benzofurane, un groupe benzothiophène, un groupe fluorène, un groupe carbazole, un groupe dibenzofurane, un groupe dibenzothiophène, un groupe dibenzosilole, un groupe azafluorène, un groupe azacarbazole, un groupe azadibenzofurane, un groupe azadibenzothiophène ou un groupe azadibenzosilole, et
R₈₁ et R₈₂ sont chacun indépendamment tels que décrits en relation avec R₁₀ et R₂₀ dans la revendication 1 ; et/ou dans lequel
CY₃ est un groupe pyridine, un groupe pyrimidine, un groupe pyrazine, un groupe triazine, un groupe quinoléine, un groupe isoquinoléine, un groupe quinoxaline ou un groupe quinazoline.

4. Composé organométallique de l'une quelconque des revendications 1 à 3, dans lequel
R₁₀, R₂₀ et R₄₁ à R₄₈ sont chacun indépendamment : un hydrogène, un deutérium, -F, -Cl, -Br, -I, -CD₃, -CD₂H, -CDH₂, -CF₃, -CF₂H, -CFH₂, -SF₅, un groupe alkyle en C₁-C₆₀, un groupe alcényle en C₂-C₆₀, un groupe alcynyle en C₂-C₆₀, un groupe alcoxy en C₁-C₆₀, -Si(Q₁)(Q₂)(Q₃) ou -Ge(Q₁)(Q₂)(Q₃) ; ou
un groupe représenté par l'une des Formules 9-1 à 9-61, 9-201 à 9-237, 10-1 à 10-141 ou 10-201 à 10-350 : 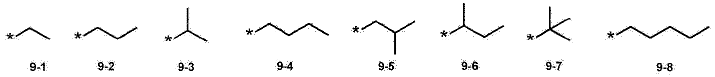 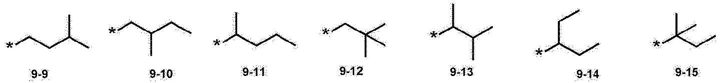 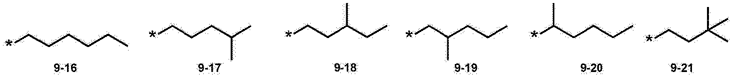 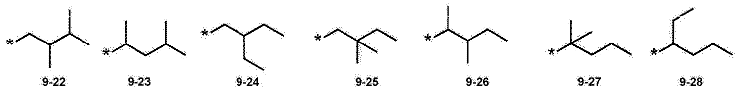 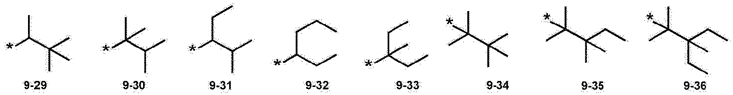 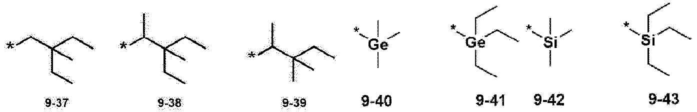 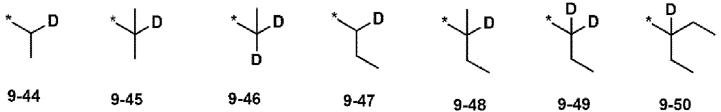 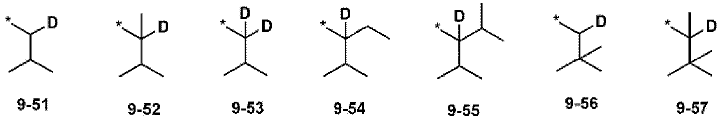 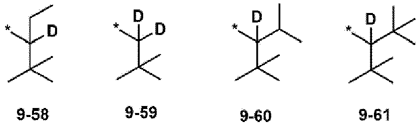 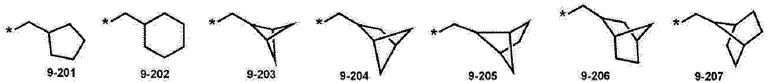 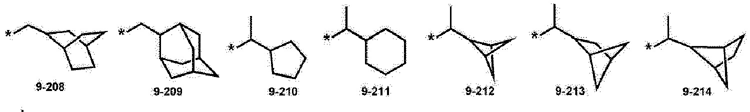 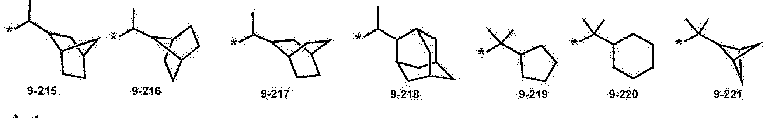 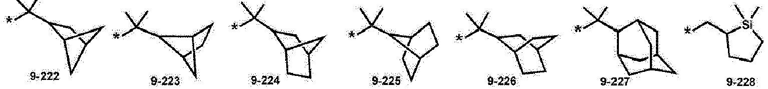 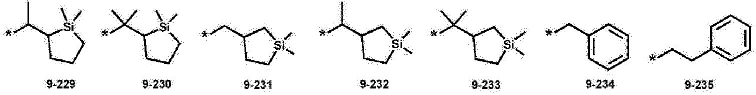 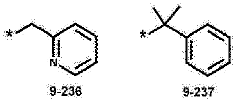 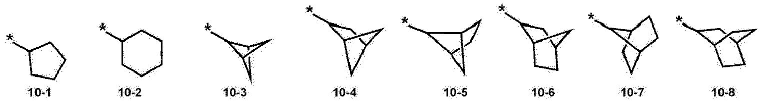 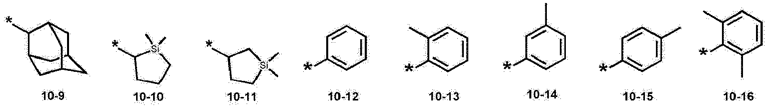 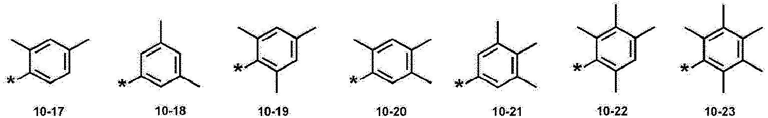 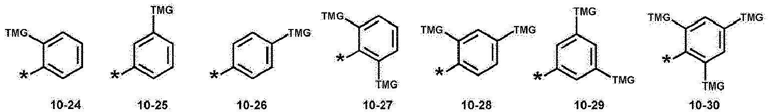 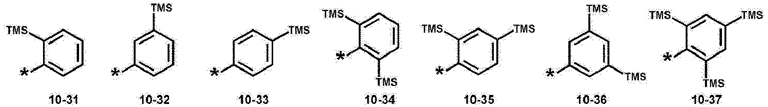 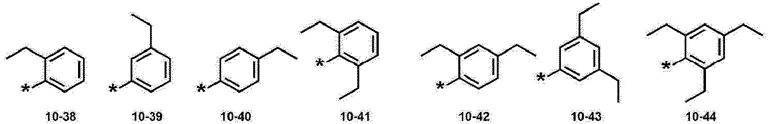 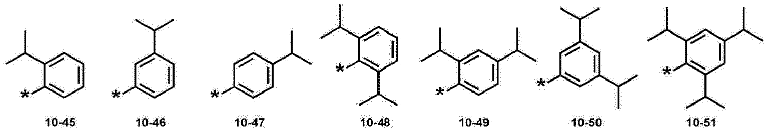 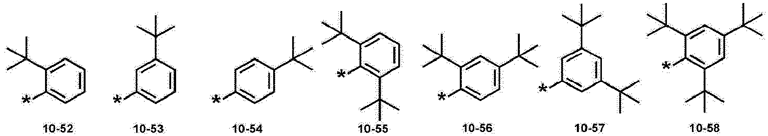 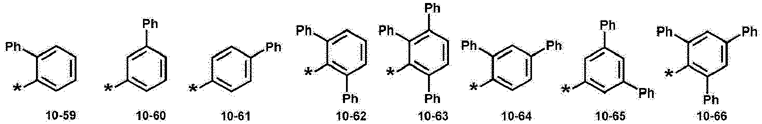 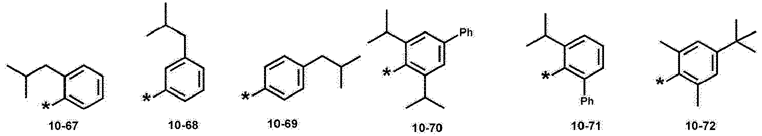 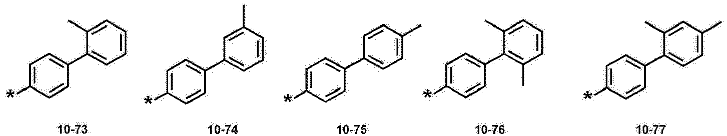 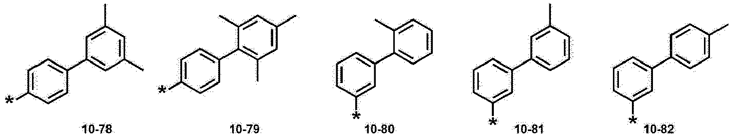 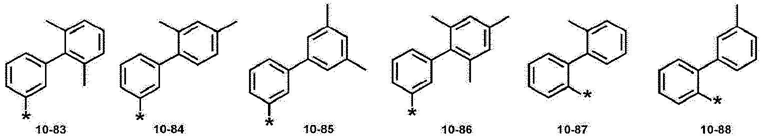 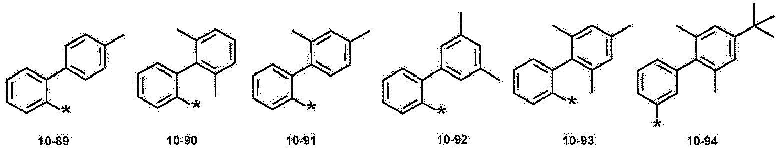 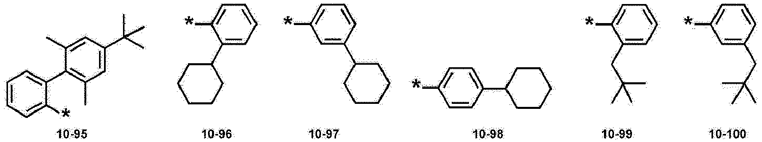 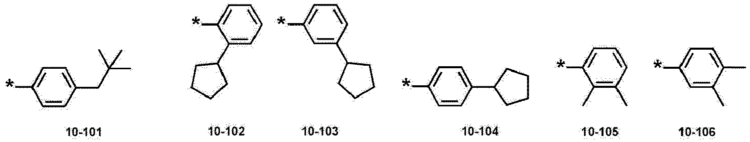 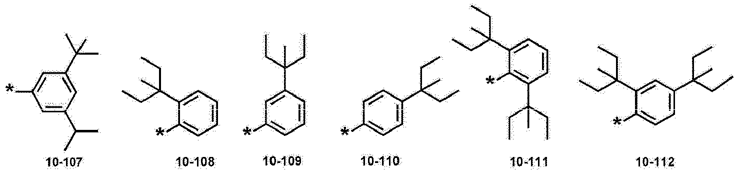 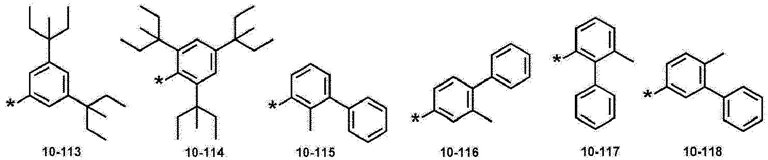 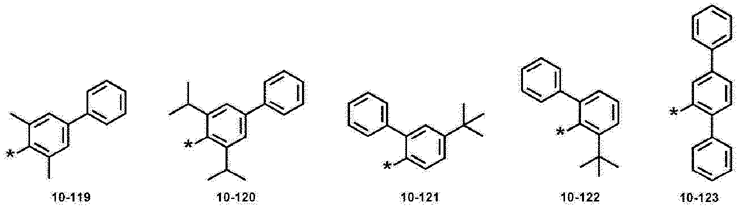 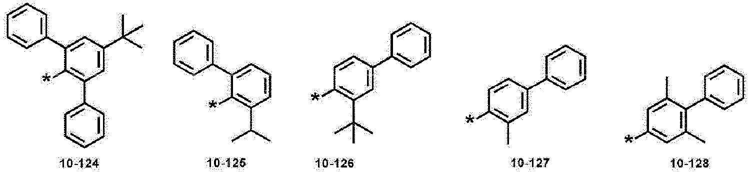 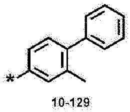 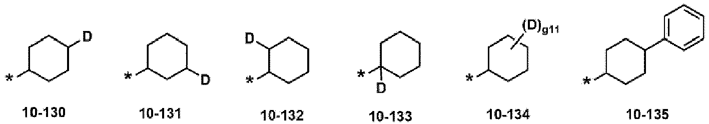 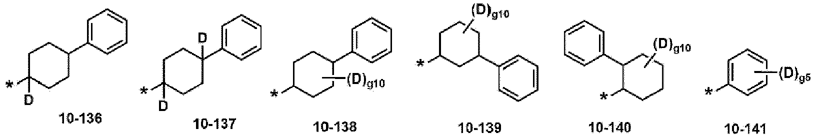 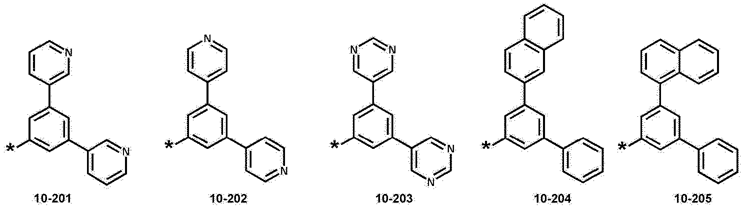 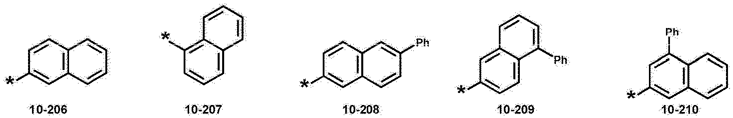 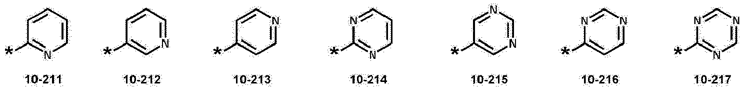 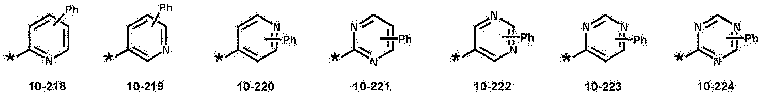 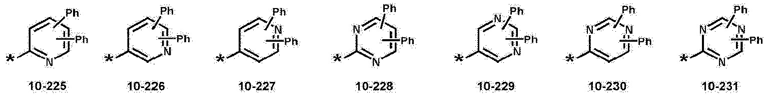 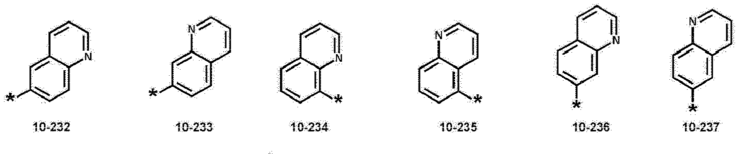 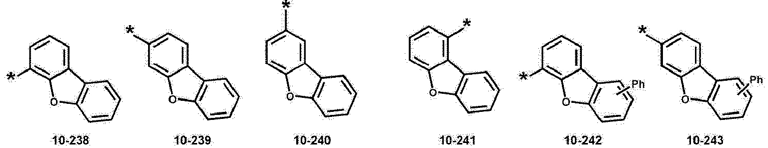 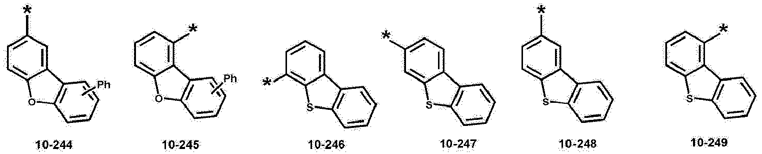 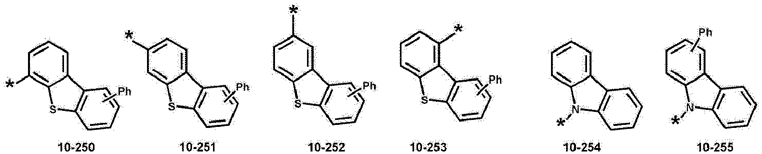 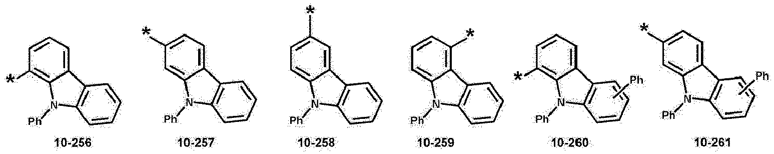 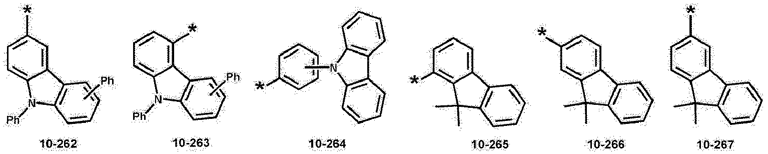 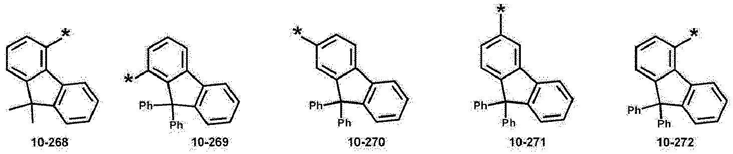 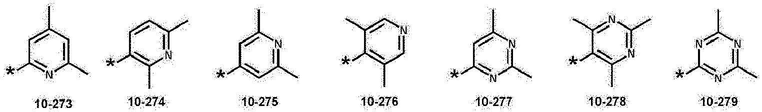 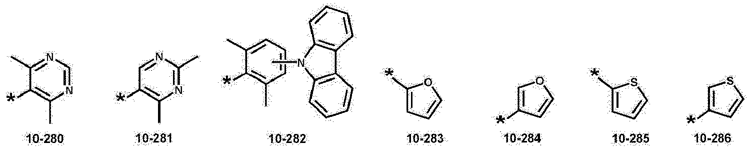 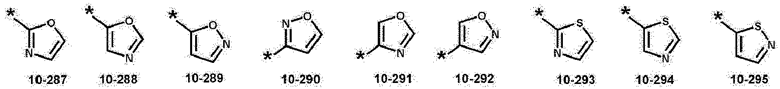 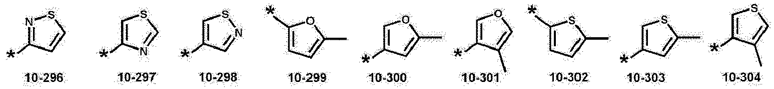 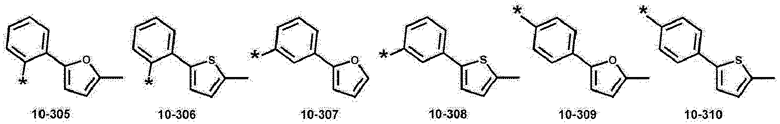 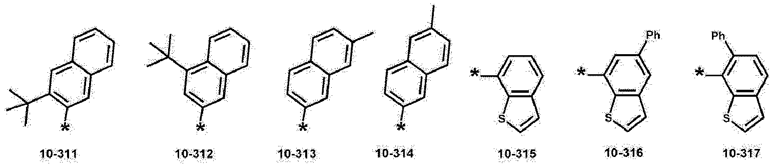 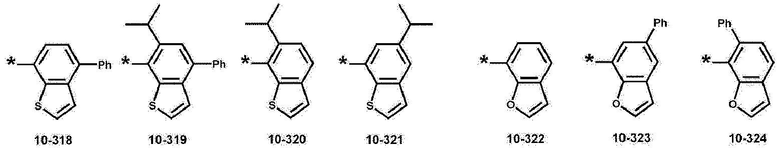 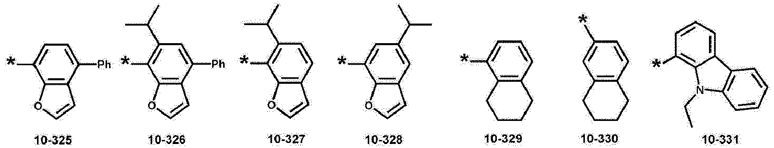 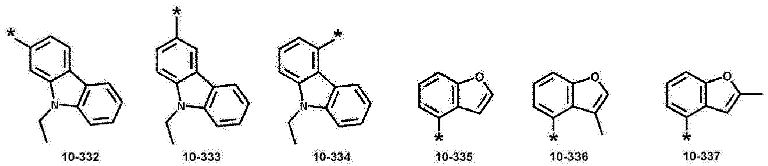 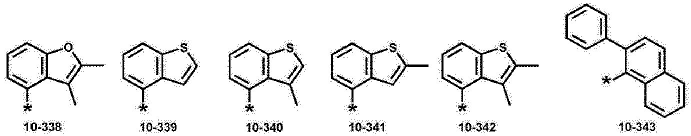 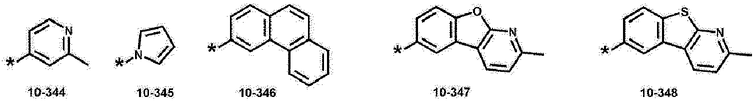 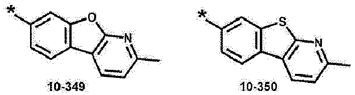 dans lequel, dans les Formules 9-1 à 9-61, 9-201 à 9-237, 10-1 à 10-141 ou 10-201 à 10-350,
* indique un site de liaison à un atome voisin,
Ph est un groupe phényle,
TMS est un groupe triméthylsilyle,
TMG est un groupe triméthylgermyle,
g5 est un entier de 1 à 5,
g10 est un entier de 1 à 10, et
g11 est un entier de 1 à 11.

5. Composé organométallique de l'une quelconque des revendications 1 à 4, dans lequel R₃₀ est un groupe représenté par l'une des Formules 9-1 à 9-61 : 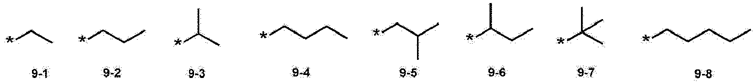 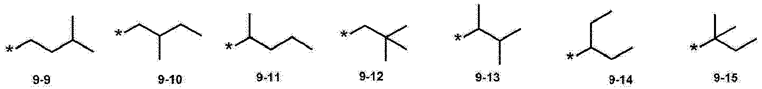 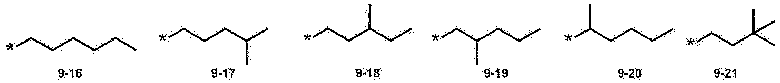 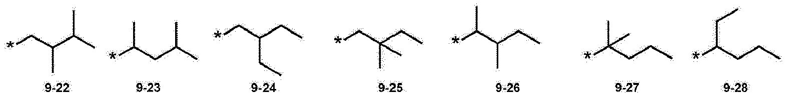 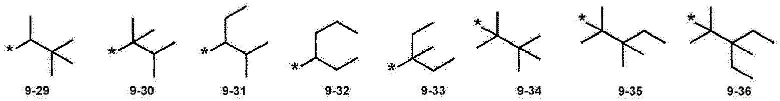 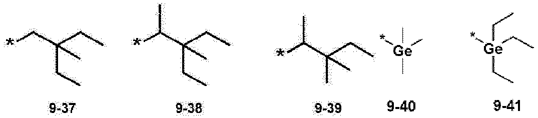 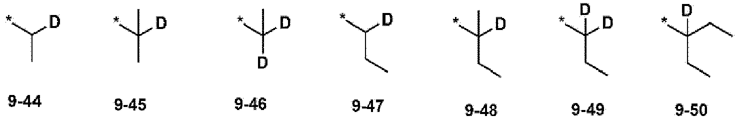 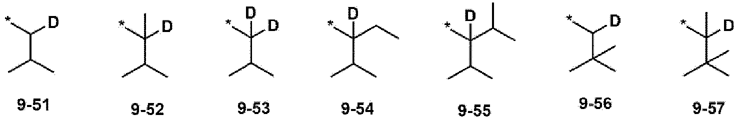 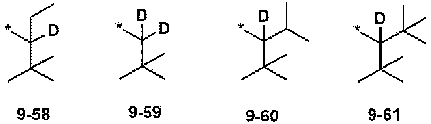 dans lequel, dans les Formules 9-1 à 9-61,
* indique un site de liaison à un atome voisin.

6. Composé organométallique de l'une quelconque des revendications 1 à 5, dans lequel CY₁ est représenté par l'une des Formules 1-1 à 1-16 : 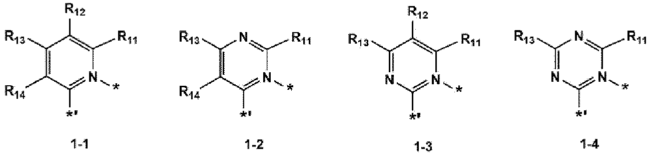 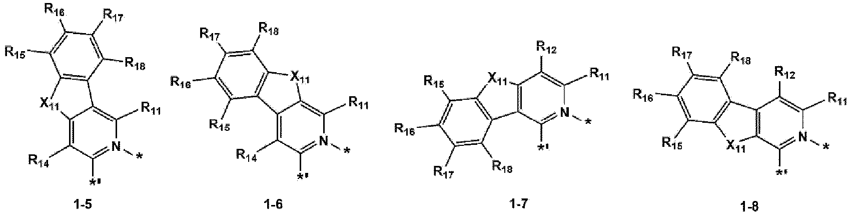 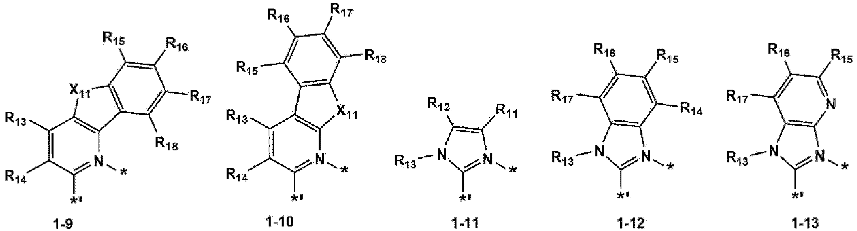 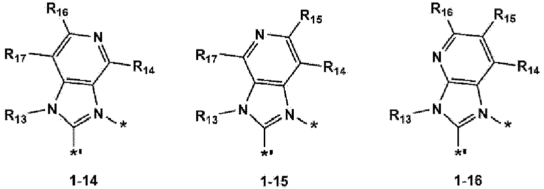 dans lequel, dans les Formules 1-1 à 1-16,
X₁₁ est O, S, N(R₁₉ₐ), C(R₁₉ₐ)(R_{19b}), ou Si(R₁₉ₐ)(R_{19b}),
R₁₁ à R₁₈, R₁₉ₐ et R_{19b} sont chacun indépendamment tels que décrits en relation avec R₁₀ dans la revendication 1,
deux substituants voisins ou plus de R₁₁ à R₁₈, R₁₉ₐ ou R_{19b} sont éventuellement liés les uns aux autres pour former un groupe carbocyclique en C₅-C₃₀ substitué ou non substitué ou un groupe hétérocyclique en C₁-C₃₀ substitué ou non substitué, et
dans lequel, lorsque R₁₁ à R₁₈, R₁₉ₐ ou R_{19b} est -Si(Q₁)(Q₂)(Q₃) ou -Ge(Q₁)(Q₂)(Q₃), Q₁ à Q₃ sont chacun indépendamment :
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, ou -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle ; ou
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle, chacun étant substitué par l'un ou plusieurs parmi un deutérium, un groupe alkyle en C₁-C₁₀ ou un groupe phényle,
* indique un site de liaison à M₁, et
*' indique un site de liaison à CY₂ ; et/ou
dans lequel
CY₂ est représenté par l'une des Formules 2-1 à 2-22 : 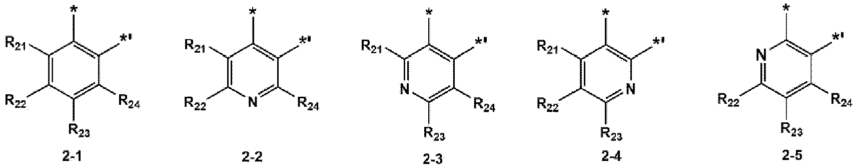 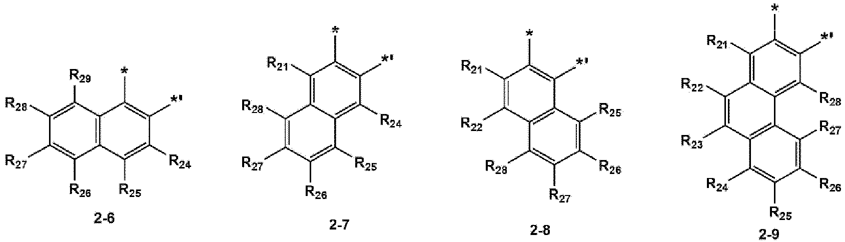 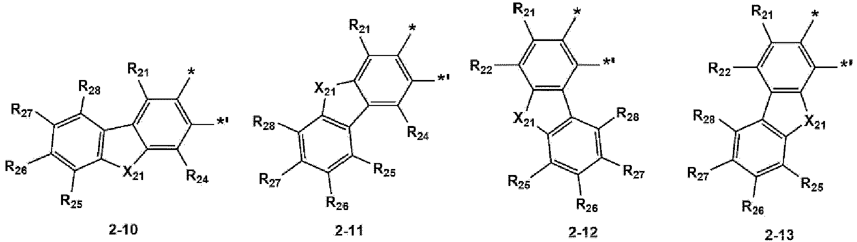 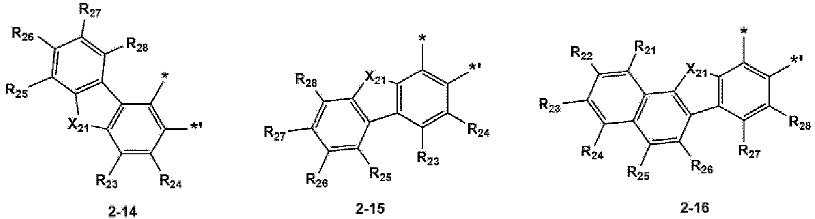 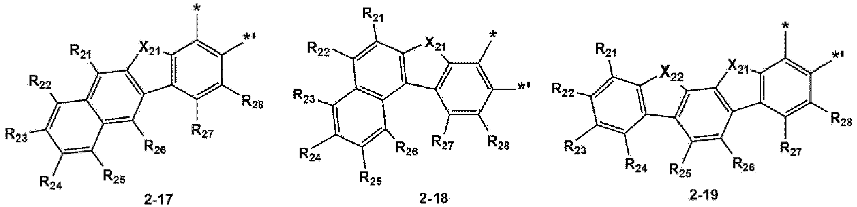 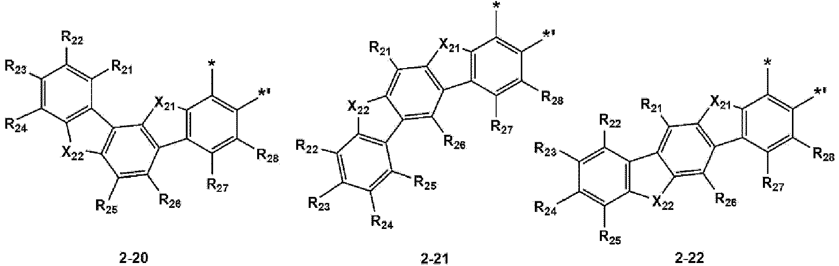 dans lequel, dans les Formules 2-1 à 2-22,
X₂₁ et X₂₂ sont chacun indépendamment O, S, N(R₂₉ₐ), C(R₂₉ₐ)(R_{29b}) ou Si(R₂₉ₐ)(R_{29b}), R₂₁ à R₂₈, R₂₉ₐ et R_{29b} sont chacun indépendamment tels que décrits en relation avec R₂₀ dans la revendication 1, et
deux substituants voisins ou plus de R₂₁ à R₂₈, R₂₉ₐ et R_{29b} sont éventuellement liés les uns aux autres pour former un groupe carbocyclique en C₅-C₃₀ substitué ou non substitué ou un groupe hétérocyclique en C₁-C₃₀ substitué ou non substitué,
dans lequel, lorsque R₂₁ à R₂₈, R₂₉ₐ ou R_{29b} est -Si(Q₁)(Q₂)(Q₃) ou -Ge(Q₁)(Q₂)(Q₃), Q₁ à Q₃ sont chacun indépendamment :
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, ou -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle ; ou
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle, chacun étant substitué par l'un ou plusieurs parmi un deutérium, un groupe alkyle en C₁-C₁₀ ou un groupe phényle,
* indique un site de liaison à CY₁, et
*' indique un site de liaison à M₁.

7. Composé organométallique de l'une quelconque des revendications 1 à 6, dans lequel CY3 est représenté par l'une des Formules 3-1 à 3-16 : 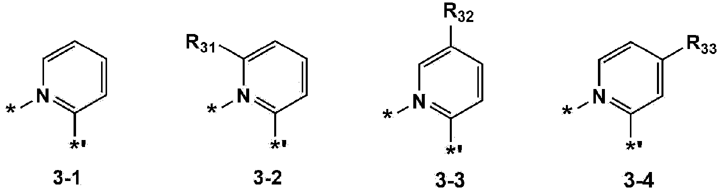 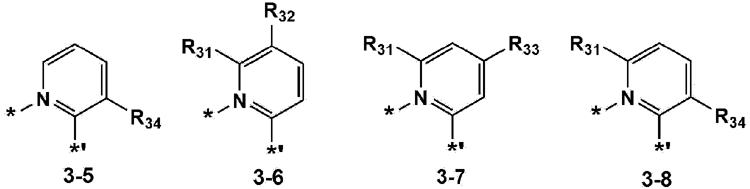 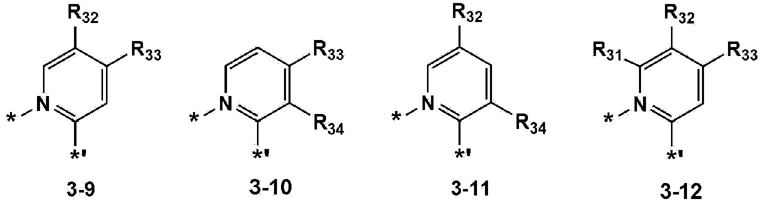 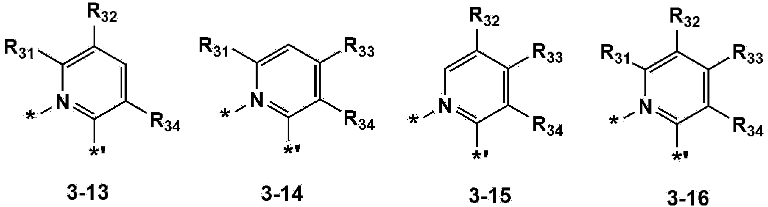 dans lequel, dans les Formules 3-1 à 3-16,
R₃₁ à R₃₄ sont chacun indépendamment tels que décrits en relation avec R₃₀ dans la revendication 1, et
* indique un site de liaison à M₁, et
*' indique un site de liaison à un atome voisin.

8. Composé organométallique de l'une quelconque des revendications 1 à 7, dans lequel le composé organométallique est un composé représenté par la Formule 11-1 : 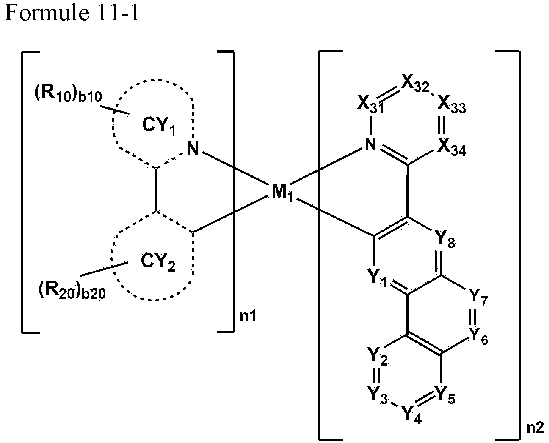 dans lequel, dans la Formule 11-1,
M₁, n1, n2, CY₁, CY₂, Y₁ à Y₈, R₁₀, R₂₀, b10 et b20 sont chacun tels que décrits dans la revendication 1,
X₃₁ est C(R₃₁) ou N, X₃₂ est C(R₃₂) ou N, X₃₃ est C(R₃₃) ou N, et X₃₄ est C(R₃₄) ou N,
R₃₁ à R₃₄ sont chacun indépendamment tels que décrits en relation avec R₃₀ dans la revendication 1, et
deux de R₃₁ à R₃₄ ou plus sont éventuellement liés pour former un groupe carbocyclique en C₅-C₃₀ substitué ou non substitué ou un groupe hétérocyclique en C₁-C₃₀ substitué ou non substitué.

9. Composé organométallique de l'une quelconque des revendications 1 à 8, dans lequel le composé organométallique est un composé représenté par la Formule 12-1 : 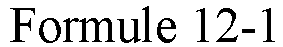 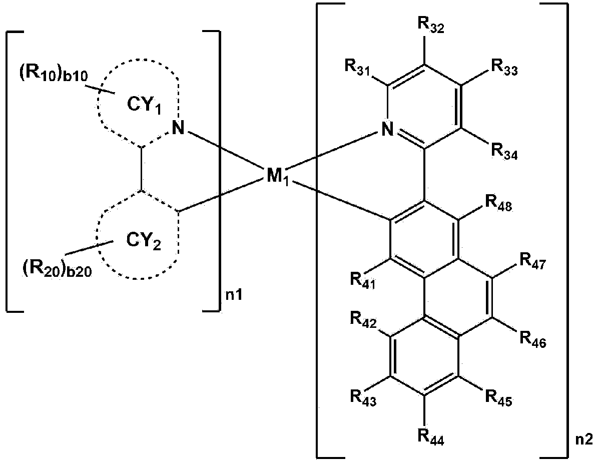 dans lequel, dans la Formule 12-1,
M₁, n1, n2, CY₁, CY₂, R₁₀, R₂₀, b10, b20 et R₄₁ à R₄₈ sont chacun tels que décrits dans la revendication 1, et
R₃₁ à R₃₄ sont chacun indépendamment tels que décrits en relation avec R₃₀ dans la revendication 1.

10. Composé organométallique de l'une quelconque des revendications 1 à 9, dans lequel le composé organométallique est électriquement neutre ; et/ou
dans lequel le composé organométallique est l'un quelconque des composés 1 à 7, 9 à 101 et 112 à 179 :

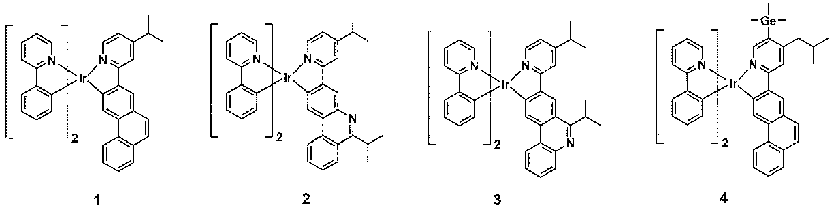

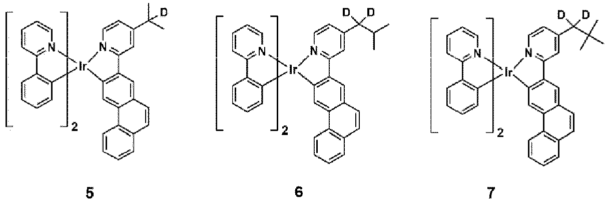

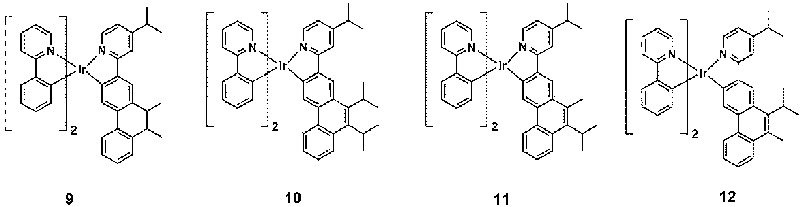

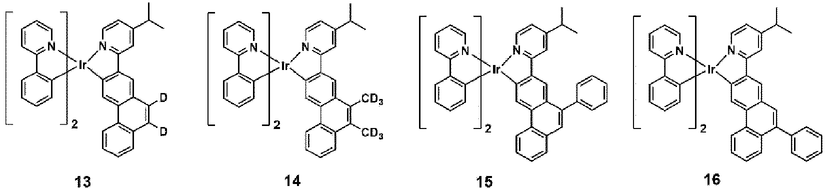

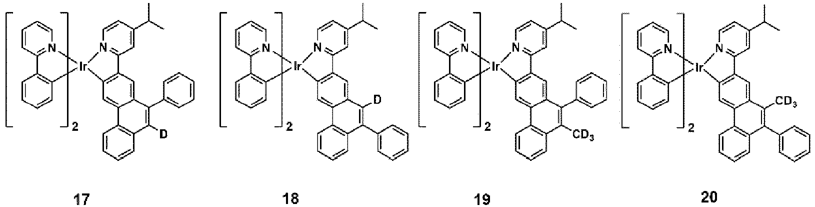

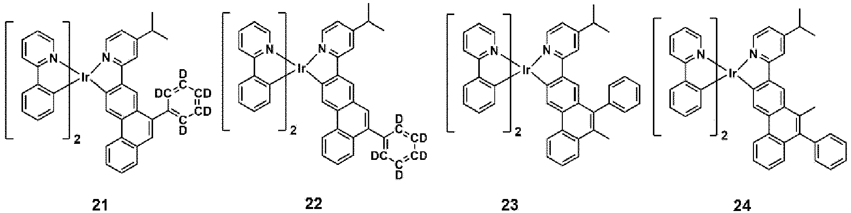

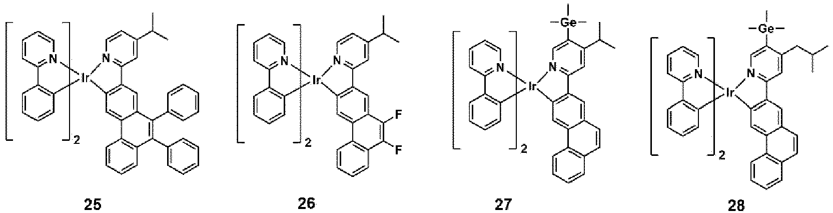

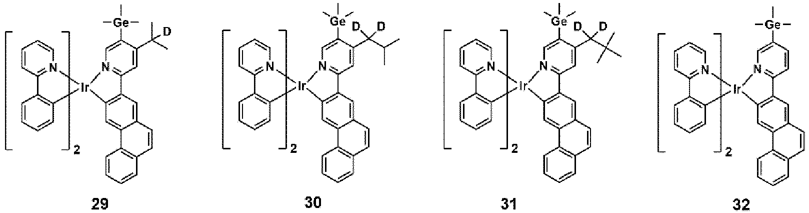

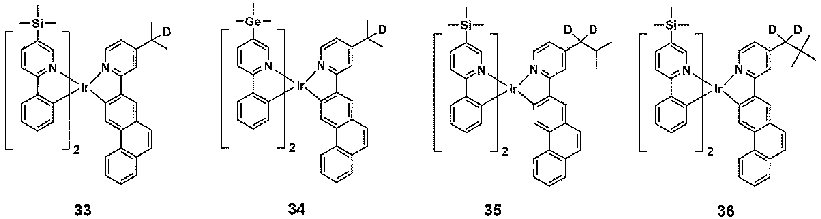

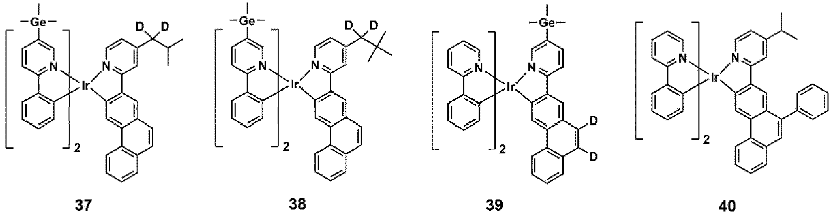

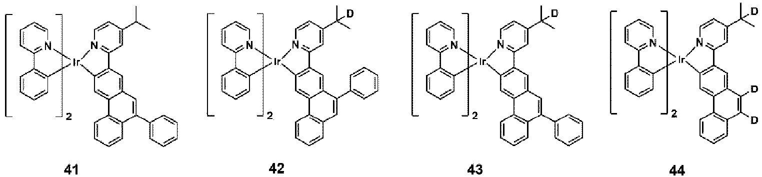

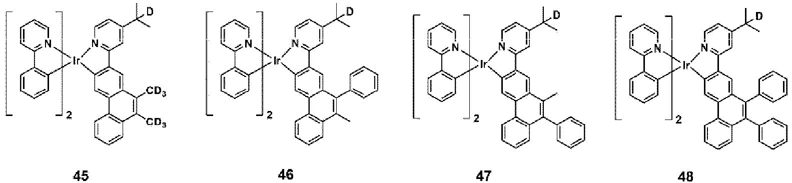

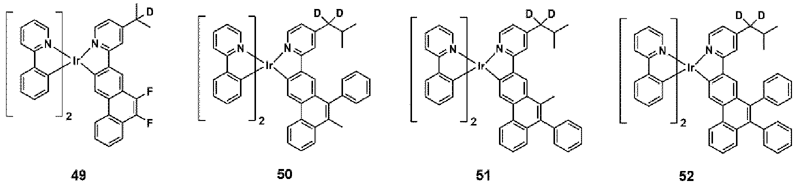

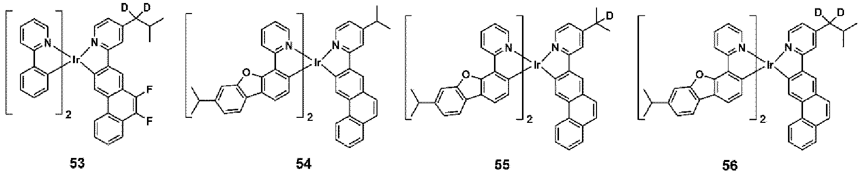

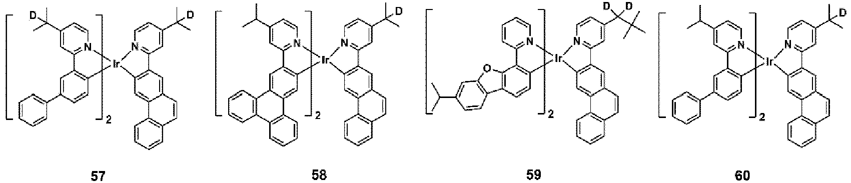

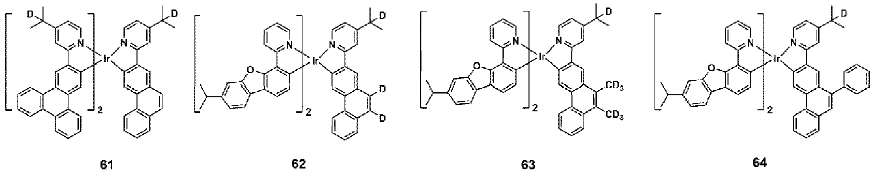

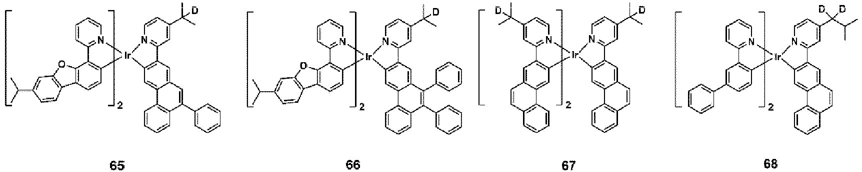

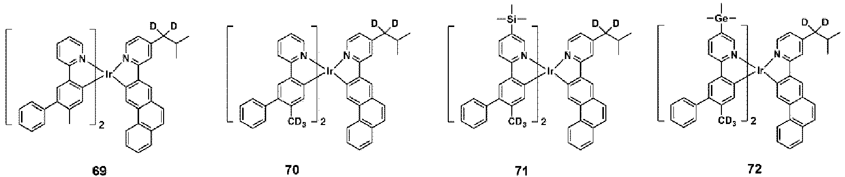

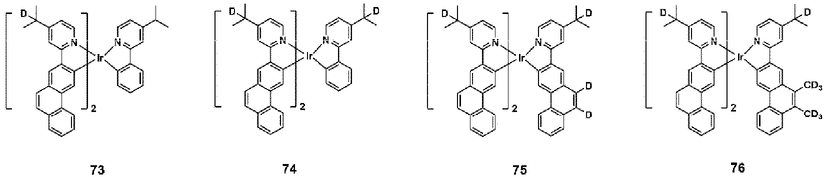

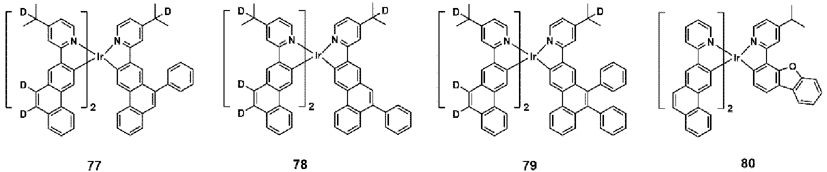

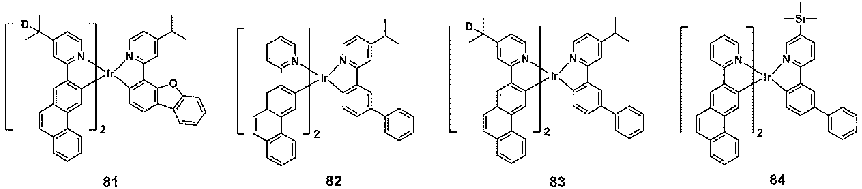

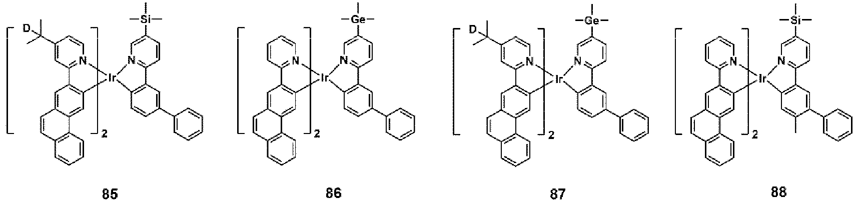

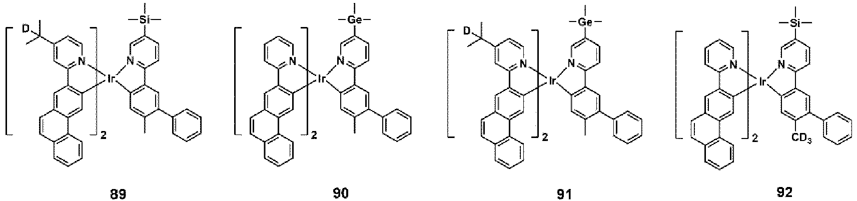

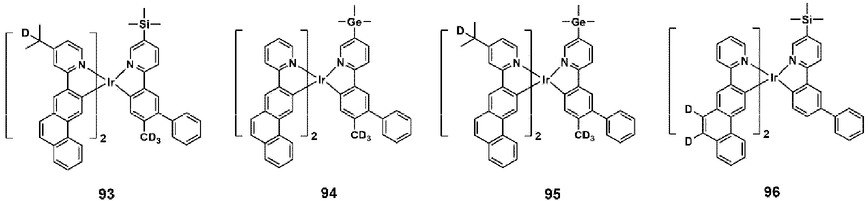

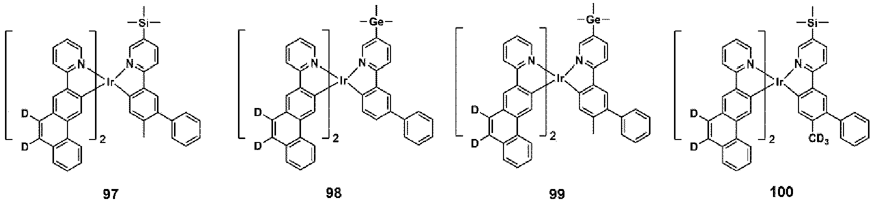

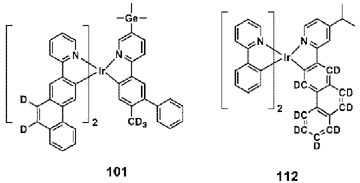

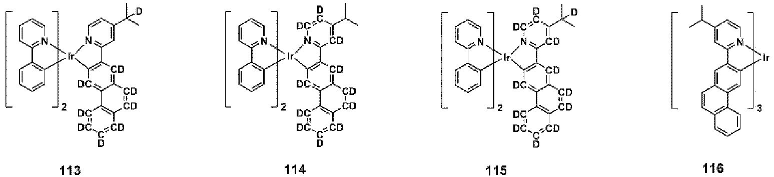

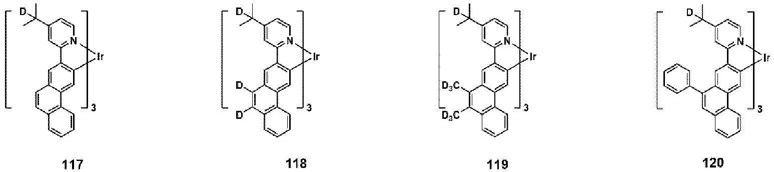

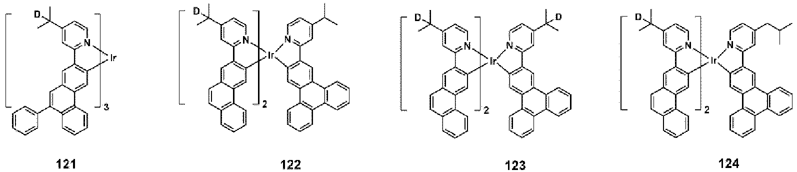

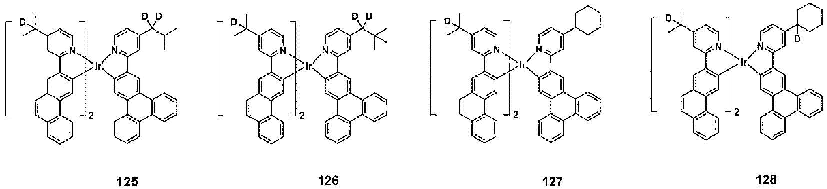

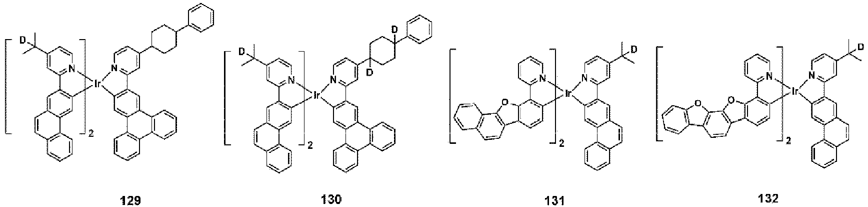

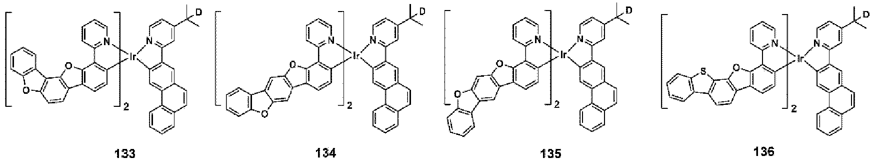

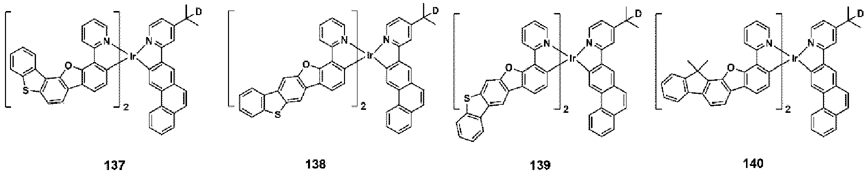

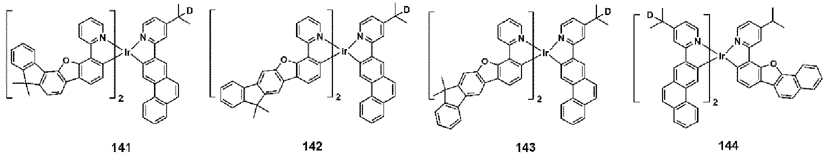

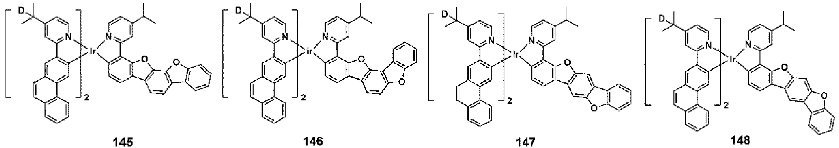

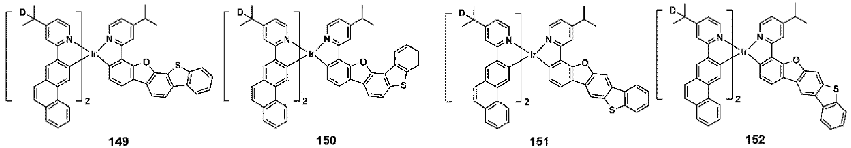

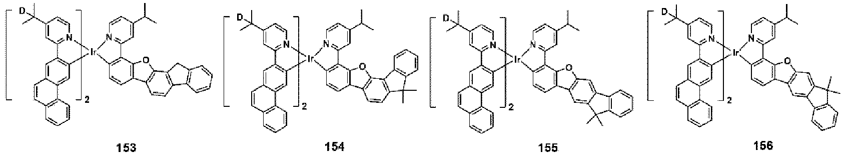

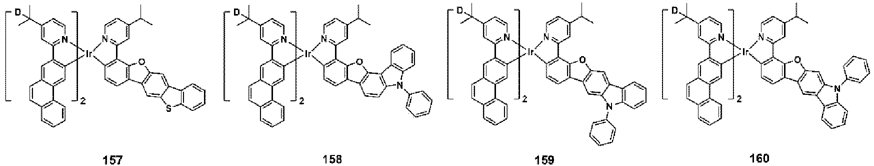

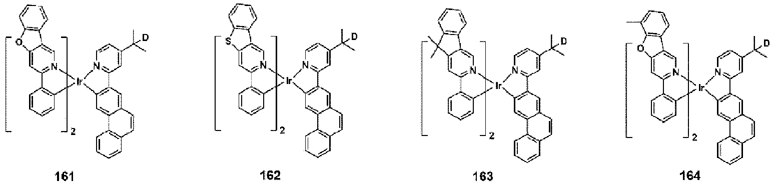

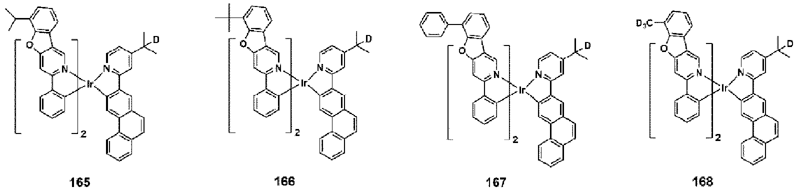

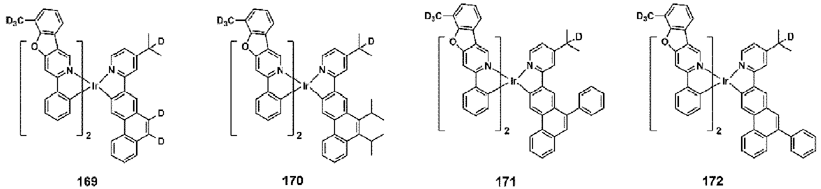

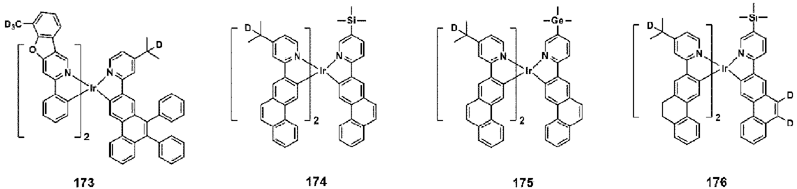

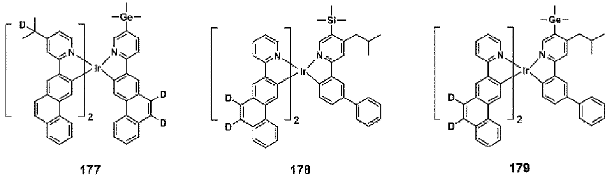

11. Dispositif électroluminescent organique, comprenant :
une première électrode ;
une seconde électrode ; et
une couche organique située entre la première électrode et la seconde électrode,
dans lequel la couche organique comprend une couche d'émission, et
dans lequel la couche organique comprend au moins l'un du composé organométallique de l'une quelconque des revendications 1 à 10.

12. Dispositif électroluminescent organique de la revendication 11, dans lequel la couche d'émission comprend le composé organométallique.

13. Dispositif électroluminescent organique de la revendication 12, dans lequel
la couche d'émission comprend en outre un hôte, et
la quantité de l'hôte dans la couche d'émission est supérieure à la quantité du composé organométallique dans la couche d'émission ;
de préférence dans lequel
la couche d'émission émet une lumière verte possédant une longueur d'onde d'émission maximale de 500 nanomètres à 600 nanomètres.

14. Dispositif électroluminescent organique de l'une des revendications 12 ou 13, dans lequel
la première électrode est une anode,
la seconde électrode est une cathode,
la couche organique comprend en outre une région de transport de trous située entre la première électrode et la couche d'émission, et une région de transport d'électrons située entre la couche d'émission et la seconde électrode, dans lequel
la région de transport de trous comprend une couche d'injection de trous, une couche de transport de trous, une couche de blocage d'électrons, une couche tampon, ou une combinaison de celles-ci, et
la région de transport d'électrons comprend une couche de blocage de trous, une couche de transport d'électrons, une couche d'injection d'électrons ou une combinaison de celles-ci.

15. Composition de diagnostic comprenant au moins l'un du composé organométallique de l'une quelconque des revendications 1 à 10.
